(19) Europäisches Patentamt
European Patent Office
Office européen des brevets

(11) EP 1 548 062 B1

(12) EUROPEAN PATENT SPECIFICATION

(45) Date of publication and mention of the grant of the patent:
**05.10.2011 Bulletin 2011/40**

(21) Application number: **03788052.3**

(22) Date of filing: **07.08.2003**

(51) Int Cl.:
***C08L 29/10*** (2006.01) ***C08L 27/12*** (2006.01)
***C08L 33/04*** (2006.01) ***C08F 14/18*** (2006.01)
***C08F 16/14*** (2006.01) ***C08F 20/32*** (2006.01)
***C09D 129/10*** (2006.01) ***G02B 6/12*** (2006.01)

(86) International application number:
**PCT/JP2003/010038**

(87) International publication number:
**WO 2004/016689 (26.02.2004 Gazette 2004/09)**

(54) **OPTICAL MATERIAL CONTAINING PHOTOCURABLE FLUOROPOLYMER AND PHOTOCURABLE FLUORORESIN COMPOSITION**

OPTISCHES MATERIAL, ENTHALTEND PHOTOHÄRTBARES FLUORPOLYMER, UND PHOTOHÄRTBARES FLUORHARZ ENTHALTENDE ZUSAMMENSETZUNG

MATERIAU OPTIQUE CONTENANT UN POLYMERE FLUORE PHOTODURCISSABLE ET UNE COMPOSITION DE RESINE FLUOREE PHOTODURCISSABLE

(84) Designated Contracting States:
**AT BE BG CH CY CZ DE DK EE ES FI FR GB GR HU IE IT LI LU MC NL PT RO SE SI SK TR**

(30) Priority: **13.08.2002 JP 2002235924**

(43) Date of publication of application:
**29.06.2005 Bulletin 2005/26**

(73) Proprietor: **DAIKIN INDUSTRIES, LTD.**
**Osaka-shi, Osaka 530-8323 (JP)**

(72) Inventors:
- **OHASHI, Mihoko**
  **Yodogawa-seisakusho**
  **Settsu-shi, Osaka 566-8585 (JP)**
- **KISHIKAWA, Yosuke**
  **Yodogawa-seisakusho**
  **Settsu-shi, Osaka 566-8585 (JP)**
- **SATO, Kazuyuki**
  **Yodogawa-seisakusho**
  **Settsu-shi, Osaka 566-8585 (JP)**
- **ARAKI, Takayuki**
  **Yodogawa-seisakusho**
  **Settsu-shi, Osaka 566-8585 (JP)**

(74) Representative: **HOFFMANN EITLE**
**Patent- und Rechtsanwälte**
**Arabellastraße 4**
**81925 München (DE)**

(56) References cited:
**WO-A-02/18457**
**WO-A1-02/18457**
**JP-A- 2000 026 444**
**JP-A- 2002 372 601**
**US-A1- 2002 051 936**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 1 548 062 B1

Printed by Jouve, 75001 PARIS (FR)

## Description

TECHNICAL FIELD

The present invention relates to a curable fluorine-containing polymer having excellent transparency in near infrared region and being excellent in resistance to moisture absorption and heat resistance, and particularly relates to optical materials and photo-curable fluorine-containing resin composition prepared using the curable fluorine-containing polymer having a crosslinkable cyclic ether structure. Those materials and composition are suitable as materials for optical devices such as an optical waveguide and a sealing member and materials for display devices such as an antireflection film.

BACKGROUND ART

An optical communication system has already been put into practical use. From now on there are problems to be solved, namely, enhancement of reliability, increase in accuracy, multiplexing and increase in speed and problem to be solved from economical point of view. In order to solve those problems, development of various optical devices is carried forward. In the field of optical devices, there is a theme of realizing a waveguide type optical device enabling high density optical wiring.

At present, widely used as a material for an optical waveguide is quartz which is high in transparency at a wavelength of from 1,300 to 1,550 nm in a near infrared region and is low in optical loss. However there is a problem that a production process is intricate and a large area is difficult to obtain. Therefore quartz is not suitable for development of a waveguide type optical device which is excellent from economical point of view and can be used widely for various purposes.

There have been already proposed materials for an optical waveguide prepared using high molecular compounds, that is, conventional transparent resin materials such as polystyrene, acrylic resin and polyimide (for example, "Applied Optics", Kurokawa et al., No. 19, 1980, p3124 and "Applied Optics", Kurokawa et al., No. 16, 1977, p1033). In those high molecular compound materials, a process for forming a film by a spin coating method, can be used, and therefore a process for producing an optical waveguide is easy and a large area can be obtained. However conventional transparent resin materials such as polystyrene, acrylic resin and polyimide undergo much absorption of light in near infrared region due to a C-H bond thereof (inferior in transparency) and therefore there is a problem that an optical loss is large. In addition, there is a problem that since moisture absorption thereof is high, light absorption in near infrared region increases with a lapse of time due to water absorption, thereby increasing a light transmission loss.

There has been proposed a fluorine-containing polymer having a C-F bond as a high molecular compound material which has good transparency in a near infrared region, is relatively low in an optical loss and is low in moisture absorption (for example, cf. JP6-16720A).

Further in order to solve the problem with scattering of light due to double refraction which is a disadvantage of perfluoro polymers having high crystallinity, there is a proposal to introduce a cyclic ether structure to a trunk chain of a fluorine-containing polymer to destroy a symmetry of the polymer and make the polymer non-crystalline (cf. JP4-19020A). Such a non-crystalline fluorine-containing perfluoro polymer has no problem with transparency, but is low in a glass transition temperature and has a problem with heat resistance. In order to enhance heat resistance, when the glass transition temperature is sufficiently increased by changing the structural units and the polymer composition, the polymer becomes fragile and there is a problem that cracking occurs in a process of forming a waveguide. Also only by the use of a non-crystalline fluorine-containing perfluoro polymer, a range of controllable refractive index is narrow and there is a big restriction particularly in designing a core-clad type waveguide which requires materials having different refractive indexes. For example, when the non-crystalline fluorine-containing perfluoro polymer is used on the core portion of an optical waveguide (high refractive index), it is difficult to decrease a refractive index while maintaining a perfluoro structure, and it is difficult to produce a proper core-clad optical waveguide. Therefore there is a proposal that a compound having a high refractive index is blended to a non-crystalline fluorine-containing perfluoro polymer as a core material to give a difference in a refractive index between the core and the clad (cf. JP2000-81519A).

The above-mentioned non-crystalline fluorine-containing perfluoro polymer disclosed in JP4-19020A does not have a functional group. The invention of JP2000-81519A was made to solve the problem that the non-crystalline fluorine-containing perfluoro polymer disclosed in JP4-19020A was inferior in adhesion to other material, and proposed that the problem with adhesion was solved by introducing a functional group. In JP2000-81519A, examples of functional groups being capable of improving adhesion are carboxylic acid group, sulfonic acid group, group having an ester bond, alkenyl group, hydrolyzable silyl group, hydroxyl group, maleimide group, amino group, cyano group and isocyanate group. However this fluorine-containing polymer material having a functional group disclosed in JP2000-81519A also is not used as a curable (crosslinkable) material.

In addition to the field of optical communication, there is a field of display devices as a field where light transmittance and durability to light (light resistance) are required. A representative technology for the display devices is one for an antireflection film. An antireflection film is provided on a substrate (glass or acryl) of a display device to enhance visibility of an image displayed on the display device such as CRT or liquid crystal display and comprises a material having a low refractive index.

Materials for the antireflection film are roughly classified into organic or inorganic silicone materials, fluorine-containing acryl materials and fluoro carbon materials.

Among them, as an acryl material, there are proposed photo-curable materials comprising a low molecular multi-functional fluorine-containing acrylate and a fluorine-containing acryl polymer (cf. for example, JP7-126552A, JP7-188582A and JP8-48935A). However in such a system, a component contributing to curing is the multi-functional fluorine-containing acrylate and the fluorine-containing acryl polymer itself is not crosslinked. Therefore if an amount of the multi-functional fluorine-containing acrylate is increased to obtain a necessary surface hardness, there arises a problem that a refractive index of the obtained coating film becomes high and the un-reacted acrylate remains therein.

With respect to the fluoro carbon material, there is proposed the use, as a material for an antireflection film, of a curable fluorine-containing polymer which has, at an end of its trunk chain or in its side chain, a fluorine-containing alkyl group containing an ethylenic carbon-carbon double bond (cf. International Publication No. WO02/18457). Such a curable fluorine-containing polymer having a carbon-carbon double bond has a low refractive index and is excellent in resistance to moisture absorption, light resistance and heat resistance, but further enhancement of curing reactivity is desired.

There is a sealing member as an optical device-related member. The sealing member is a member for filling between the optical devices and also for protecting the optical devices from outside environment, namely from dust, air (oxygen, moisture) and mechanical shock. The sealing member itself is not a functional element, but is a necessary member for designing and fabricating optical devices.

The sealing member for optical devices is required to be excellent in transparency, resistance to moisture absorption, heat resistance, mechanical strength. From this point of view, there are an air-tight sealing member of ceramic material and a resin sealing member of resin material. At present, the resin sealing member is mainly used.

For the resin sealing member, epoxy resin materials such as bisphenol A epoxy resins and alicyclic epoxy resins are widely used from the viewpoint of excellent transparency and heat resistance (cf. for example, JP8-27233A and JP7-21987A). However epoxy resins have a problem that resistance to moisture absorption thereof is inferior, and have a disadvantage that in the case of use for sealing of optical functional devices such as a light emitting diode (LED), electroluminescent device and non-linear optical material device, ability of preventing corrosion of those functional devices is inferior and a life of optical device is shortened.

Therefore development of materials for sealing member being excellent in any of transparency, resistance to moisture absorption, heat resistance and mechanical strength is strongly desired.

The present invention was completed based on the finding of a fluorine-containing polymer material being photo-curable while maintaining transparency in a wide wavelength range of from a near infrared region to an ultraviolet region. By curing, mechanical properties such as high modulus, scratch resistance and abrasion resistance, resistance to moisture absorption and heat resistance are improved. An object of the present invention is to provide an optical material for optical devices (optical waveguide, sealing member) by making use of transparency of the polymer in a wide wavelength range of from a near infrared region to an ultraviolet region and to provide an optical material for display devices (antireflection film) by making use of a low refractive index of the polymer.

Further an object of the present invention is to provide an optical material enabling a fabrication process to be carried out easily since a film forming process by spin coating method can be employed because the material is soluble in a solvent, fabrication of a large area device can be made by photo-curing or photo-lithography process, and curing can be conducted in the air without being adversely affected by oxygen.

## DISCLOSURE OF INVENTION

The present inventors have made intensive studies to attain the mentioned objects, and as a result have found that a non-crystalline fluorine-containing polymer having a crosslinkable cyclic ether structure in its side chain or at an end of its trunk chain can provide a cured article having high heat resistance by curing the polymer in the air without decreasing a refractive index and lowering transparency.

The present inventors also have found that a cured film of a specific fluorine-containing polymer having a crosslinkable cyclic ether structure in its side chain or at an end of its trunk chain is excellent in transparency in a wide wavelength range of from a near infrared region to an ultraviolet region and also in heat resistance, and is useful particularly as an optical material for optical devices such as an optical waveguide and a sealing member and as an optical material for display devices such as an antireflection film.

Further the present inventors have found that a photo-curable fluorine-containing resin composition having a high photo-curing rate can be obtained in combination of the above-mentioned specific fluorine-containing polymer and

a photoacid generator.

Namely, the present invention relates to various inventions making use of a curable fluorine-containing polymer (I) which has a number average molecular weight of from 500 to 1,000,000 and is represented by the formula (1):

$$-(M)-(A)- \qquad (1)$$

wherein the structural unit M is a structural unit derived from a fluorine-containing ethylenic monomer and represented by the formula (M):

$$-(CX^1X^2-\underset{\displaystyle (CX^4X^5)_a(C{=}O)_b(O)_c Rf}{\underset{|}{CX^3}})- \qquad (M)$$

wherein $X^1$ and $X^2$ are the same or different and each is H or F; $X^3$ is H, F, $CH_3$ or $CF_3$; $X^4$ and $X^5$ are the same or different and each is H, F or $CF_3$; Rf is an organic group in which 1 to 3 $Y^1$ ($Y^1$ is a monovalent organic group having 2 to 100 carbon atoms and 1 to 5 crosslinkable cyclic ether structures in which hydrogen atoms may be substituted with fluorine atoms) are bonded to a fluorine-containing alkyl group having 1 to 40 carbon atoms or a fluorine-containing alkyl group having 2 to 100 carbon atoms and ether bond; a is 0 or an integer of from 1 to 3; b and c are the same or different and each is 0 or 1,

the structural unit A is a structural unit derived from a monomer copolymerizable with the fluorine-containing ethylenic monomer for the structural unit represented by the formula (M), and the structural units M and A are contained in amounts of from 0.1 to 100 % by mole and from 0 to 99.9 % by mole, respectively.

Among them, the first invention relates to a photo-curable fluorine-containing resin composition comprising (a) the above-mentioned curable fluorine-containing polymer (I) and (b) a photoacid generator (II).

The second invention relates to an optical material for optical devices which comprises the above-mentioned curable fluorine-containing polymer (I).

It is preferable that the optical material for optical devices of the present invention comprises (a) the above-mentioned curable fluorine-containing polymer (I) and (b) the photoacid generator (II).

A cured article obtained by curing the optical material for optical devices of the present invention can provide an optical member for optical devices.

Particularly the optical material for optical devices of the present invention can provide a material for an optical waveguide. A cured article obtained by curing the material for an optical waveguide can provide an excellent member for an optical waveguide.

Also the optical material for optical devices of the present invention can provide an optical material for a sealing member. A cured article obtained by curing the material for a sealing member can provide an optical device having an excellent sealing member.

The third invention relates to an optical material for display devices which comprises the above-mentioned curable fluorine-containing polymer (I) represented by the formula (1).

It is preferable that the optical material for display devices of the present invention comprises (a) the above-mentioned curable fluorine-containing polymer (I) and (b) the photoacid generator (II).

A cured article obtained by curing the optical material for display devices of the present invention can provide an optical member for display devices.

Particularly the optical material for display devices of the present invention can provide a material for an antireflection film. A cured article obtained by curing the material for an antireflection film can provide an excellent antireflection film.

The photoacid generator (II) to be blended to the composition and optical materials of the present invention is preferably at least one aromatic compound selected from the group consisting of aromatic diazonium salts, aromatic sulfonium salts, aromatic iodonium salts and metallocene compounds. Among those aromatic compounds, preferred is a compound in which 1 to 4 organic groups R are bonded to the aromatic ring, wherein R are the same or different and each is thiophenoxy group, thioalkyl group, hydroxyl group or an alkyl group which has 1 to 10 carbon atoms and may have an ether bond.

Further it is preferable that the photoacid generator (II) is a compound having fluorine atom.

The above-mentioned fluorine-containing polymer (I) encompasses novel polymers (Ia) and (Ib). Namely, the

fourth invention relates to a fluorine-containing polymer (Ia) having crosslinkable group which has a number average molecular weight of from 500 to 1,000,000 and is represented by the formula (2):

- (M4) - (B) - (2)

wherein the structural unit M4 is a structural unit derived from a fluorine-containing ethylenic monomer and represented by the formula (M4):

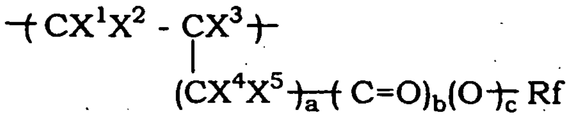

(M4)

wherein $X^1$ and $X^2$ are the same or different and each is H or F; $X^3$ is H, F, $CH_3$ or $CF_3$; $X^4$ and $X^5$ are the same or different and each is H, F or $CF_3$; Rf is an organic group in which 1 to 3 $Y^2$ ($Y^2$ is an organic group having 2 to 100 carbon atoms and 1 to 5 crosslinkable cyclic ether structures of:

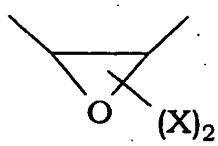

wherein X are the same or different and each is hydrogen atom, fluorine atom, an alkyl group having 1 to 6 carbon atoms or a fluorine-containing alkyl group having 1 to 6 carbon atoms, or
an organic group having 3 to 100 carbon atoms and 1 to 5 structures represented by the formula:

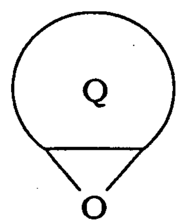

wherein Q is a monovalent or divalent organic group of monocyclic, polycyclic or heterocyclic structure having 3 to 100 carbon atoms in which hydrogen atom of Q may be substituted with the X mentioned above) are bonded to a fluorine-containing alkyl group having 1 to 40 carbon atoms or a fluorine-containing alkyl group having 2 to 100 carbon atoms and ether bond; a is 0 or an integer of from 1 to 3; b and c are the same or different and each is 0 or 1,
the structural unit B is a structural unit derived from a monomer copolymerizable with the fluorine-containing ethylenic monomer for the structural unit represented by the formula (M4), and the structural units M4 and B are contained in amounts of from 0.1 to 100 % by mole and from 0 to 99.9 % by mole, respectively,
or relates to a fluorine-containing polymer (Ib) having crosslinkable group which has a number average molecular weight of from 500 to 1,000,000 and is represented by the formula (2-1):

- (M4) - (B) - (2-1)

wherein the structural unit M4 is a structural unit derived from a fluorine-containing ethylenic monomer and represented by the formula (M4-1):

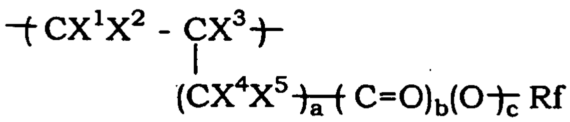

(M4-1)

wherein $X^1$ and $X^2$ are the same or different and each is H or F; $X^3$ is H, F, $CH_3$ or $CF_3$; $X^4$ and $X^5$ are the same or different and each is H, F or $CF_3$; Rf is an organic group in which 1 to 3 $Y^{2a}$ ($Y^{2a}$ is an organic group having 3 to 100 carbon atoms and 1 to 5 crosslinkable cyclic ether structures of:

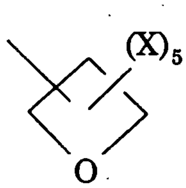

or

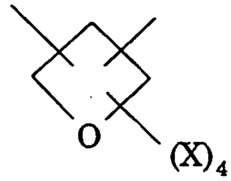

wherein X are the same or different and each is hydrogen atom, fluorine atom, an alkyl group having 1 to 6 carbon atoms or a fluorine-containing alkyl group having 1 to 6 carbon atoms) are bonded to a fluorine-containing alkyl group having 1 to 40 carbon atoms or a fluorine-containing alkyl group having 2 to 100 carbon atoms and ether bond; a is 0 or an integer of from 1 to 3; b and c are the same or different and each is 0 or 1,
the structural unit B is a structural unit derived from a monomer copolymerizable with the fluorine-containing ethylenic monomer for the structural unit represented by the formula (M4-1), and the structural units M4 and B are contained in amounts of from 0.1 to 100 % by mole and from 0 to 99.9 % by mole, respectively.

The fluorine-containing ethylenic monomer providing the above-mentioned novel fluorine-containing polymer (Ia) is also a novel monomer. Namely, the fifth invention relates to a fluorine-containing ethylenic monomer represented by the formula (3):

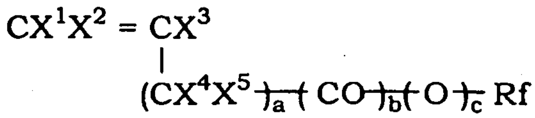

(3)

wherein $X^1$ and $X^2$ are the same or different and each is H or F; $X^3$ is H, F, CH3 or $CF_3$; $X^4$ and $X^5$ are the same or different and each is H, F or $CF_3$; Rf is an organic group in which 1 to 3 $Y^2$ ($Y^2$ is an organic group having 2 to 100 carbon atoms and 1 to 5 crosslinkable cyclic ether structures of:

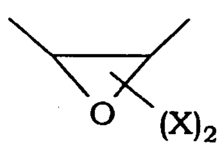

wherein X are the same or different and each is hydrogen atom, fluorine atom, an alkyl group having 1 to 6 carbon atoms or a fluorine-containing alkyl group having 1 to 6 carbon atoms, or
an organic group having 3 to 100 carbon atoms and 1 to 5 structures represented by the formula:

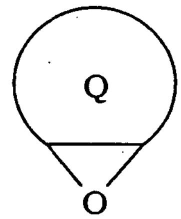

wherein Q is a monovalent or divalent organic group of monocyclic, polycyclic or heterocyclic structure having 3 to 100 carbon atoms in which hydrogen atom of Q may be substituted with the X mentioned above) are bonded to a fluorine-containing alkyl group having 1 to 40 carbon atoms or a fluorine-containing alkyl group having 2 to 100 carbon atoms and ether bond; a is 0 or an integer of from 1 to 3; b and c are the same or different and each is 0 or 1, or

a fluorine-containing ethylenic monomer represented by the formula (3-1):

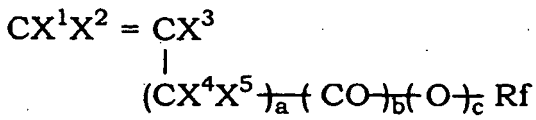

(3-1)

wherein $X^1$ and $X^2$ are the same or different and each is H or F; $X^3$ is H, F, $CH_3$ or $CF_3$; $X^4$ and $X^5$ are the same or different and each is H, F or $CF_3$; Rf is an organic group in which 1 to 3 $Y^{2a}$ ($Y^{2a}$ is an organic group having 2 to 100 carbon atoms and 1 to 5 crosslinkable cyclic ether structures of:

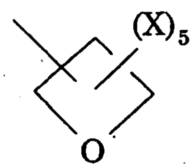

or

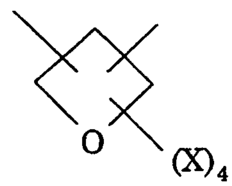

wherein X are the same or different and each is hydrogen atom, fluorine atom, an alkyl group having 1 to 6 carbon atoms or a fluorine-containing alkyl group having 1 to 6 carbon atoms) are bonded to a fluorine-containing alkyl group having 1 to 40 carbon atoms or a fluorine-containing alkyl group having 2 to 100 carbon atoms and ether bond; a is 0 or an integer of from 1 to 3; b and c are the same or different and each is 0 or 1.

BRIEF EXPLANATION OF THE DRAWINGS

Fig. 1 is a diagrammatic cross-sectional view of an optical waveguide device produced using the member for an optical waveguide of the present invention.

Fig. 2 is a flow chart for explaining production steps of an optical waveguide device produced using the member for an optical waveguide of the present invention.

Fig. 3 is a diagrammatic cross-sectional view of lens for deep ultraviolet produced using the sealing member of the present invention.

Fig. 4 is a diagrammatic cross-sectional view of an organic electroluminescent device produced using the sealing member of the present invention.

BEST MODE FOR CARRYING OUT THE INVENTION

First, the curable fluorine-containing polymer (I) which is used for the optical materials and composition of the present invention is explained below.

The curable fluorine-containing polymer (I) is, as mentioned above, the curable fluorine-containing polymer

having a number average molecular weight of from 500 to 1,000,000 and represented by the formula (1):

$$-(M)-(A)- \qquad (1)$$

wherein the structural unit M is a structural unit derived from a fluorine-containing ethylenic monomer and represented by the formula (M):

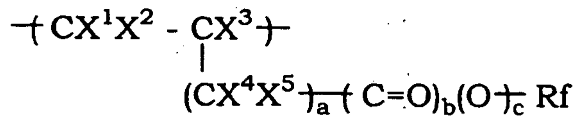

(M)

wherein $X^1$ and $X^2$ are the same or different and each is H or F; $X^3$ is H, F, $CH_3$ or $CF_3$; $X^4$ and $X^5$ are the same or different and each is H, F or $CF_3$; Rf is an organic group in which 1 to 3 $Y^1$ ($Y^1$ is a monovalent organic group which has 2 to 100 carbon atoms and 1 to 5 crosslinkable cyclic ether structures in which hydrogen atoms may be substituted with fluorine atoms) are bonded to a fluorine-containing alkyl group having 1 to 40 carbon atoms or a fluorine-containing alkyl group having 2 to 100 carbon atoms and ether bond; a is 0 or an integer of from 1 to 3; b and c are the same or different and each is 0 or 1,

the structural unit A is a structural unit derived from a monomer copolymerizable with the fluorine-containing ethylenic monomer for the structural unit represented by the formula (M), and

the structural units M and A are contained in amounts of from 0.1 to 100 % by mole and from 0 to 99.9 % by mole, respectively.

Namely, the curable fluorine-containing polymer used in the present invention is a homopolymer of the structural unit M containing the fluorine-containing alkyl group Rf having the organic group $Y^1$ having the crosslinkable cyclic ether structure or a copolymer of the structural units M and A.

The fluorine content of the curable fluorine-containing polymer (I) is preferably not less than 25 % by weight, particularly preferably not less than 40 % by weight since transparency of the fluorine-containing polymer (I) can be made high and a refractive index thereof can be made low, particularly since a high transparency can be maintained at a low refractive index even if a degree of curing (crosslinking density) is increased for the purposes to increase heat resistance and modulus of elasticity of a cured article. Also in order to maintain a high transparency, the fluorine content is preferably not more than 70 % by weight.

As a method of measuring a fluorine content, generally there is used a method of calculating the fluorine content by analyzing a polymer composition from measurements with $^{19}F$-NMR and $^1H$-NMR using equipment and measuring conditions mentioned below. When it is difficult to analyze a polymer structure by the above-mentioned method, there is used a method of elementary analysis of fluorine in which 2 mg of a sample and a combustion improver (10 mg of sodium peroxide) are wrapped with a filter paper (filter paper No.7 available from Toyo Roshi) and are put in a platinum basket and then are burned in a 500 ml flask filled with 25 ml of pure water. Immediately after the burning, the flask is shaken to absorb fluorine ion in pure water and then fluorine ion absorbed in pure water is analyzed with a fluorine ion electrode.

Example of the preferred curable fluorine-containing polymer (I) is the fluorine-containing polymer of the formula (1) in which the structural unit M is a structural unit M 1 derived from a fluorine-containing ethylenic monomer and represented by the formula (M1):

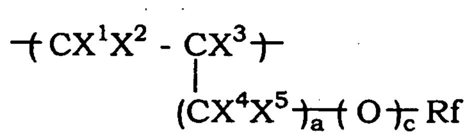

(M1)

wherein $X^1$ and $X^2$ are the same or different and each is H or F; $X^3$ is H, F, $CH_3$ or $CF_3$; $X^4$ and $X^5$ are the same or different and each is H, F or $CF_3$; Rf is an organic group in which 1 to 3 $Y^1$ ($Y^1$ is a monovalent organic group having 2 to 100 carbon atoms and 1 to 5 crosslinkable cyclic ether structures in which hydrogen atoms may be substituted with fluorine atoms) are bonded to a fluorine-containing alkyl group having 1 to 40 carbon atoms or a fluorine-containing alkyl

group having 2 to 100 carbon atoms and ether bond; a is 0 or an integer of from 1 to 3; c is 0 or 1.

The fluorine-containing polymer having the structural unit M 1 has a high transparency particularly to light of from a near infrared region to an ultraviolet region and a low refractive index and is preferred because transparency can be made high and a refractive index can be made low not only in the case of a homopolymer of the structural unit M 1 but also in the case of a copolymer comprising an increased amount of the structural unit M1.

Further there is the fluorine-containing polymer of the formula (1) in which the structural unit M is a structural unit M2 derived from a fluorine-containing ethylenic monomer and represented by the formula (M2):

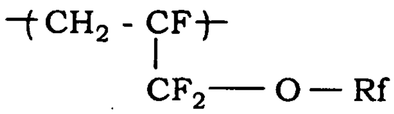

(M2)

wherein Rf is as defined above.

This structural unit M2 is a structural unit of a fluorine-containing allyl ether having a crosslinkable cyclic ether structure in its Rf and is preferred not only because transparency can be made high and a refractive index can be made low but also because of good polymerizability, particularly good homo-polymerizability and copolymerizability with other fluorine-containing ethylenic monomers.

Further preferred is the fluorine-containing polymer of the formula (1) in which the structural unit M is a structural unit M3 derived from a fluorine-containing ethylenic monomer and represented by the formula (M3):

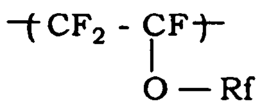

(M3)

wherein Rf is as defined above.

This structural unit M3 is a structural unit of a fluorine-containing vinyl ether having a crosslinkable cyclic ether structure in its Rf and is preferred because transparency can be made high and a refractive index can be made low and also because of good copolymerizability with other fluorine-containing ethylenic monomers.

It is preferable that at least one of $Y^1$ in the Rf in the formulae (M), (M1), (M2) and (M3) is bonded to an end of the Rf.

The cyclic ether structure in $Y^1$ has an ability of causing ring-opening addition reaction and can provide a cured (crosslinked) article. Particularly the ring-opening addition reaction is caused, for example, between the molecules of the fluorine-containing polymer (I) or between the fluorine-containing polymer (I) and a curing (crosslinking) agent to be blended as case demands, by contact with a cation, thereby enabling a cured (crosslinked) article to be provided.

Preferred example of the crosslinkable cyclic ether structure contained in $Y^1$ in the Rf is a crosslinkable cyclic ether structure of 3- to 6-membered ring having at least one ether bond (hydrogen atom of the cyclic ether structure may be substituted with fluorine atom).

Examples of oxirane (epoxy) structure (Y-a) which is a crosslinkable cyclic ether structure of 3-membered ring are, for instance:

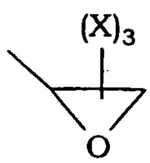

(Y-a1)

or

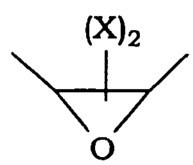

(Y-a2)

wherein X are the same or different and each is hydrogen atom, fluorine atom, an alkyl group having 1 to 6 carbon atoms or a fluorine-containing alkyl group having 1 to 6 carbon atoms, or a structure of the formula:

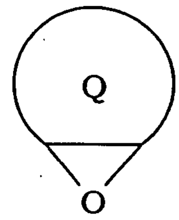

(Y-a3)

wherein Q is a monovalent or divalent organic group of monocyclic, polycyclic or heterocyclic structure having 3 to 100 carbon atoms, in which hydrogen atom of Q may be substituted with the mentioned X.

Examples of the oxirane structure (Y-a1) are, for instance:

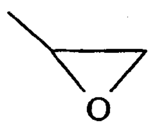 , 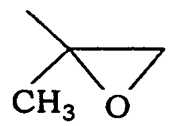 , 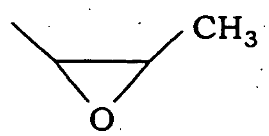 ,

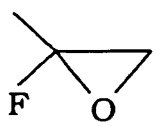 , 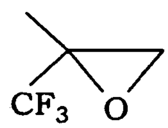

Among them, preferred are:

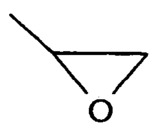 , 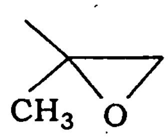 and 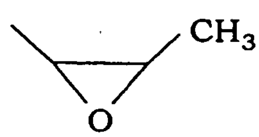

from the viewpoint of good reactivity, and

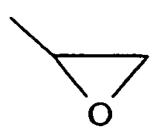

is particularly preferred.

Examples of the oxirane structure (Y-a2) are, for instance:

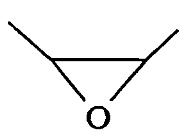 , 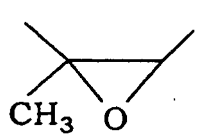 , 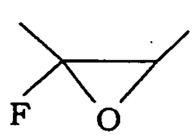 , 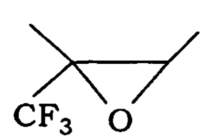

Among them,

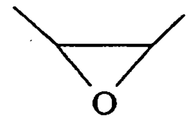

is preferred from the viewpoint of good reactivity.

Examples of the oxirane structure (Y-a3) are, for instance:

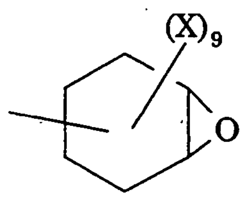 , 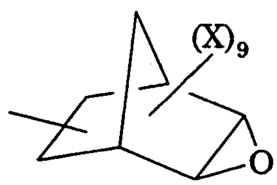 , 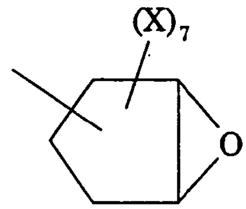

Particularly there are:

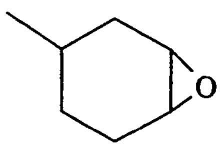 , 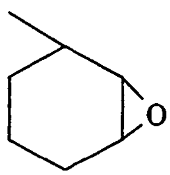 , 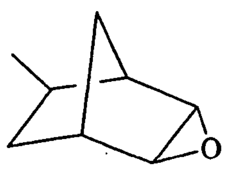 , 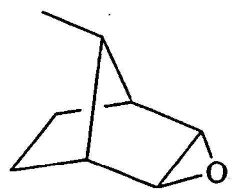 ,

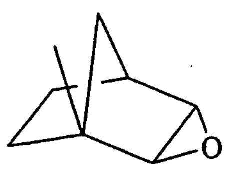 , 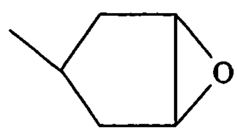 , 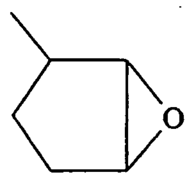

Among them,

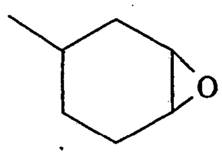 and 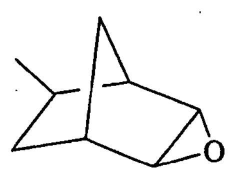

are preferred from the point that reactivity is good and a mechanical strength can be imparted to the obtained coating film.

Preferred examples of an embodiment containing a structure of Y-a1, Y-a2 or Y-a3 which is bonded in the Rf are, for instance, as follows.

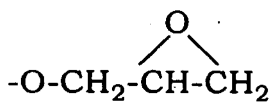 , 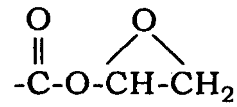 ,

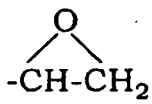 , 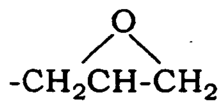 , 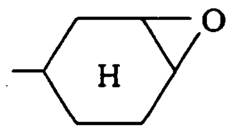 ,

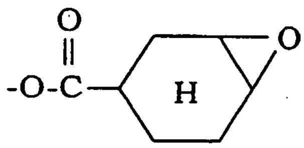 and 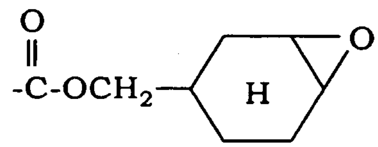

Examples of oxetane structure (Y-b) which is a crosslinkable cyclic ether structure of 4-membered ring are, for instance:

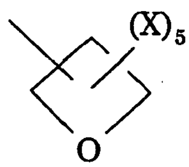

(Y-b1) or

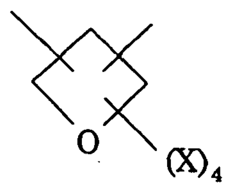

(Y-b2)

wherein X are the same or different and each is hydrogen atom, fluorine atom, an alkyl group having 1 to 6 carbon atoms or a fluorine-containing alkyl group having 1 to 6 carbon atoms, or
a structure of the formula:

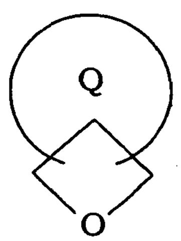

(Y-b3)

wherein Q is a monovalent or divalent organic group of monocyclic, polycyclic or heterocyclic structure having 3 to 100 carbon atoms in which hydrogen atom of Q may be substituted with the mentioned X.
Examples of the oxetane structure (Y-b1) are, for instance:

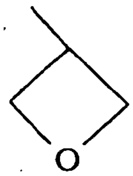 , 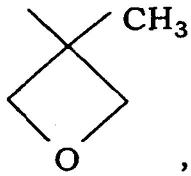 , 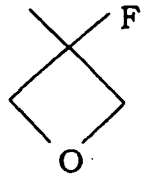 , 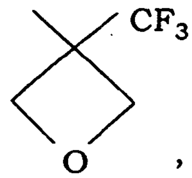 , 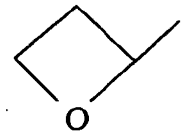

Among them, preferred are:

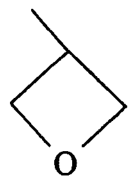 and 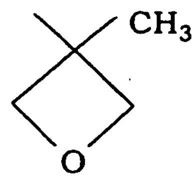

from the viewpoint of good reactivity.

Examples of the oxetane structure (Y-b2) are, for instance:

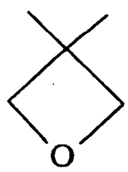 , 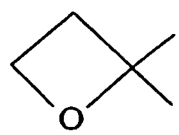 , 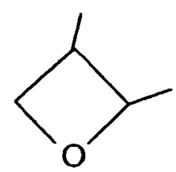

Examples of the oxetane structure (Y-b3) are, for instance:

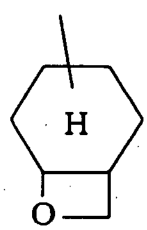 , 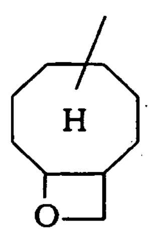 , 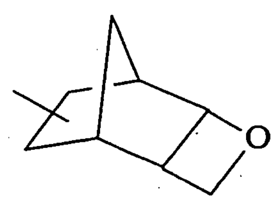

Among Y-b1, Y-b2 and Y-b3, preferred is Y-b1. Particularly the examples thereof mentioned above are preferred from the viewpoint of good reactivity.

Preferred examples of an embodiment containing a structure of Y-b1, Y-b2 or Y-b3 which is bonded in the Rf are, for instance:

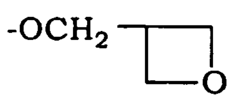 , 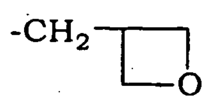 , 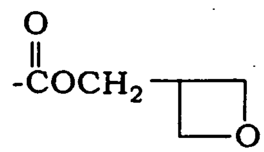 ,

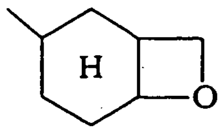, 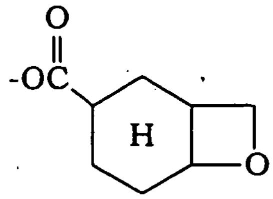, 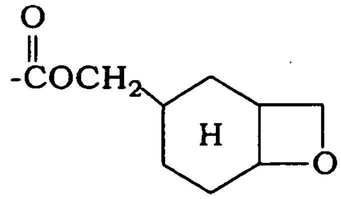

Examples of other crosslinkable cyclic ether structure are, for instance, tetrahydrofuran ring (5-membered ring), dioxolan ring (5- or 6-membered ring), trioxane ring (6-membered ring), spiroorthocarbonate.

Examples thereof are, for instance:

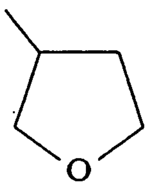, 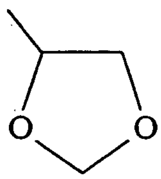, 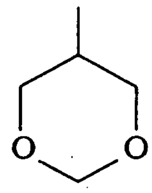, 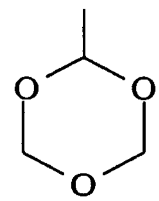,

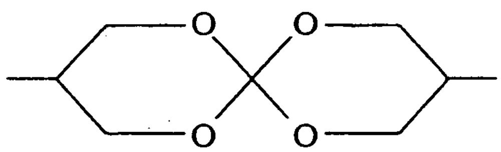

The organic group Rf in which the crosslinkable cyclic ether structure $Y^1$ is bonded may be present at an end of a trunk chain of the fluorine-containing polymer (I).

A residue having two or more valences (hereinafter referred to as "Rf residue") of the organic group Rf excluding the crosslinkable cyclic ether structure $Y^1$ is a fluorine-containing alkylene group of C1 to C40 having two or more valences or a fluorine-containing alkylene group of C2 to C100 having two or more valences which has ether bond. In the Rf residue, a fluorine atom is bonded to the carbon atom contained therein. The Rf residue is generally a fluorine-containing alkylene group having two or more valences or a fluorine-containing alkylene group having two or more valences which has ether bond, in which fluorine atom and hydrogen atom or chlorine atom are bonded to the carbon atom. Preferred are the Rf residues having more fluorine atoms (high fluorine content), and more preferred are perfluoro alkylene groups having two or more valences or perfluoro alkylene groups having two or more valences which have ether bond. The fluorine content in the fluorine-containing polymer (I) is, as mentioned above, not less than 25 % by weight, preferably not less than 40 % by weight.

Too large number of carbon atoms of the Rf residue is not preferred because there is a case where solubility in a solvent and transparency are lowered in the case of the fluorine-containing alkylene group, and hardness and mechanical properties of the polymer itself and the cured article thereof are lowered in the case of the fluorine-containing alkylene group having ether bond. The number of carbon atoms of the fluorine-containing alkylene group is preferably from 1 to 20, more preferably from 1 to 10. The number of carbon atoms of the fluorine-containing alkylene group having ether bond is preferably from 2 to 30, more preferably from 2 to 20.

Preferred examples of the Rf residue are:

$$-(CF_2)_m(CH_2)_n-,\quad -(CF_2\underset{}{\overset{CF_3}{\overset{|}{C}}}F)_m(CH_2)_n-,\quad -(CH_2CF_2)_m(CH_2)_n-,$$

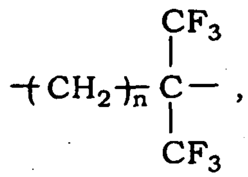

(m: from 1 to 10, n: from 0 to 5)

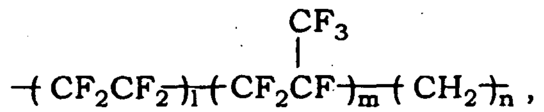

$-(CF_2CF_2)_l-(CH_2CF_2)_m-(CH_2)_n-$ ,

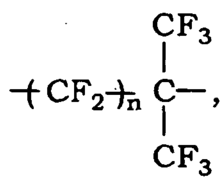 , 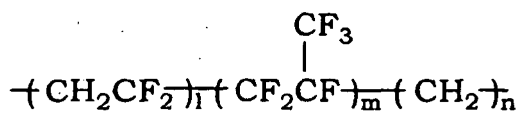

(l: from 1 to 10, m: from 1 to 10, n: from 0 to 5)

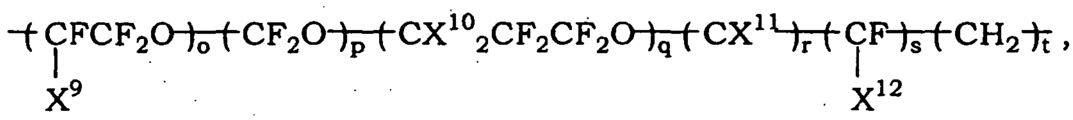

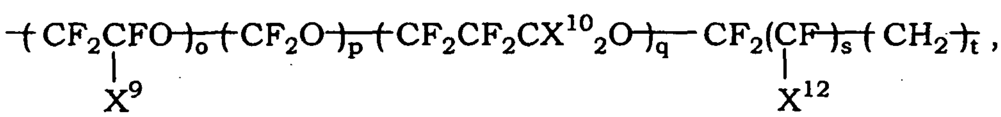

($X^9$ and $X^{12}$ are F or $CF_3$; $X^{10}$ and $X^{11}$ are H or F; o + p + q is from 1 to 30; r is 0 or 1; s and t are 0 or 1)

As mentioned above, the structural unit M constituting the fluorine-containing polymer (I) of the present invention is preferably the structural unit M 1 and the structural unit M 1 is further preferably the structural unit M2 or M3. Next, mentioned below are examples of the structural units M2 and M3.

Preferred examples of the monomer introducing the structural unit M2 are:

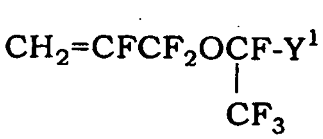 , 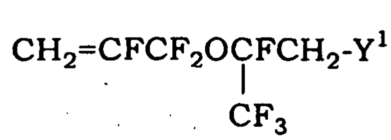

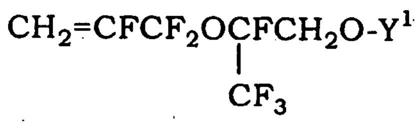 , 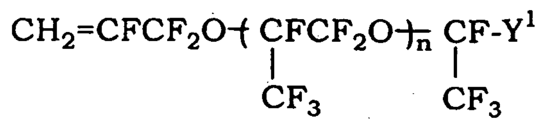 ,

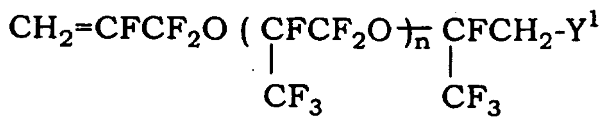 ,

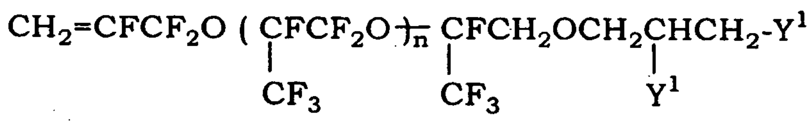 ,

(n: an integer of from 1 to 30)

$$CH_2=CFCF_2O(CF_2CF_2O)_n CF_2\text{-}Y^1 ,$$

$$CH_2=CFCF_2O(CF_2CF_2O)_n CF_2CH_2\text{-}Y^1 ,$$

$$CH_2=CFCF_2O(CF_2CF_2CF_2O)_n CF_2CF_2\text{-}Y^1 ,$$

$$CH_2=CFCF_2O(CF_2CF_2CF_2O)_n CF_2CF_2CH_2\text{-}Y^1 ,$$

$$CH_2=CFCF_2O(CH_2CF_2CF_2O)_n CH_2CF_2\text{-}Y^1 ,$$

$$CH_2=CFCF_2O(CH_2CF_2CF_2O)_n CH_2CF_2CH_2\text{-}Y^1 ,$$

(n: an integer of from 1 to 30)

$$CH_2=CFCF_2O(CF_2CF_2)_n Y^1 ,$$

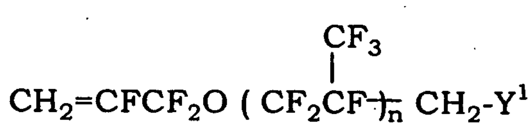

($Y^1$ is as defined above).

More concretely there are:

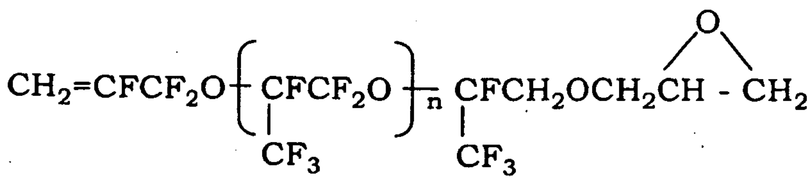
,

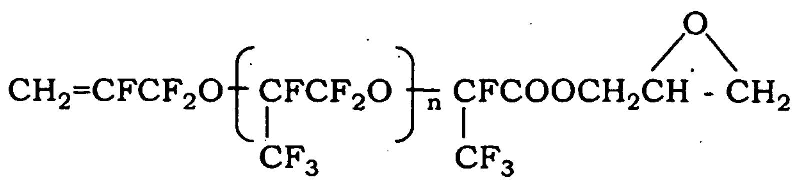
,

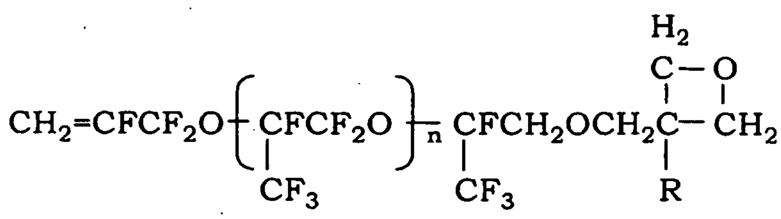
,

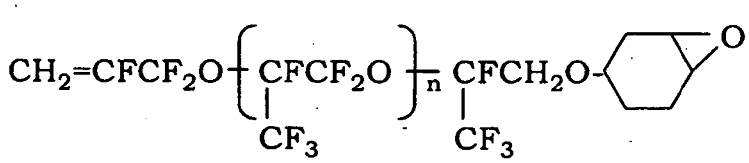
,

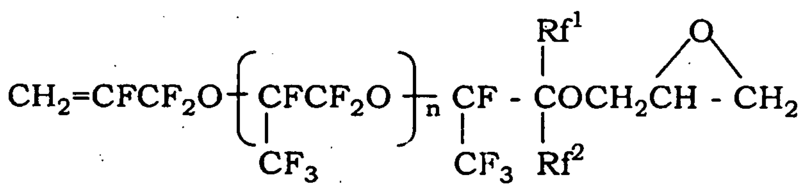
,

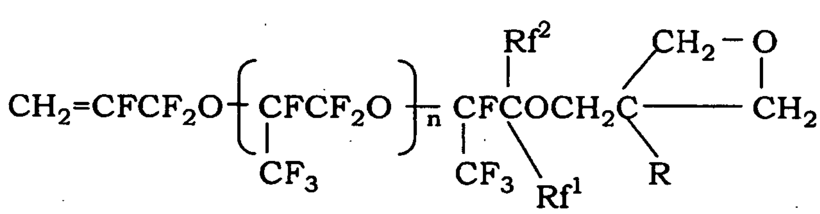
,

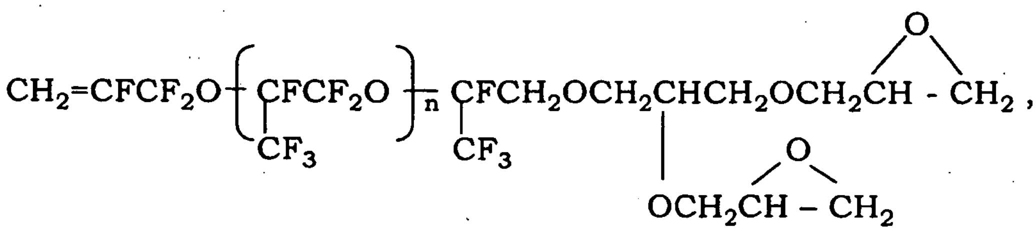

wherein R is H or $CH_3$; $Rf^1$ and $Rf^2$ are the same or different and each is a perfluoro alkyl group having 1 to 5 carbon atoms; n is 0 or an integer of from 1 to 30.

Preferred examples of the monomer introducing the structural unit M3 are:

$CF_2=CFOCF_2CF_2-Y^1$, $CF_2=CFOCF_2CF_2CH_2-Y^1$,

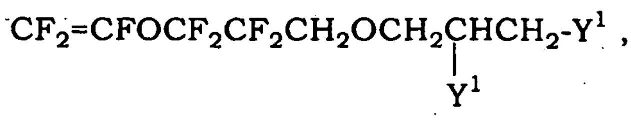

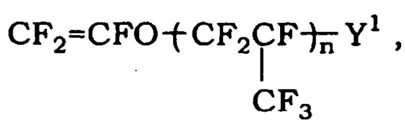 , 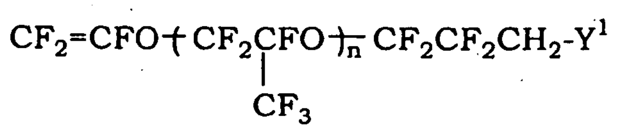

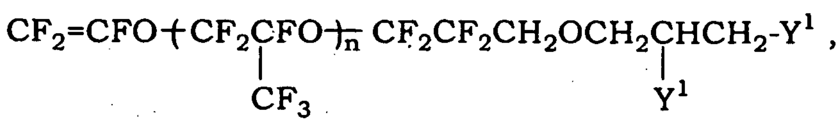

(n is an integer of from 1 to 30)

$CF_2=CFO(CF_2)_3Y^1$ , $CF_2=CFO(CF_2)_3CH_2-Y^1$ ,

$CF_2=CFOCF_2CF_2OCF_2-Y^1$, $CF_2=CFOCF_2CF_2OCF_2CH_2-Y^1$,

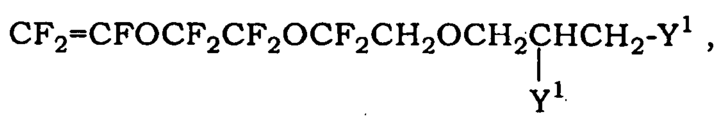

$CF_2=CFOCF_2CF_2CH_2OCF_2CF_2-Y^1$,
$CF_2=CFOCF_2CF_2CH_2OCF_2CF_2CH_2-Y^1$,

wherein $Y^1$ is as defined above.

More concretely there are:

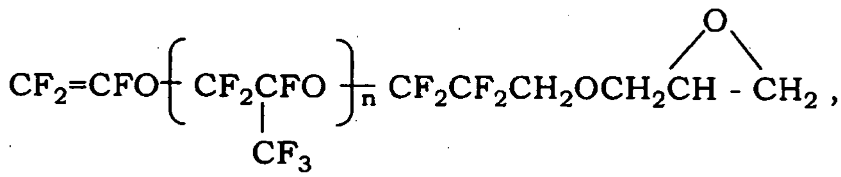
,

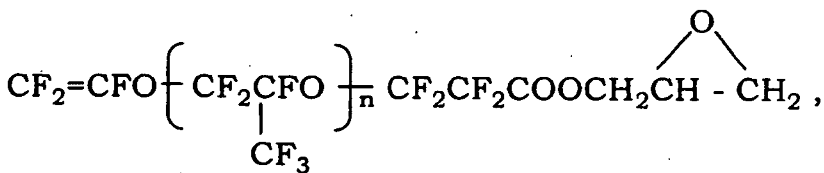
,

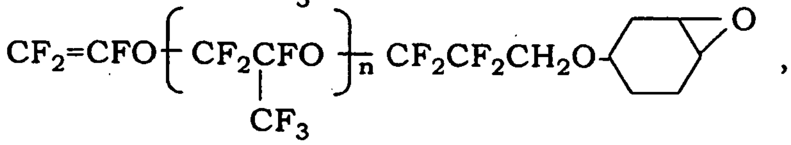
,

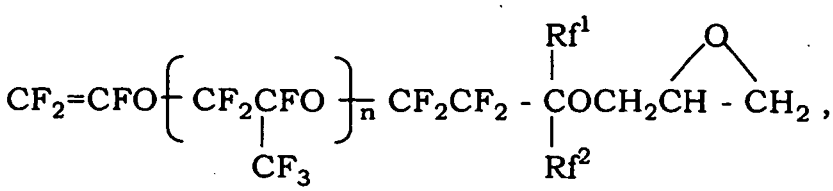
,

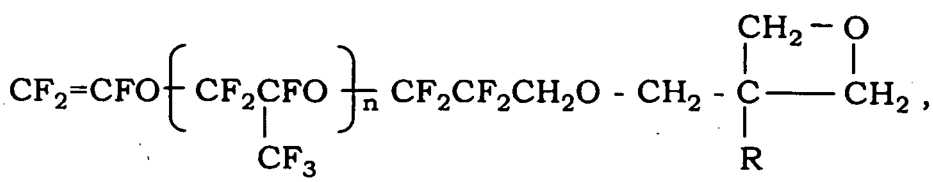
,

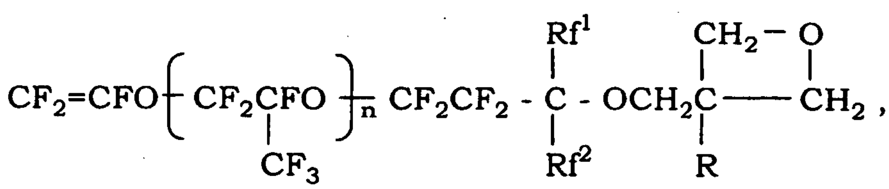
,

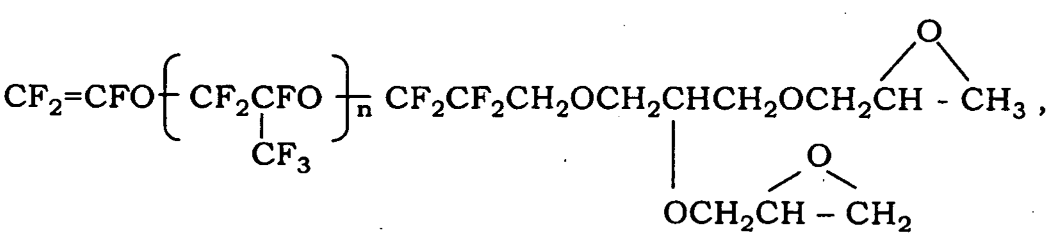
,

wherein R is H or $CH_3$; $Rf^1$ and $Rf^2$ are the same or different and each is a perfluoro alkyl group having 1 to 5 carbon atoms; n is 0 or an integer of from 1 to 30.

Preferred examples of the monomer introducing the structural unit M of the fluorine-containing polymer (I) other

than the above-mentioned structural units M2 and M3 are, for instance,

$CF_2=CFCF_2-O-Rf-Y^1$,

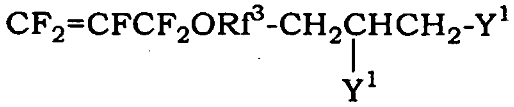 ,

$CF_2=CF-Rf-Y^1$,

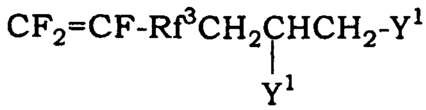 ,

$CH_2=CH-Rf-Y^1$,

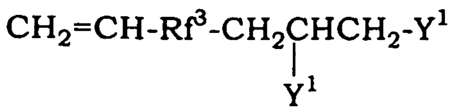 ,

$CH_2=CHO-Rf-Y^1$,

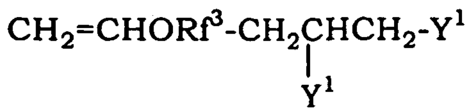

wherein $Y^1$ is as defined above; $Rf^3$ is a group obtained by excluding $-CH_2CHCH_2-$ from Rf.

More concretely there are:

$CF_2=CFCF_2OCF_2CF_2CF_2-Y^1$, $CF_2=CFCF_2OCF_2CF_2CF_2CH_2-Y^1$,

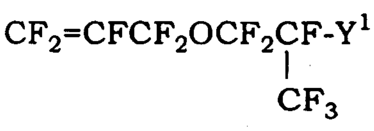 , 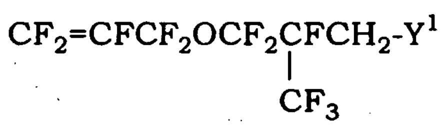 ,

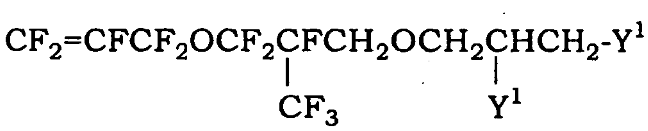 ,

$CF_2=CFCF_2-Y^1$ , $CF_2=CFCF_2CH_2-Y^1$,

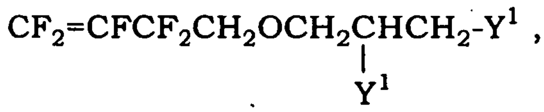

$CH_2=CHCF_2CF_2CH_2CH_2-Y^1$, $CH_2=CHCF_2CF_2-Y^1$, $CH_2=CHCF_2CF_2CH_2-Y^1$, $CH_2=CHCF_2CF_2CF_2CF_2-Y^1$, $CH_2=CHCF_2CF_2CF_2CF_2CH_2-Y^1$,

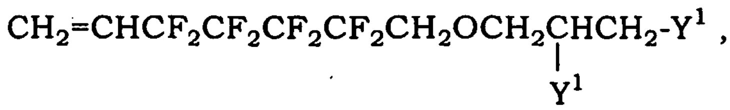

$CH_2=CHOCH_2CF_2CF_2-Y^1$, $CH_2=CHOCH_2CF_2CF_2CH_2-Y^1$

wherein $Y^1$ is as defined above.

In the fluorine-containing polymer (I) of the present invention, the structural unit A is an optional component. The structural unit A is not limited particularly as far as the monomer for the structural unit A is copolymerizable with the monomer for the structural unit M (M1, M2 or M3). The structural unit A may be optionally selected depending on intended applications and required characteristics of the fluorine-containing polymer (I) and the cured article obtained therefrom.

Examples of the structural unit A are, for instance, the following structural units.

(i) Structural units derived from fluorine-containing ethylenic monomers having functional group:

(i)-1 Structural units derived from fluorine-containing ethylenic monomers having a polar group (excluding the crosslinkable cyclic ether group contained in $Y^1$)

(i)-2 Structural units derived from fluorine-containing ethylenic monomers having a radically reactive group

These structural units (i) can impart, to the fluorine-containing polymer (I), solubility in a solvent, physical properties such as adhesion to a substrate and reactivity other than cation reactivity while maintaining a low refractive index and high transparency of the polymer and the cured article obtained therefrom. Particularly the structural units (i)-1 are preferred from the point that crosslinking reaction is accelerated and adhesion to a substrate and solubility in a solvent, particularly in a general-purpose solvent can be imparted. The structural units (i)-2 are preferred from the point that when irradiating active energy rays by using a photo-cationic catalyst generating a radical or in combination of a photoradical catalyst and the photo-cationic catalyst, a curing speed can be increased and further a mechanical strength such as hardness of a cured article can be increased.

Preferred structural units (i) of the fluorine-containing ethylenic monomer having functional group are structural units represented by the formula (4):

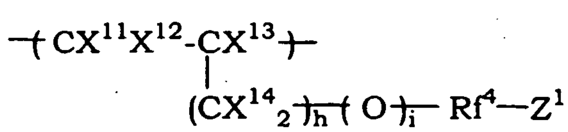

(4)

wherein $X^{11}$, $X^{12}$ and $X^{13}$ are the same or different and each is H or F; $X^{14}$ is H, F or $CF_3$; h is 0, 1 or 2; i is 0 or 1; $Rf^4$ is a fluorine-containing alkylene group having 1 to 40 carbon atoms or a fluorine-containing alkylene group having 2 to 100 carbon atoms and ether bond; $Z^1$ is a polar functional group selected from the group consisting of -OH, $CH_2OH$, -COOH, carboxylic acid derivative, $-SO_3H$, sulfonic acid derivative and cyano or a radically reactive carbon-carbon double bond, and particularly preferred are structural units derived from:

$CH_2=CFCF_2ORf^4-Z^1$

wherein $Rf^4$ and $Z^1$ are as defined above.

More concretely there are preferably structural units derived from fluorine-containing ethylenic monomers such as:

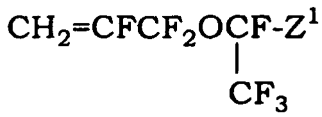 , 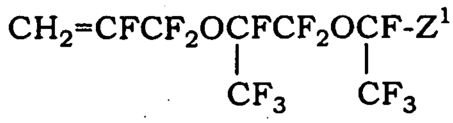 ,

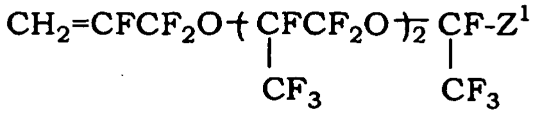 ,

$CH_2=CFCF_2OCH_2CF_2-Z^1$,

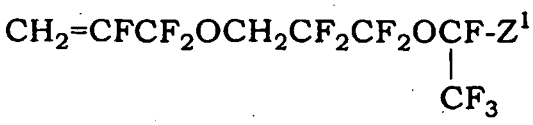 ,

$CH_2=CFCF_2OCF_2CF_2OCF_2-Z^1$,

$$CH_2=CFCF_2O(CF_2CF_2O)_2CF_2-Z^1$$

wherein $Z^1$ is as defined above.

Also there are preferred structural units derived from monomers represented by:

$$CF_2=CFORf^4-Z^1$$

wherein $Rf^4$ and $Z^1$ are as defined above. More concretely there are structural units derived from monomers such as:

$CF_2=CFOCF_2CF_2-Z^1$, $CF_2=CFOCF_2CF_2CH_2-Z^1$,

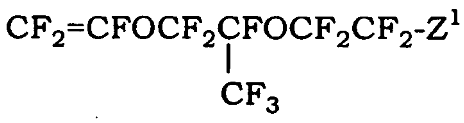 ,

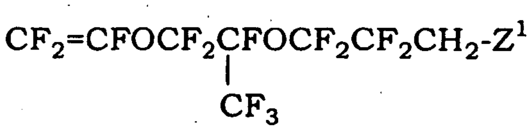 ,

$CF_2=CFO(CF_2)_3Z^1$ , $CF_2=CFO(CF_2)_3CH_2-Z^1$ ,

$CF_2=CFOCF_2CF_2OCF_2-Z^1$, $CF_2=CFOCF_2CF_2OCF_2CH_2-Z^1$,
$CF_2=CFOCF_2CF_2CH_2OCF_2CF_2-Z^1$,
$CF_2=CFOCF_2CF_2CH_2OCF_2CF_2CH_2-Z^1$

wherein $Z^1$ is as defined above.

Examples of the other fluorine-containing ethylenic monomer having functional group are:

$CF_2=CFCF_2\text{-}O\text{-}Rf^4\text{-}Z^1$ , $CF_2=CF\text{-}Rf^4\text{-}Z^1$,
$CH_2=CH\text{-}Rf^4\text{-}Z^1$, $CH_2=CHO\text{-}Rf^4\text{-}Z^1$

wherein $Rf^4$ and $Z^1$ are as defined above. More concretely there are:

$CF_2=CFCF_2OCF_2CF_2CF_2\text{-}Z^1$, $CF_2=CFCF_2OCF_2CF_2CF_2CH_2\text{-}Z^1$,

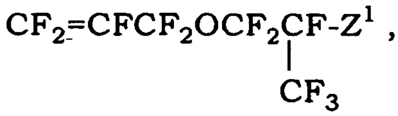 , 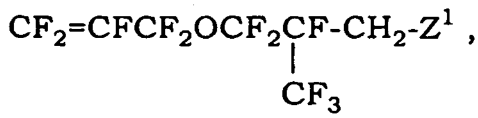 ,

$CF_2=CFCF_2\text{-}Z^1$, $CF_2=CFCF_2CH_2\text{-}Z^1$,
$CH_2=CHCF_2OF_2CH_2CH_2\text{-}Z^1$, $CH_2=CHCF_2CF_2\text{-}Z^1$,
$CH_2=CHCF_2CF_2CH_2\text{-}Z^1$, $CH_2=CHCF_2CF_2CF_2CF_2\text{-}Z^1$,
$CH_2=CHCF_2CF_2CF_2CF_2CH_2\text{-}Z^1$, $CH_2=CHO\text{-}CH_2CF_2CF_2\text{-}Z^1$,
$CH_2=CHOCH_2CF_2CF_2CH_2\text{-}Z^1$

wherein $Z^1$ is as defined above.

When using the monomer having -OH group, -COOH group or $\text{-}SO_3H$ group for the optical material for optical devices, particularly for the optical material for optical waveguide, it is preferable that an amount thereof is within the limit of not lowering near infrared transparency.

(ii) Structural units derived from fluorine-containing ethylenic monomers having no functional group

These structural units (ii) are preferred from the point that a refractive index of the fluorine-containing polymer (I) and the cured article obtained therefrom can be made low and a higher transparency thereof can be maintained. Also these structural units are preferred from the point that by selecting the monomer, mechanical properties and glass transition temperature of the polymer can be adjusted, and particularly the glass transition temperature can be increased by copolymerization with the structural unit M.

Examples of the preferred structural units (ii) of the fluorine-containing ethylenic monomer are those represented by the formula (5):

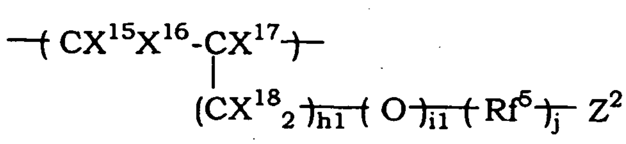 (5)

wherein $X^{15}$, $X^{16}$ and $X^{18}$ are the same or different and each is H or F; $X^{17}$ is H, F or $CF_3$; h1, i1 and j are 0 or 1; $Z^2$ is H, F or Cl; $Rf^5$ is a fluorine-containing alkylene group having 1 to 20 carbon atoms or a fluorine-containing alkylene group having 2 to 100 carbon atoms and ether bond.

Examples thereof are preferably structural units derived from monomers such as:

$CF_2=CF_2$, $CF_2=CH_2$, $CF_2=CFCl$, $CF_2=CFCF_3$ ,

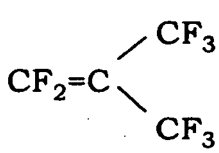 ,

$CF_2=CFO(CF_2)_nF$ (n: from 1 to 5), $CH_2=C(CF_3)_2$ , $CF_2=CFH$ , $CF_2=CCl_2$ ,

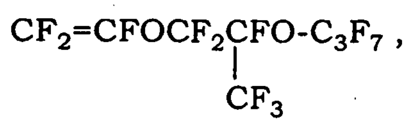

$$CH_2=CF-(CF_2)_n-Z^2$$

($Z^2$ is as defined in the formula (4), n is from 1 to 10) and

$$CH_2=CHOCH_2-(CF_2)_n-Z^2$$

($Z^2$ is as defined in the formula (4), n is from 1 to 10)

Among them, $CF_2=CF_2$, $CF_2=CH_2$, $CF_2=CFCl$ and $CF_2=CFCF_3$ are preferred from the viewpoint of transparency.

(iii) Fluorine-containing aliphatic ring structural units

Introduction of these structural units (iii) is preferred since transparency can be increased, a near infrared transparency can be increased more and further the fluorine-containing polymer (I) having a high glass transition temperature can be obtained and a higher hardness of the cured article can be expected.

The structural unit (iii) is the structural unit A in the formula (1), and an object thereof is to enhance transparency and mechanical properties by introducing a ring structure to the trunk chain of the fluorine-containing polymer (I). Therefore in order to accomplish this object, the ring structure must not be broken. On the other hand, an object of the crosslinkable cyclic ether structure in $Y^1$ which is introduced to the side chain of the structural unit M is to form a crosslinking point to cause crosslinking by ring-opening reaction, and therefore this crosslinkable cyclic ether structure differs from the structural unit (iii) in its position in the polymer, its object and its action and effect.

Examples of the preferred fluorine-containing aliphatic ring structural unit (iii) are those represented by the formula (6):

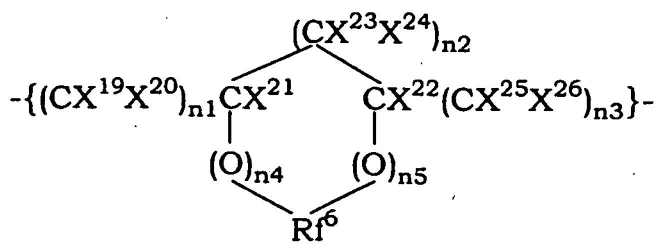

(6)

wherein $X^{19}$, $X^{20}$, $X^{23}$, $X^{24}$, $X^{25}$ and $X^{26}$ are the same or different and each is H or F; $X^{21}$ and $X^{22}$ are the same or different and each is H, F, Cl or $CF_3$; $Rf^6$ is a fluorine-containing alkylene group having 1 to 10 carbon atoms or a fluorine-containing alkylene group having 2 to 10 carbon atoms and ether bond; n2 is 0 or an integer of from 1 to 3; n1, n3, n4 and n5 are the same or different and each is 0 or 1.

For example, there are structural units represented by:

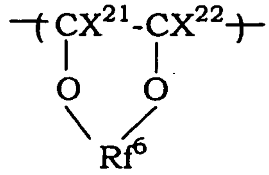

wherein $Rf^6$, $X^{21}$ and $X^{22}$ are as defined above.

Concretely there are:

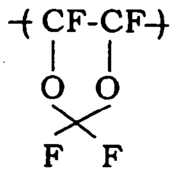 , 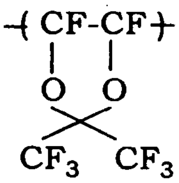 , 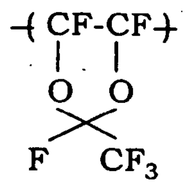 ,

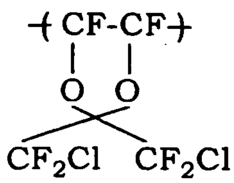 , 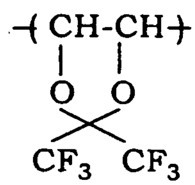 , 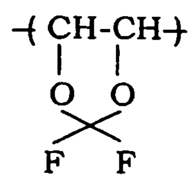 ,

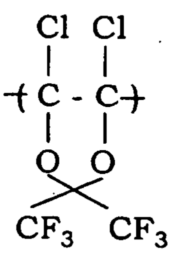 , 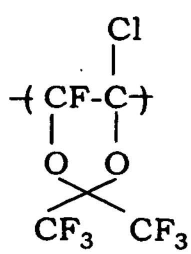 , 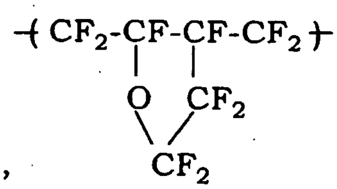 ,

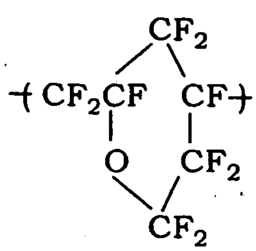 , 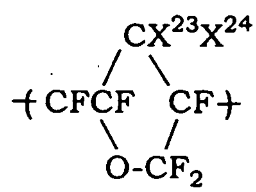 ,

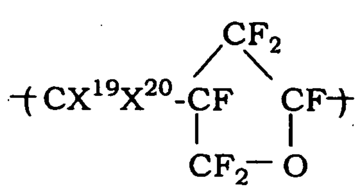 , 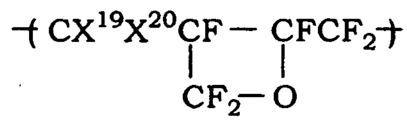 ,

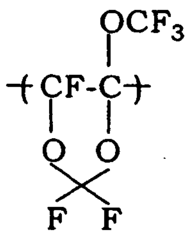 , 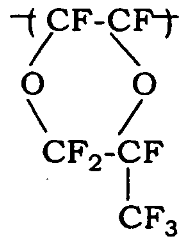 , 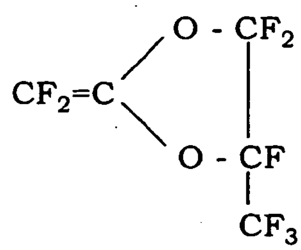

wherein $X^{19}$, $X^{20}$, $X^{23}$ and $X^{24}$ are as defined above.

(iv) Structural units derived from ethylenic monomers having no fluorine

The structural units (iv) derived from ethylenic monomers having no fluorine may be introduced to the polymer within the limit of not lowering near infrared transparency.

The introduction of those structural units (iv) can enhance solubility in general-purpose solvents and can improve compatibility with additives, for example, a photocatalyst and a crosslinking agent to be added as case demands.

Examples of the non-fluorine-containing ethylenic monomer are as follows.

α-Olefins:

Ethylene, propylene, butene, vinyl chloride, vinylidene chloride.

Vinyl ether or vinyl ester monomers:

$CH_2$=CHOR, $CH_2$=CHOCOR (R: hydrocarbon group having 1 to 20 carbon atoms).

Allyl monomers:

$CH_2$=$CHCH_2Cl$, $CH_2$=$CHCH_2OH$, $CH_2$=$CHCH_2COOH$, $CH_2$=$CHCH_2Br$.

Allyl ether monomers:

$CH_2$=$CHCH_2OR$

(R: hydrocarbon group having 1 to 20 carbon atoms),
$CH_2$=$CHCH_2OCH_2CH_2COOH$,

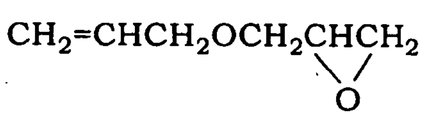 , 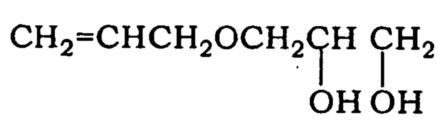

Acrylic or methacrylic monomers:

Acrylic acid, methacrylic acid, acrylic acid esters, methacrylic acid esters, maleic anhydride, maleic acid, maleic acid esters. Monomers obtained by replacing hydrogen atoms of those non-fluorine-containing ethylenic monomers with heavy hydrogen atoms are more preferred from the viewpoint of transparency.

(v) Structural units derived from alicyclic monomers

The structural unit (v) of an alicyclic monomer may be introduced as a component copolymerizable with the

structural unit M, more preferably as the third component in addition to the structural unit M and the structural unit of the above-mentioned fluorine-containing ethylenic monomer or non-fluorine-containing ethylenic monomer (the above-mentioned (iii) or (iv), respectively), thereby making a glass transition temperature and hardness high.

Examples of the alicyclic monomer (v) are norbornene derivatives represented by:

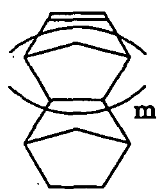

and

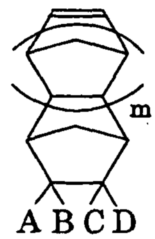

wherein m is 0 or an integer of from 1 to 3; A, B, C and D are the same or different and each is H, F, Cl, COOH, $CH_2OH$, a perfluoroalkyl group having 1 to 5 carbon atoms, alicyclic monomers such as:

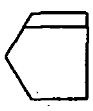 , 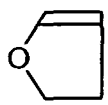 , 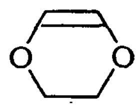 , 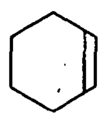 , 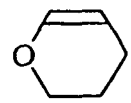 and 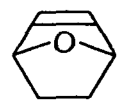

and derivatives thereof to which a substituent is introduced.

With respect to the above-exemplified monomers introducing the cyclic ether structure to the trunk chain, this cyclic ether structure differs from the crosslinkable cyclic ether structure of the structural unit M in the points mentioned in the above-mentioned structural unit (iii)

In the fluorine-containing polymer (I) of the present invention, various combinations and proportions of the structural units M (M 1, M2 or M3) and A can be selected from the above-mentioned examples depending on intended applications, physical properties (particularly glass transition temperature, hardness) functions (transparency and refractive index) as far as the combination of the structural units M and A makes the polymer non-crystalline and the fluorine content becomes not less than 25 % by weight, preferably not less than 40 % by weight.

The fluorine-containing polymer (I) contains the structural unit M (M1, M2 or M3) as essential component and has functions due to the structural unit M itself such as decreasing a refractive index, maintaining a high transparency, imparting transparency and being capable of imparting hardness, heat resistance, abrasion resistance, scratch resistance and solvent resistance to a cured article by curing (crosslinking). Also the fluorine-containing polymer has a characteristic that a refractive index can be controlled by adjusting the content of the structural unit M. Therefore even if the fluorine-containing polymer (I) contains a larger amount of the structural unit M or in the extreme case, even if the polymer consists of the structural unit M (100 by mole), a low refractive index and a high transparency can be maintained. Further a cured article having a high curing (crosslinking) density can be obtained and a coating film having a high hardness and excellent abrasion resistance, scratch resistance and heat resistance can be obtained.

Also in the case of the copolymer comprising the structural unit M and the structural unit A of the fluorine-containing polymer (I), when the structural unit A is selected from the above-mentioned examples, there can be obtained the polymer providing a cured article having a higher hardness (a high glass transition temperature) and a higher near infrared transparency.

In the copolymer comprising the structural unit M and the structural unit A of the fluorine-containing polymer (I), the proportion of the structural unit M may be not less than 0.1 % by mole based on the whole monomers constituting the fluorine-containing polymer (I). The proportion is not less than 2.0 % by mole, preferably not less than 5 % by mole, more preferably not less than 10 % by mole in order to obtain the cured article having a high hardness, excellent abrasion resistance and scratch resistance and good chemical resistance and solvent resistance by curing (crosslinking).

Particularly for applications which require formation of a cured coating film having excellent heat resistance and transparency and small moisture absorption, it is preferable that the structural unit M is contained in an amount of not less than 10 % by mole, more preferably not less than 20 % by mole, further preferably not less than 50 % by mole.

The molecular weight of the fluorine-containing polymer (I) can be selected, for example, within a range of from 500 to 1,000,000 in number average molecular weight, preferably from 1,000 to 500,000, particularly preferably from

2,000 to 200,000.

If the molecular weight is too low, mechanical properties tend to be insufficient even after the curing, and particularly a cured article and a cured coating film tend to be fragile and insufficient in strength. If the molecular weight is too high, solubility in a solvent is lowered, particularly film forming property and leveling property are apt to be lowered at forming a thin film and storage stability of the fluorine-containing polymer tends to be lowered. The most preferable number average molecular weight is selected within a range of from 5,000 to 100,000 for optical waveguide application, from 2,000 to 50,000 for sealing member application and from 10,000 to 200,000 for antireflection film application.

Further it is preferable that the fluorine-containing polymer is soluble in a solvent, particularly in at least one of ketone solvents, acetic acid ester solvents, alcohol solvents and aromatic solvents or in a solvent mixture containing at least one of the above-mentioned solvents. Being soluble in a solvent means that the concentration is not less than 10 % by weight at 25˚C.

The polymer being soluble in a solvent is preferred because film forming property and homogeneity are excellent particularly when it is necessary to form a thin coating film in a process for forming an optical waveguide, antireflection film, and also is advantageous from the viewpoint of productivity.

The fluorine-containing polymer (I) of the present invention has preferable characteristics particularly as a material for an optical waveguide since transparency is not lowered even if the proportion of the structural unit M is increased (or even if the number of cure sites is increased).

The fluorine-containing polymer (I) of the present invention has preferable characteristics particularly as a material for a sealing member for optical devices since transparency is not lowered and a refractive index is not increased even if the proportion of the structural unit M is increased (or even if the number of cure sites is increased).

Also the fluorine-containing polymer (I) of the present invention has preferable characteristics particularly as a material for antireflection film since a refractive index is not increased even if the proportion of the structural unit M is increased (or even if the number of cure sites is increased).

In order to obtain the fluorine-containing polymer (I) of the present invention, generally there can be employed any of:

(i) a method of previously synthesizing a monomer having $Y^1$ and then subjecting the monomer to homo-polymerization or copolymerization,

(ii) a method of once synthesizing a polymer having another functional group and then converting the functional group through polymer reaction, thus introducing the functional group $Y^1$ to the polymer.

For the polymerization of (i) above, radical polymerization method, anion polymerization method and cation polymerization method can be employed. Among them, the radical polymerization method is preferably used.

In order to initiate the radical polymerization, means for initiation is not limited particularly as far as the polymerization proceeds radically. The polymerization is initiated, for example, with an organic or inorganic radical polymerization initiator, heat, light or ionizing radiation. The polymerization can be carried out by solution polymerization, bulk polymerization, suspension polymerization or emulsion polymerization. The molecular weight is controlled by the contents of the monomers to be used for the polymerization, the content of the polymerization initiator, the content of a chain transfer agent, temperature. The copolymer composition can be controlled by the starting monomer composition.

In the method of (ii) above, the curable fluorine-containing polymer of the present invention can be obtained, for example, by a method of first synthesizing a fluorine-containing polymer comprising a structural unit of a fluorine-containing monomer having hydroxyl group, isocyanate group, amino group, carboxyl group, -COCl, -COF or an organic group $Y^3$ having any of those groups and as case demands, a structural unit of a copolymerizable monomer and then reacting the polymer with a halogenated compound having a structure of $Y^1$ or its derivative to introduce the crosslinkable cyclic ether structure to a side chain of the polymer.

Examples of the halogenated compound having the crosslinkable cyclic ether structure or its derivative which is reacted with the fluorine-containing polymer having hydroxyl group are:

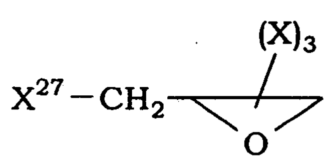
,
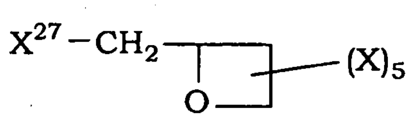

wherein $X^{27}$ is Cl, Br or I; X are the same or different and each is H, F, an alkyl group having 1 to 6 carbon atoms or a fluorine-containing alkyl group having 1 to 6 carbon atoms.

Examples of the curable fluorine-containing polymer (I) represented by the above-mentioned formula (1) are:

a fluorine-containing polymer (Ia) having crosslinkable group which has a number average molecular weight of from 500 to 1,000,000 and is represented by the formula (2):

- (M4) - (B) - (2)

wherein the structural unit M4 is a structural unit derived from a fluorine-containing ethylenic monomer and represented by the formula (M4):

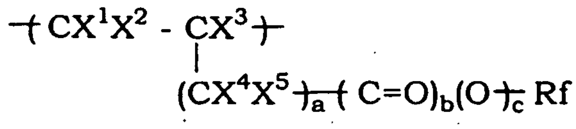

(M4)

wherein $X^1$ and $X^2$ are the same or different and each is H or F; $X^3$ is H, F, $CH_3$ or $CF_3$; $X^4$ and $X^5$ are the same or different and each is H, F or $CF_3$; Rf is an organic group in which 1 to 3 $Y^2$ ($Y^2$ is an organic group having 2 to 100 carbon atoms and 1 to 5 crosslinkable cyclic ether structures of:

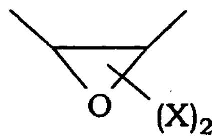

wherein X are the same or different and each is a hydrogen atom, a fluorine atom, an alkyl group having 1 to 6 carbon atoms or a fluorine-containing alkyl group having 1 to 6 carbon atoms, or
an organic group having 3 to 100 carbon atoms and 1 to 5 structures represented by the formula:

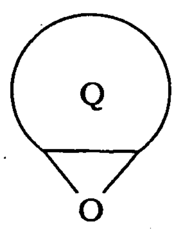

wherein Q is a monovalent or divalent organic group of monocyclic, polycyclic or heterocyclic structure having 3 to 100 carbon atoms in which hydrogen atom of Q may be substituted with the mentioned X) are bonded to a fluorine-containing alkyl group having 1 to 40 carbon atoms or a fluorine-containing alkyl group having 2 to 100 carbon atoms and ether bond; a is 0 or an integer of from 1 to 3; b and c are the same or different and each is 0 or 1,
the structural unit B is a structural unit derived from a monomer copolymerizable with the fluorine-containing ethylenic monomer for the structural unit represented by the formula (M4), and
the structural units M4 and B are contained in amounts of from 0.1 to 100 % by mole and from 0 to 99.9 % by mole, respectively, and a fluorine-containing polymer (Ib) having crosslinkable group which has a number average molecular weight of from 500 to 1,000,000 and is represented by the formula (2-1):

- (M4) - (B) - (2-1)

wherein the structural unit M4 is a structural unit derived from a fluorine-containing ethylenic monomer and represented by the formula (M4-1):

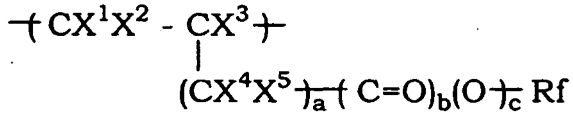

(M4-1)

wherein $X^1$ and $X^2$ are the same or different and each is H or F; $X^3$ is H, F, $CH_3$ or $CF_3$; $X^4$ and $X^5$ are the same or different and each is H, F or $CF_3$; Rf is a fluorine-containing alkyl group having 1 to 40 carbon atoms or a fluorine-containing alkyl group having 2 to 100 carbon atoms and ether bond which has $Y^{2a}$ ($Y^{2a}$ is an organic group having 3 to 100 carbon atoms and 1 to 5 crosslinkable cyclic ether structures of:

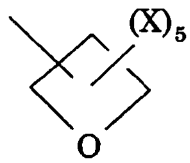

or

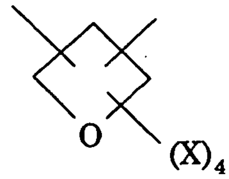

wherein X are the same or different and each is hydrogen atom, fluorine atom, an alkyl group having 1 to 6 carbon atoms or a fluorine-containing alkyl group having 1 to 6 carbon atoms; a is 0 or an integer of from 1 to 3; b and c are the same or different and each is 0 or 1,

the structural unit B is a structural unit derived from a monomer copolymerizable with the fluorine-containing ethylenic monomer for the structural unit represented by the formula (M4-1), and the structural units M4 and B are contained in amounts of from 0.1 to 100 % by mole and from 0 to 99.9 % by mole, respectively. The fluorine-containing polymers (Ia) and (Ib) having crosslinkable group are novel polymers.

Examples of those novel fluorine-containing polymers (Ia) and (Ib) are polymers exemplified in the fluorine-containing polymer (I) mentioned supra, in which $Y^1$ is replaced by $Y^2$ or $Y^{2a}$. Also examples of the structural unit B are the same as those of the structural unit A mentioned supra.

Examples of the crosslinkable cyclic ether structure in the novel fluorine-containing polymers of the present invention are preferably the same as those exemplified in (Y-a2), (Y-a3), (Y-b1) and (Y-b2) mentioned supra.

Among them, those having oxetane structure (Y-b1 and Y-b2 mentioned supra) are particularly preferred from the viewpoint of curing reactivity.

Those novel fluorine-containing polymers (Ia) and (Ib) can be prepared using the following monomers by the above-mentioned method.

The fluorine-containing ethylenic monomer which provides the novel fluorine-containing polymers (Ia) and (Ib) and is represented by the formula:

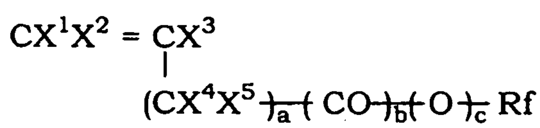

wherein $X^1$, $X^2$, $X^3$, $X^4$, $X^5$, a, b, c and Rf (having $Y^2$ or $Y^{2a}$ instead of $Y^1$) is a novel monomer.

Examples of the novel monomer are the same as the above-mentioned monomers introducing the structural unit M, in which $Y^1$ is replaced by $Y^2$ or $Y^{2a}$.

Examples of $Y^2$ and $Y^{2a}$ and preferred examples thereof are the same as in the above-mentioned novel fluorine-containing polymers (Ia) and (Ib), and monomers having an oxetane structure (Y-b1 and Y-b2 mentioned supra) are preferred novel monomers.

Among them, preferred are novel monomers such as:

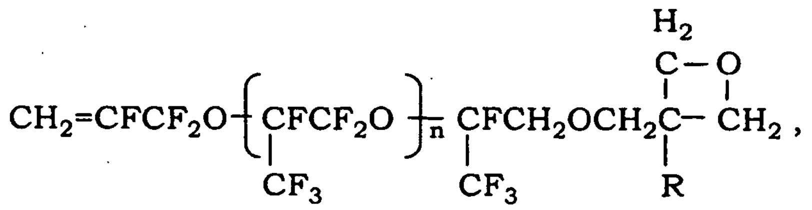

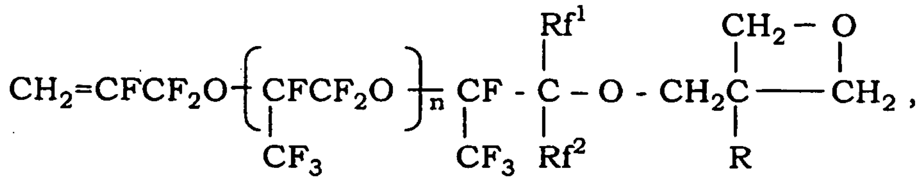

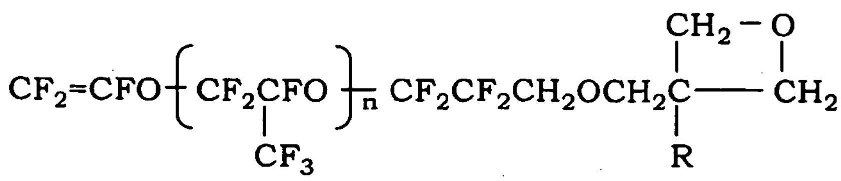

wherein R is H or $CH_3$; $Rf^1$ and $Rf^2$ are the same or different and each is a perfluoro alkyl group having 1 to 5 carbon atoms; n is 0 or an integer of from 1 to 30.

Such a novel fluorine-containing ethylenic monomer can be synthesized, for example, by reacting a halogenated compound having $Y^2$ or $Y^{2a}$, for example, Br - $CH_2$

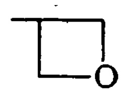

with a fluorine-containing olefin having hydroxyl group at its end in the presence of a base.

Preferred examples of the base are, for instance, hydroxides of alkali metal such as sodium hydroxide and potassium hydroxide; hydroxides of alkali earth metal such as calcium hydroxide; carbonates of alkali metal such as sodium carbonate; metal alkoxides such as sodium methoxide, sodium ethoxide and potassium-t-butoxide; and tertiary amines such as triethylamine and pyridine. Among them, hydroxides of alkali metal, carbonates of alkali metal and tertiary amines are preferred.

A reaction solvent may be or may not be used. When the reaction solvent is not used, the halogenated compound having $Y^2$ or $Y^{2a}$ is reacted usually in an excess amount to the fluorine-containing olefin having hydroxyl group.

When used, the reaction solvent is not limited particularly. Preferred examples thereof are alcohols such as methanol and ethanol; ethers such as tetrahydrofuran, dioxane and monoglyme; ketones such as acetone and methyl ethyl ketone; tertiary amines such as triethylamine and pyridine; dimethylformamide and dimethyl sulfoxide.

The reaction temperature can be within a range of from -10°C to 250°C, and is preferably from room temperature to 180°C, more preferably from 80° to 150°C.

Next, the photo-curable fluorine-containing resin composition of the first invention prepared using the curable fluorine-containing polymer (I) is explained below.

The photo-curable fluorine-containing resin composition of the present invention comprises:

(a) the curable fluorine-containing polymer (I) and
(b) the photoacid generator (II).

The curable fluorine-containing polymer (I) of the component (a) is as explained supra.

The photoacid generator (II) used as the component (b) are those which generate a cation (acid) only by irradiation of active energy rays such as visible light, ultraviolet light, electron beam, X-rays and γ-rays and act as a

catalyst to initiate ring-opening addition reaction (crosslinking reaction) of the crosslinkable cyclic ether of $Y^1$ contained in the side chain of the structural unit M of the fluorine-containing polymer.

The present inventors have found that the photo-curable fluorine-containing resin composition of the present invention can be applied to substrates which have low heat resistance and easily undergo deformation, decomposition and coloring due to heat, for example, transparent resin substrates because curing reaction can be easily initiated by the above-mentioned active energy rays, heating at high temperatures is not necessary and the curing reaction can be carried out at relatively low temperatures.

Further the present inventors have found that curability (curing reactivity) of the photo-curable fluorine-containing resin composition of the present invention is better than that of, for example, conventional non-fluorine-containing photo-curable resin compositions having epoxy group and conventional photo-curable resin compositions comprising a fluorine-containing polymer, and also have found that particularly even in case of a thick coating film, it is possible to obtain a cured film having uniform degree of curing and high hardness in a relatively short period of time. Thus from the viewpoint of productivity, an effect of reducing energy and time required for processing can also be attained.

The photoacid generator used for the photo-curable fluorine-containing resin composition of the present invention has light absorption within a wavelength range of preferably from 120 to 400 nm, more preferably from 200 to 380 nm, particularly preferably from 250 to 380 nm.

It is preferable that the photoacid generator (II) is a compound having fluorine atom since compatibility with the fluorine-containing polymer (I) is enhanced.

Examples of the photoacid generator (II) are, for instance, as follows.

Onium salts:

Iodonium salt, sulfonium salt, phosphonium salt, diazonium salt, ammonium salt and pyridinium salt.

Metallocene compounds

Iron-arene complex.

Sulfone compounds:

β-keto ester, β-sulfonyl sulfone and α-diazo compounds thereof.

Sulfonic acid esters:

Alkyl sulfonate, haloalkyl sulfonate, aryl sulfonate and imino sulfonate.

Others:

Sulfonimide compounds and diazomethane compounds.

Among them, iodonium salts, sulfonium salts, diazonium salts and metallocene compounds are preferred. Further preferred is at least one aromatic compound selected from the group consisting of aromatic diazonium salts, aromatic sulfonium salts, aromatic iodonium salts and metallocene compounds. Those compounds are preferred since cation species which initiate cation polymerization are generated at high quantum efficiency by irradiation of light.

Further preferred is at least one aromatic compound selected from the group consisting of aromatic diazonium salts, aromatic sulfonium salts, aromatic iodonium salts and metallocene compounds, in which to the aromatic ring are bonded 1 to 4 organic groups R, wherein R are the same or different and each is thiophenoxy group, thioalkyl group, hydroxyl group or an alkyl group which has 1 to 10 carbon atoms and may have an ether bond. Those compounds are preferred because of good compatibility with the curable fluorine-containing polymer (I). Also the photoacid generator, in which at least one of R is thiophenoxy group, is preferred because of a relatively long absorption wavelength.

Examples of the photoacid generator (initiator) are compounds represented by:

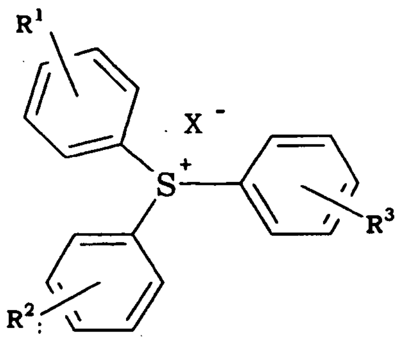

,

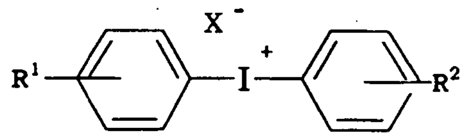

,

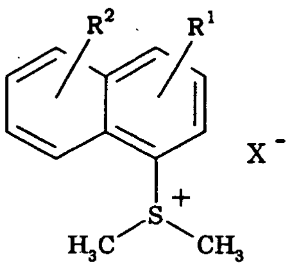

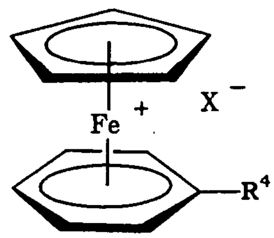

and

wherein $R^1$ to $R^4$ are the same or different and each is an alkyl group having 1 to 10 carbon atoms which may have ether bond, hydroxyl group, thioalkyl group or thiophenoxy group; $X^-$ is a counter anion.

$R^1$ to $R^4$ may be hydrogen atoms and, at least one of them is preferably any of hydroxyl group, thioalkyl group, thiophenoxy group or an alkyl group having 1 to 5 carbon atoms which has or does not have ether bond.

Preferred X- is a fluorine-containing anion because of excellent compatibility with the fluorine-containing polymer. Examples thereof are $PF_6^-$, $AsF_6^-$, $BF_4^-$, $SbF_6^-$, $CF_3SO_3^-$, $C_4F_9SO_3^-$, $C_8F_{17}SO_3^-$,

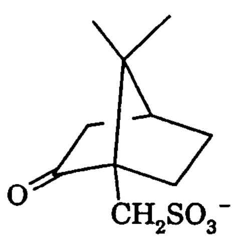

,

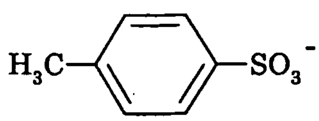

Also it is preferable that $R^1$ to $R^4$ are partly fluorinated since compatibility with the fluorine-containing polymer is more excellent.

Examples of such an initiator are:

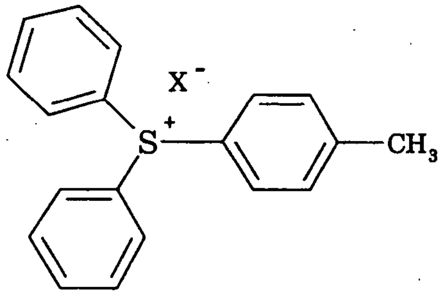
,
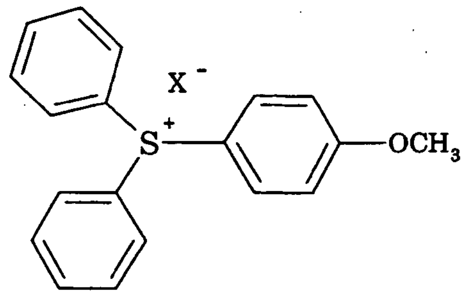
,
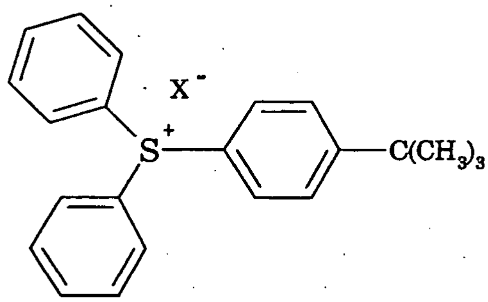
,
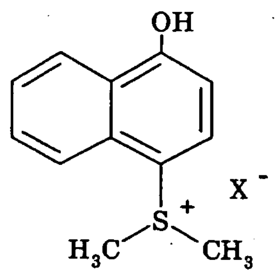
,
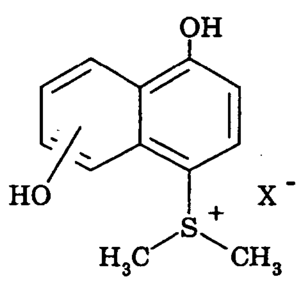
,
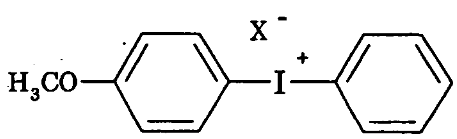
,
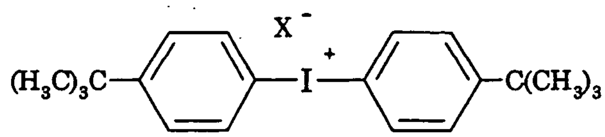

wherein X is as defined above.

The photo-curable fluorine-containing resin composition of the present invention may consist of any one of the above-exemplified curable fluorine-containing polymers (I) or may comprise two or more thereof.

A preferred curable fluorine-containing polymer (I) used for the photo-curable fluorine-containing resin composition of the present invention is one having high transparency to light at a wavelength of from 200 to 400 nm. Particularly preferred is one having light transmittance of not less than 30 %, further not less than 40 % per 1mm of an optical path length at a light absorption wavelength of from 250 to 380 nm.

The curable fluorine-containing polymer (I) of the present invention is preferred because transparency to light in the mentioned ultraviolet region is high.

In the curable fluorine-containing resin composition of the present invention, an adding amount of the photoacid generator (II) is optionally selected depending on the content of the cationically polymerizable group (crosslinkable cyclic

ether structure unit) in the fluorine-containing polymer (I), an amount of the crosslinking agent and further kind of the photoacid generator (initiator), a wavelength of light source and an amount of irradiation energy (intensity and time) and also depending on whether or not the crosslinking agent is used. When the crosslinking agent is not used, the amount of the initiator is not less than 0.01 part by weight, preferably not less than 0.05 part by weight, most preferably not less than 0.1 part by weight and not more than 30 parts by weight, preferably not more than 20 parts by weight, most preferably not more than 10 parts by weight based on 100 parts by weight of the fluorine-containing polymer (I).

To the curable fluorine-containing resin composition of the present invention comprising the curable fluorine-containing polymer (I) and the photoacid generator (II) may be further added the following crosslinking agent.

Preferred example of the crosslinking agent is one having at least one functional group undergoing cation polymerization. Examples thereof are concretely monomers or oligomers which have a cyclic ether group being capable of undergoing cation polymerization such as oxirane or oxetane monomers or oligomers. Also the crosslinking agent may be monomers having at least one cationically polymerizable carbon-carbon double bond such as vinyl ether monomers.

Those crosslinking agents having a cationically polymerizable group react with a cation generated from the photoacid generator in the composition of the present invention by irradiation of light and can be copolymerized with the crosslinkable cyclic ether which is a crosslinking site in the side chain of the fluorine-containing polymer (I) in the composition of the present invention.

Examples of the monomer for the crosslinking agent are, for instance, epoxy, alicyclic epoxy, glycidyl and oxetane monomers. In order to maintain a low refractive index, preferred are monomers having a fluoroalkyl group or a fluoroalkoxy group. Examples of the mono-functional monomer are, for instance, fluorine-containing oxirane compounds such as compounds represented by the formula:

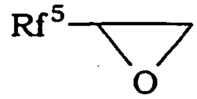

or

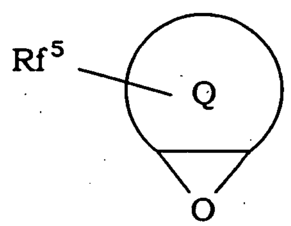

wherein $Rf^5$ is a fluorine-containing alkyl group having 1 to 40 carbon atoms or a fluorine-containing alkyl group having 1 to 100 carbon atoms and ether bond; Q is an organic group of monocyclic, polycyclic or heterocyclic structure having 3 to 100 carbon atoms, in which hydrogen atom of Q may be substituted with X, wherein X are the same or different and each is hydrogen atom, fluorine atom, an alkyl group having 1 to 6 carbon atoms or a fluorine-containing alkyl group having 1 to 6 carbon atoms which may have ether bond, and
fluorine-containing oxetane compounds represented by the formula (7):

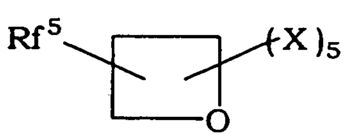

or

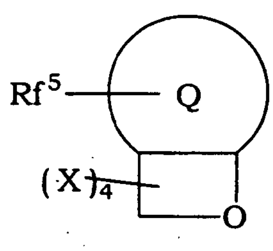

(7)

wherein $Rf^5$ is as defined above; X are the same or different and each is hydrogen atom, fluorine atom, an alkyl group having 1 to 6 carbon atoms or a fluorine-containing alkyl group having 1 to 6 carbon atoms which may have ether bond; Q is an organic group of monocyclic, polycyclic or heterocyclic structure having 3 to 100 carbon atoms, in which hydrogen atom of Q may be substituted with the above-mentioned X. Among them, the mono-functional fluorine-containing oxetane compounds of the formula (7) are novel compounds which have not been disclosed in any literatures and patent publications.

More preferred examples of those mono-functional fluorine-containing oxirane compounds and fluorine-containing oxetane compounds are compounds represented by:

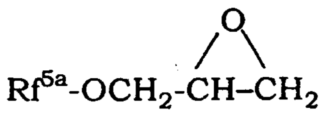, 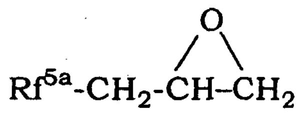,

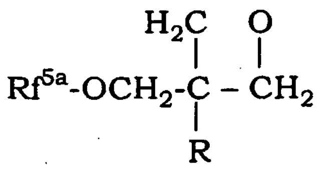 and 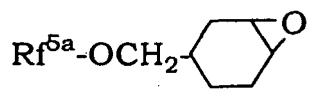

wherein R is H or $CH_3$; $Rf^{5a}$ is a fluorine-containing alkyl group having 1 to 40 carbon atoms or a fluorine-containing alkyl group having 1 to 100 carbon atoms and ether bond.

Concretely there are:

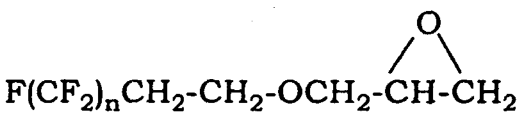, 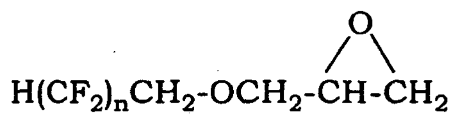,

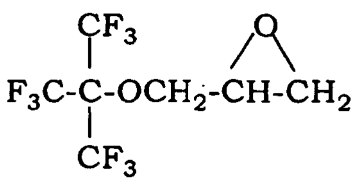, 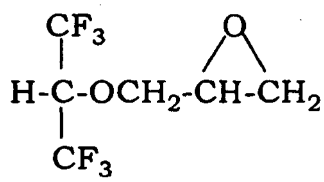,

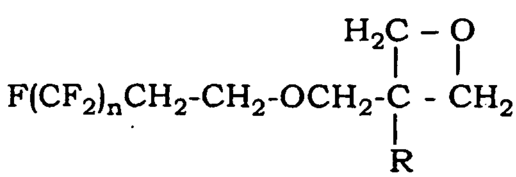, 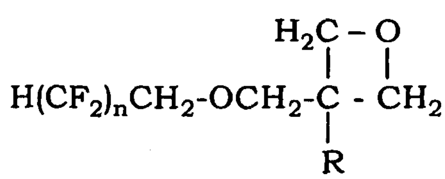,

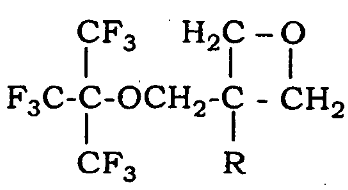, 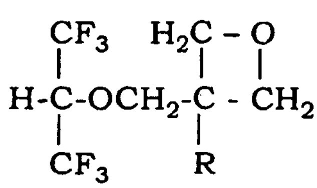,

wherein R is H or $CH_3$; n is an integer of from 1 to 4.

Examples of the multi-functional monomer are multi-functional fluorine-containing oxirane compounds represented by:

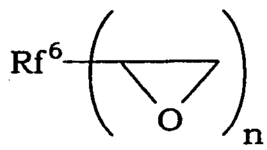

or

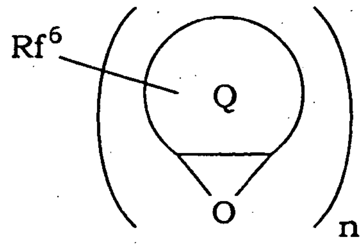

wherein $Rf^6$ is a di-, tri-, tetra-, penta- or hexa-valent fluorine-containing organic group having 1 to 40 carbon atoms or a di-, tri-, tetra-, penta- or hexa-valent fluorine-containing organic group having 1 to 100 carbon atoms and ether bond; n is an integer of from 2 to 6; Q is the same organic group as above having 3 to 100 carbon atoms, and multi-functional fluorine-containing oxetane compounds represented by the formula (8):

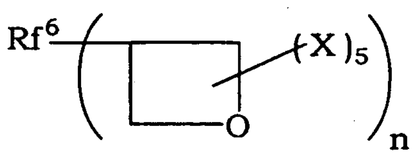

or

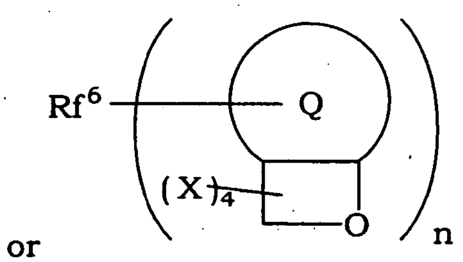

(8)

wherein $Rf^6$ is as defined above; X are the same or different and each is H, F, an alkyl group having 1 to 6 carbon atoms or a fluorine-containing alkyl group having 1 to 6 carbon atoms which may have ether bond; Q is the same organic group as above having 3 to 100 carbon atoms. The multi-functional fluorine-containing oxetane compounds of the formula (8) are novel compounds which have not been disclosed in any literatures and patent publications.

Among them, preferred is:

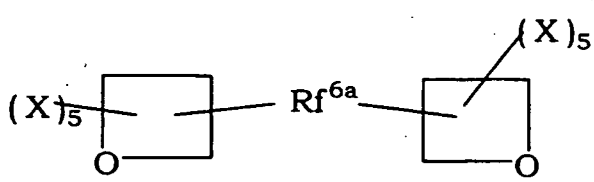

wherein $Rf^{6a}$ is a divalent fluorine-containing alkylene group having 1 to 40 carbon atoms or a divalent fluorine-containing alkylene group having 1 to 100 carbon atoms and ether bond; X is as defined above, or

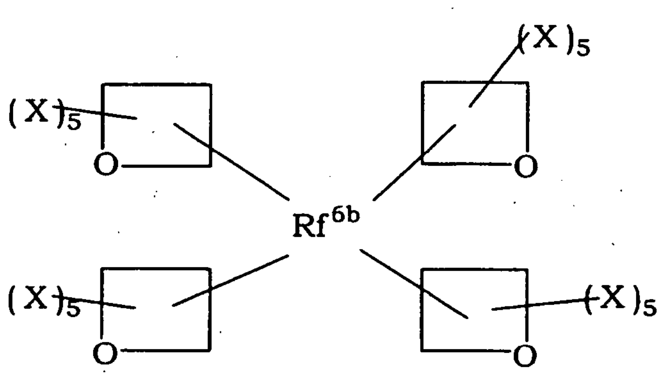

wherein $Rf^{6b}$ is a tetra-valent fluorine-containing alkylene group having 1 to 40 carbon atoms or a fluorine-containing alkylene group having 1 to 100 carbon atoms and ether bond; X is as defined above. Those bi-functional and tetra-functional fluorine-containing oxetane compounds are also novel compounds which have not been disclosed in any literatures and patent publications.

Concretely preferred are:

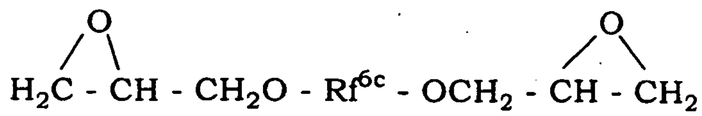

and

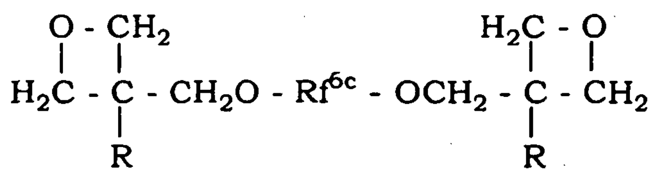

wherein R is H or $CH_3$; $Rf^{6c}$ is a fluorine-containing organic group having 1 to 100 carbon atoms which has two or more valences.

There are concretely:

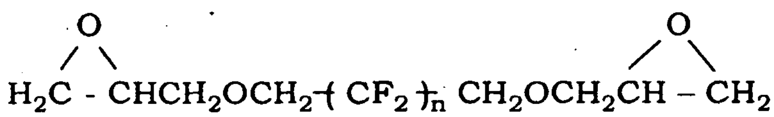

,

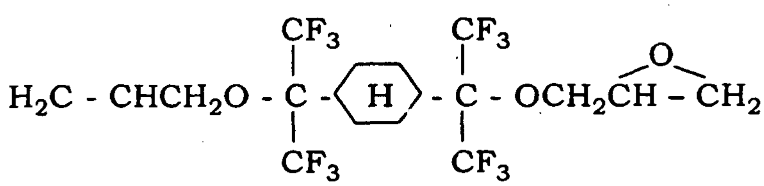

,

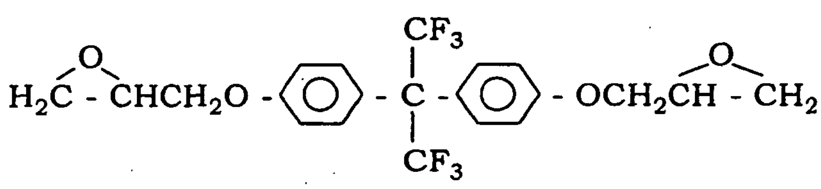

wherein n is an integer of from 1 to 8.

Examples of other crosslinking agent which can be used are oxirane oligomers and oxetane oligomers. There are, for example, oligomers represented by the formulae:

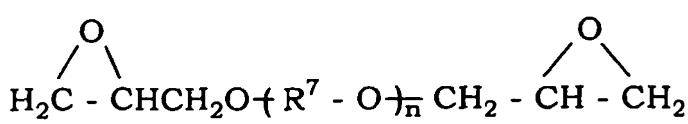

and

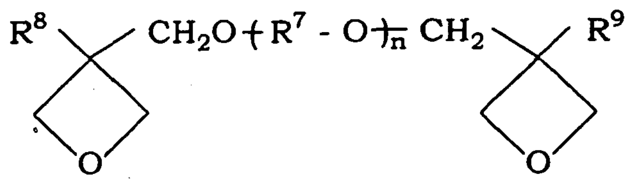

wherein $R^7$ is a divalent organic group having 3 to 20 carbon atoms; $R^8$ and $R^9$ are the same or different and each is H or $CH_3$; n is an integer of from 2 to 100.

Among them, preferred are oligomers in which a part or the whole of hydrogen atoms of the organic group $R^7$ are substituted with fluorine atoms since particularly high transparency can be maintained and a low refractive index can be maintained.

Also when those exemplified mono-functional and multi-functional monomers and oligomers are used as a crosslinking agent for the composition of the present invention, particularly preferred are fluorine-containing oxetane compounds and mixtures of fluorine-containing oxetane compound and fluorine-containing oxirane compound from the viewpoint of good curing reactivity.

To the composition of the present invention may be added an acrylic, methacrylic or α-fluoroacrylic mono-functional or multi-functional monomer depending on required characteristics (curing reactivity, hardness, scratch resistance, abrasion resistance). Among them, preferred are multi-functional monomers which have any one of or two or more of acrylic, methacrylic and α-fluoroacrylic functional groups and a crosslinkable cyclic ether structure since curing reactivity, hardness, scratch resistance and abrasion resistance can be enhanced. There are, for example:

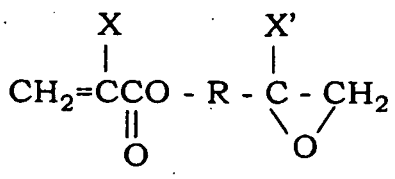 , 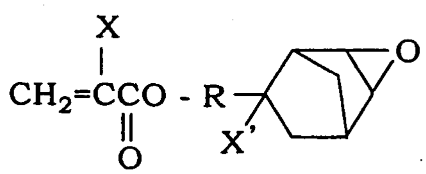 ,

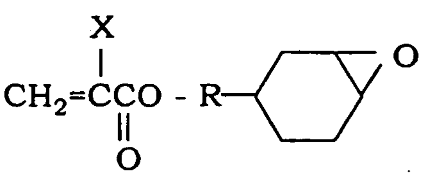 , 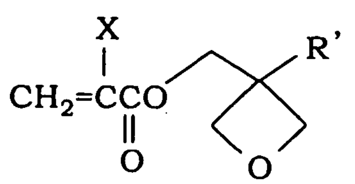

wherein X is H, $CH_3$ or F; X' is H or $CH_3$; R is a divalent organic group having 1 to 10 carbon atoms; R' is an alkyl group having 1 to 5 carbon atoms.

Examples thereof are:

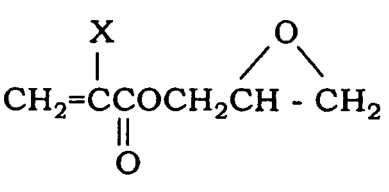 , 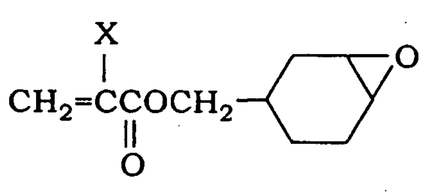

wherein X is H, $CH_3$ or F.

When those monomers are blended, it is possible to carry out curing only by adding the above-mentioned photo-cationic catalyst as a catalyst (initiator). A combination use of the photo-cationic catalyst and a photoradical

catalyst is preferred since curing reactivity can be enhanced.

To the composition of the present invention may be added a fluorine-containing polymer having no crosslinkable cyclic ether structure depending on required characteristics (refractive index, curing reactivity). Preferred as the fluorine-containing polymer to be added are those which are non-crystalline and are soluble in an organic solvent because processing and molding are easy and the polymer is transparent. Particularly preferred are fluorine-containing polymers which are non-crystalline, are soluble in an organic solvent and have a radically reactive C=C bond from the viewpoint of high hardness and excellent scratch resistance and abrasion resistance. Among them, particularly preferred are radically curable fluorine-containing polymers disclosed in International Publication No. WO02/18457 from the viewpoint of a low refractive index, high hardness and excellent curing reactivity, scratch resistance and abrasion resistance. When the fluorine-containing polymer having radically reactive crosslinkable group is blended, it is possible to carry out curing by adding only the above-mentioned photoacid generator as an initiator. A combination use of the photo-cationic catalyst and a photoradical generator is preferred since curing reactivity can be enhanced.

In the composition of the present invention, in addition to the above-mentioned compounds, various additives may be added as case demands within a limit not lowering transparency.

Examples of such additives are, for instance, a leveling agent, viscosity control agent, light-stabilizer, moisture absorbing agent, pigment, dye and reinforcing agent.

The fluorine-containing resin composition of the present invention is dissolved or dispersed in various solvents and used in the form of solution or dispersion.

The solvent to be used for making the solution is not limited particularly as far as the fluorine-containing polymer (I), photoacid generator (II) and a crosslinking agent and other additives to be added as case demands are uniformly dissolved or dispersed in it. Particularly preferred is a solvent dissolving the fluorine-containing polymer (I) uniformly.

Examples of the solvent are, for instance, cellosolve solvents such as methyl cellosolve, ethyl cellosolve, methyl cellosolve acetate and ethyl cellosolve acetate; ester solvents such as diethyl oxalate, ethyl pyruvate, ethyl-2-hydroxybutyrate, ethyl acetoacetate, butyl acetate, isobutyl acetate, propyl acetate, amyl acetate, ethyl butyrate, butyl butyrate, methyl lactate, ethyl lactate, methyl 3-methoxypropionate, ethyl 3-methoxypropionate, methyl 2-hydroxyisobutyrate and ethyl 2-hydroxyisobutyrate; propylene glycol solvents such as propylene glycol monomethyl ether, propylene glycol monoethyl ether, propylene glycol monobutyl ether, propylene glycol monomethyl ether acetate, propylene glycol monoethyl ether acetate, propylene glycol monobutyl ether acetate and dipropylene glycol dimethyl ether; ketone solvents such as methyl ethyl ketone, methyl isobutyl ketone, 2-hexanone, cyclohexanone, methyl amino ketone and 2-heptanone; alcohol solvents such as methanol, ethanol, n-propanol, isopropanol, n-butanol, isobutanol and isopentyl alcohol; aromatic hydrocarbons such as toluene and xylene; solvent mixtures of two or more thereof.

Also in order to enhance solubility of the fluorine-containing polymer (I), a fluorine-containing solvent may be used as case demands.

Examples of the fluorine-containing solvent are, for instance, $CH_3CCl_2F$ (HCFC-141b), a mixture of $CF_3CF_2CHCl_2$ and $CClF_2CF_2CHClF$ (HCFC-225), perfluorohexane, perfluoro(2-butyltetrahydrofuran), methoxy-nonafluorobutane, 1,3-bistrifluoromethylbenzene, and in addition, fluorine-containing alcohols such as:

$$H(CF_2CF_2)_nCH_2OH$$

(n: an integer of from 1 to 3),

$$F(CF_2)_nCH_2OH$$

(n: an integer of from 1 to 5) and

$$(CF_3)_2CHOH,$$

benzotrifluoride, perfluorobenzene, perfluoro(tributylamine) and $ClCF_2CFClCF_2CFCl_2$.

Those fluorine-containing solvents may be used solely, in a mixture thereof or in a mixture of one or more of the fluorine-containing solvents and non-fluorine-containing solvents.

Among them, general-purpose solvents such as ketone solvents, acetic acid ester solvents, alcohol solvents and aromatic solvents are preferred from the viewpoint of coatability and productivity of a coating film.

Also to the composition of the present invention can be added fine particles of inorganic compound depending

on applications (for example, antireflection film, sealing member) in order to enhance hardness and optical properties thereof such as a low refractive index, wide wavelength range and low reflection.

In the present invention, the inorganic compound may be in the form of ultra fine particles or colloid sol. An amount of fine particles of inorganic compound to be added in the coating film may be from 50 % by weight to 75 % by weight based on the weight of the coating film.

If the adding amount of inorganic fine particles is increased, the fluorine-containing component in the cured article is diluted and action of the fluorine-containing component for decreasing a refractive index is reduced. However instead thereof, micro voids are formed in the coating film, and due to action of the micro voids, a refractive index of the coating film is decreased near the refractive index of air. Therefore a material having a remarkably reduced refractive index can be obtained in combination of the fluorine-containing component with the micro voids.

If the adding amount of inorganic fine particles in the cured article is less than 50 % by weight based on the weight of the coating film, usually micro voids are not formed in the coating film, and a refractive index of the coating film can be decreased mainly by action of the fluorine-containing component.

When the adding amount of inorganic fine particles in the coating film exceeds 50 % by weight based on the weight of the coating film, micro voids are formed in the coating film and a refractive index of the coating film can be decreased remarkably by the both actions of the fluorine-containing component and the micro voids though it varies depending on the composition of the cured article. If the adding amount of inorganic fine particles in the cured article exceeds 75 % by weight based on the weight of the coating film, there remains action of the fluorine-containing component, but action of the micro voids for decreasing the refractive index becomes relatively strong and as a result, significant optical properties of the coating film are maintained while a mechanical strength thereof is reduced.

The fine particles and colloid sol of inorganic compound are not limited particularly, but preferred are compounds having a refractive index of not more than 1.5. Concretely desirable are fine particles and colloid sol of magnesium fluoride (refractive index: 1.38), silicon oxide (refractive index: 1.46), aluminum fluoride (refractive index: 1.33 to 1.39), calcium fluoride (refractive index: 1.44), lithium fluoride (refractive index: 1.36 to 1.37), sodium fluoride (refractive index: 1.32 to 1.34), thorium fluoride (refractive index: 1.45 to 1.50) and the like. It is desirable that a particle size (volume average particle size) of the fine particles and colloid sol is small enough with respect to a wavelength of visible light in order to secure transparency of the material having a low refractive index. The particle size is not more than 100 nm, particularly preferably not more than 50 nm.

The volume average particle size of fine particles is measured at room temperature with a particle size distribution meter (for example, particle size distribution meter model 9320HRA available from Micro Truck Co., Ltd.) by a laser diffraction scattering method by dispersing the fine particles in an organic solvent such as ethanol.

It is desirable that the fine particles of inorganic compound are used in the form of organic sol previously dispersed in an organic dispersant in order not to lower dispersion stability in the composition and adhesion in the low refractive index material. Further in the composition, in order to enhance dispersion stability and adhesion in the low refractive index material of the fine particles of inorganic compound, surfaces of the fine particles of inorganic compound can be decorated previously with various coupling agents.

Examples of the coupling agent are, for instance, organosilicon compounds; metal alkoxides such as aluminum, titanium, zirconium, antimony and a mixture thereof; salts of organic acid; coordination compounds having ligand.

In the fluorine-containing resin composition of the present invention, the curable fluorine-containing polymer (I) or the additives may be in the form of dispersion or solution in the solvent. Being in the form of uniform solution is preferred to form a uniform coating film and also to enable the film to be formed at relatively low temperature.

For coating the composition, proper known coating methods can be adopted depending on applications. For example, when it is necessary to control a coating thickness, there can be employed a roll coating method, a gravure coating method, a micro gravure coating method, a flow coating method, a bar coating method, a spray coating method, a die coating method, a spin coating method and a dip coating method.

The curable resin composition of the present invention comprising the curable fluorine-containing polymer (I) and the photoacid generator (II) and also the coating film obtained by coating the composition on a substrate by the above-mentioned method and then drying can be photo-cured by irradiation of active energy rays such as ultraviolet light, electron beam or radiation.

By the photo-curing, the crosslinkable cyclic ether in the curable fluorine-containing polymer (I) undergoes cleavage and opening of a ring and the fluorine-containing polymers (I) are combined directly or through the crosslinking agent, thereby causing curing. As a result, a resin hardness is increased, a mechanical strength, abrasion resistance and scratch resistance are enhanced and the polymer becomes insoluble not only in a solvent in which the polymer is soluble before the curing but also in many other kinds of solvents.

The curing reactivity of the curable fluorine-containing polymer (I) used in the present invention varies depending mainly on an amount and kind of the photoacid generator (II), a wavelength of light source and an amount of irradiation energy and also depending on a difference in the cyclic ether structure of the side chain of the fluorine-containing polymer (I).

As mentioned supra, oxiranes, oxetanes, tetrahydrofurans, 1,3-dioxolans and 1,3,5-trioxanes are preferred as the cyclic ether structure of the side chain of the curable fluorine-containing polymer (I). Among them, more preferred are oxetanes and oxiranes (particularly alicyclic epoxy group and glycidyl group) which exhibit high curing reactivity while maintaining a low refractive index of the polymer.

Particularly oxetanes are higher in polymerization rate than oxiranes and are difficult to undergo chain transfer. Also oxetanes are more preferred as a material for optical waveguide because of a little generation of hydroxyl group by crosslinking reaction. Also it is more preferable to mix any of a polymer, oligomer or monomer having an oxirane structure (epoxy or glycidyl) with the curable fluorine-containing polymer having an oxetane structure in its side chain since curing can be carried out at a higher rate.

The composition of the present invention can be easily cured under usual photo-curing conditions by action of the photoacid generator and a curing agent to be added as case demands, and thus a cured article having excellent transparency and mechanical properties can be obtained. A preferred curing rate of the cured article of the present invention, namely a preferred reaction rate of the functional group is from 30 to 100 %, more preferably from 50 to 100 %, further preferably from 80 to 100 %, and can be obtained from an absorption intensity of C-O stretch (2,100 to 2,300 nm) of near infrared spectrum. The cured article having such a reaction rate has a high Tg and excellent heat resistance and solvent resistance.

With respect to the conditions for obtaining such a reaction rate, when the above-mentioned photoacid generator is used, a wavelength of irradiation light is preferably from 200 to 400 nm which corresponds to an absorption wavelength of the photoacid generator, and an amount of light exposure is preferably not less than 0.1 $J/cm^2$ since an enough reaction rate is obtained. The amount of light exposure of not more than 10 $J/cm^2$ is preferred because deterioration such as a change in color is not given to the film. A curing temperature is not limited particularly and is usually not more than 150°C to prevent the change in color, and is not less than 20°C, preferably not less than 30°C, further preferably not less than 40°C to shorten a period of time of from starting of light irradiation to completion of the curing reaction.

The photo-curable fluorine-containing resin composition of the present invention is useful as an optical material for optical devices such as a material for optical waveguide and as a material for sealing member which is necessary for fabrication of optical devices, and also is useful as an optical material for display devices such as an antireflection film. In addition, the composition can be used as a material for a sealing member for electronic semiconductor, a water-proof and moisture-proof adhesive and an adhesive for optical parts and devices.

The second invention relates to the optical material for optical devices which contains the curable fluorine-containing polymer (I) represented by the formula (1).

Such an optical material contains the curable fluorine-containing polymer (I) and can be in the form of a photo-curable fluorine-containing resin composition of the first invention further containing the photoacid generator (II).

For the optical material for optical devices, transparency is required in addition to excellent resistance to water absorption and moisture absorption, excellent heat resistance and easy molding. Known as the optical device are functional devices such as an optical waveguide, OADM, optical switch, optical filter, optical connector and optical multiplex/ demultiplex device and optical mounts such as optical wiring. The optical material for optical devices is also suitable for the use as functional devices for optical devices such as a modulator, a wavelength conversion device and optical amplifier by blending thereto various functional compounds (non-linear optical material, fluorescence-emitting functional pigment, photorefractive material). Also as mentioned supra, the sealing member itself does not become a functional device, but is a member necessary for designing and fabrication of optical devices. In the second invention, those devices are collectively referred to as optical devices.

The optical material of the present invention can be used as it is as a member for optical devices without curing the curable fluorine-containing polymer (I). However it is preferable to use, as a member for optical devices, the optical material in the form of a cured article by curing (crosslinking) the polymer (I) for enhancing a mechanical strength, heat resistance and solvent resistance.

When the fluorine-containing polymer (I) is used alone, the polymer may be dissolved or dispersed in the above-mentioned solvent to be in the form of solution or dispersion, formed into a film by a spin coating method, roll coating method or gravure coating method and then cured by irradiation of active energy rays or heat treating.

The use of the optical material for optical devices in the form of the above-mentioned photo-curable fluorine-containing resin composition by blending the photoacid generator (II) is better not only since a cured article can be obtained at high speed (short period of time) but also since a resin being inferior in heat resistance can be used as a substrate.

In the optical material obtained using the fluorine-containing polymer (I) having the above-mentioned crosslinkable cyclic ether structure, a rate of curing reaction of the crosslinkable cyclic ether structure is in the same level as or higher than that of the curing (crosslinking) reaction of, for example, the fluorine-containing polymer having an ethylenic carbon-carbon double bond which is disclosed in International Publication No. WO02/18457 mentioned supra, and in addition, the optical material is superior because a reaction failure is difficult to occur even under atmosphere containing oxygen and further because of a little shrinkage by the curing reaction and excellent dimensional stability.

Next, mentioned below is explanation in the case where the optical device is an optical waveguide.

The above-mentioned optical material for optical devices can be employed as the optical material for optical waveguide. Basically the explanation made supra with respect to the curable fluorine-containing polymer (II) and the photo-curable fluorine-containing resin composition can be applied as it is to the optical material for optical waveguide. Therefore explained below are mainly particulars to be noted for the optical waveguide.

In the material for optical waveguide of the present invention, when the photoacid generator (II) is used, its amount is optionally selected depending on the content of crosslinkable cyclic ether structures in the fluorine-containing polymer (I), an amount of the crosslinking agent, and further kinds of the photoacid generator and active energy ray and an amount of irradiation energy (intensity and time) and also depending on whether or not the above-mentioned crosslinking agent is used. When the crosslinking agent is not used, the amount of the photoacid generator is not less than 0.01 part by weight, more preferably not less than 0.05 part by weight, most preferably not less than 0.1 part by weight, and not more than 30 parts by weight, more preferably not more than 20 parts by weight, most preferably not more than 10 parts by weight based on 100 parts by weight of the fluorine-containing polymer (I).

Particularly the amount of the photoacid generator (II) is not less than 0.05 % by mole, more preferably not less than 0.1 % by mole, most preferably not less than 0.5 % by mole, and not more than 50 % by mole, more preferably not more than 20 % by mole, most preferably not more than 10 % by mole based on the content (number of moles) of crosslinkable cyclic ether structures contained in the fluorine-containing polymer (I).

When the crosslinking agent is used, the amount of the photoacid generator is not less than 0.05 % by mole, more preferably not less than 0.1 % by mole, most preferably not less than 0.5 % by mole, and not more than 50 % by mole, more preferably not more than 20 % by mole, most preferably not more than 10 % by mole based on the total number of moles of crosslinkable cyclic ether structures contained in the fluorine-containing polymer (I) and crosslinkable cyclic ether structures of the crosslinking agent.

To the material of the present invention may be added various additives as case demands in addition to the above-mentioned compounds within a range not lowering near infrared transparency.

Examples of the additives are, for instance, a leveling agent, viscosity control agent, light-stabilizer, moisture absorbing agent, pigment, dye and reinforcing agent.

The material for the optical waveguide of the present invention is dissolved or dispersed in the above-mentioned solvent and is used for production of various members for optical waveguide.

The member for optical waveguide of the present invention is obtained from a cured article produced by photocuring the fluorine-containing polymer (I) alone or the above-mentioned fluorine-containing resin composition.

The cured article is preferably one having a maximum absorption coefficient of not more than 1 $cm^{-1}$, preferably not more than 0.5 $cm^{-1}$ in wavelength ranges of from 1,290 to 1,320 nm and from 1,530 to 1,570 nm.

An optical loss of the cured article is ideally zero in the above-mentioned wavelength ranges. The optical loss is preferably not more than 5 db/cm, and particularly when the cured article is used on a core portion, the optical loss is preferably not more than 2 db/cm, more preferably not more than 1 db/cm, particularly preferably not more than 0.7 db/cm.

The optical waveguide member is a member constituting the optical waveguide device and is formed on a substrate. The optical waveguide device is produced by connecting optical functional devices with an optical waveguide and the optical waveguide comprises a core portion and a clad portion. On the other hand, the optical functional device is a device undergoing functions of amplification, conversion of a wavelength, optical multiplex/demultiplex, selection of a wavelength, of an optical communication signal. There are various forms of functional devices and there are waveguide type functional devices such as optical multiplexer/demultiplexer devices and optical amplification devices. In that case, those functional devices also comprise a core portion and a clad portion. The member of the present invention can be used on any of the core portion and clad portion of those functional devices. The member of the present invention may be used only on the core portion or the clad portion. Also it is possible to use the member of the present invention as a core material for a waveguide type functional device by adding various functional compounds, for example, a non-linear optical material, a fluorescence-emitting functional organic pigment and a photo-refractive material to the member. Further it is preferable that the both of the core portion and the clad portion are cured articles obtained by curing the fluorine-containing polymer (I).

When the optical waveguide device comprises a core portion and a clad portion, a refractive index of the core portion must be higher than that of the clad portion. A difference in the refractive index between the core portion and the clad portion is preferably not less than 0.003, more preferably not less than 0.01. The difference in the refractive index varies depending on required characteristics and is usually not more than 1. Since the refractive index of the material and member of the present invention can be controlled in a wide range, materials can be selected from a wide range.

In the optical waveguide device, a width of the core portion is preferably from 1 to 200 $\mu$m, more preferably from 5 to 50 $\mu$m. Also a preferred height of the core portion is from 5 to 50 $\mu$m. An accuracy of the width and height of the core portion is preferably not more than 5 %, more preferably not more than 1 % of an average value.

Fig. 1 is a diagrammatic cross-sectional view of a structure of a typical optical waveguide device. Numeral 1 represents a substrate, numeral 2 represents a core portion and numerals 4 and 5 represent clad portions. Such an optical waveguide device is used to connect optical functional devices. Light coming out from a terminal of one optical functional device is transmitted through the inside of the core portion 2 of the optical waveguide device to a terminal of another optical functional device while repeating total reflections, for example, on an interface between the core portion 2 and the clad portions 4 and 5. The optical waveguide device can be optionally formed into a plane, strip, ridge or embedded type.

A material of the substrate of the optical waveguide device is not limited particularly, and materials such as metal, semiconductor material, ceramic, glass, thermoplastic resin and thermo-setting resin can be used optionally.

Fig. 2 shows an example of production steps of an optical waveguide device using the material of the present invention. The optical waveguide device is produced using a photolithography technology. First, as shown in Fig. 2(a), a clad portion 4 is previously formed on a substrate 1, and then a film 3 of the optical waveguide material of the present invention for a core portion is formed. In forming the films of the clad portion 4 and the core portion of the optical waveguide materials, it is preferable to coat the solutions of those materials by coating means such as rotary coating, cast coating or roll coating, and the rotary coating is particularly preferred. Each of the solutions of materials is prepared preferably by dissolving the materials in a solvent at a proper concentration for the thickness of each film and then filtrating, for example, through a filter having a pore size of about 0.2 $\mu$m.

The preferred concentration of each solution varies depending on a coating method. With respect to the resin for forming the core portion, the concentration is generally from 5 to 1,000 g, particularly preferably from 30 to 500 g per liter of a solvent, and with respect to the material for clad portion, the concentration is generally from 1 to 1,000 g, particularly preferably from 30 to 500 g per liter of a solvent. The preferred concentration of a radiation-sensitive material which is added, as case demands, for applying a lithography technology using radiation is generally from 100 to 500 g, particularly preferably from 300 to 400 g per liter of a solvent.

As a solvent for preparing the solutions, there can be suitably used those mentioned supra.

Next, as shown in Fig. 2(b), the fluorine-containing polymer is irradiated with active energy ray 7 through a mask 6 having a specific pattern form. Then pre-baking is carried out as case demands. By photo-curing, the crosslinkable cyclic ether structures in the fluorine-containing polymer (I) in the optical wavegiude material of the present invention are polymerized between the molecules thereof and thereby the crosslinkable cyclic ether structures in the polymer decrease or disappear. As a result, hardness of the resin becomes high, a mechanical strength and heat resistance are increased and further the resin becomes insoluble not only in a solvent in which the resin is soluble before the curing but also in many other kinds of solvents. Namely, the polymer functions as a photoresist material. Then un-cured fluorine-containing polymer is dissolved and distilled off with a proper solvent to form the core portion 2 having a specific pattern form as shown in Fig. 2(c). Though the device in the form only having the so-obtained core portion 2 can be used as it is as the optical waveguide device, it is preferable that after the formation of the core portion 2, the clad portion 5 is further formed as shown in Fig. 2(d). It is preferable that the clad portion 5 is formed by coating the solution of material by rotary coating, cast coating or roll coating, and the rotary coating is particularly preferred. It is also preferable that the solution of material for the clad portion 5 is prepared by dissolving a specific material in a solvent and then filtrating, for example, with a filter having a pore size of about 0.2 $\mu$m.

In addition, there are useful methods for the pattern formation such as relief printing, lithography printing (off-set printing), intaglio printing (gravure printing), stencil printing (screen printing) and electrophotographic printing.

In case where the clad portion 5 is produced from the optical waveguide material of the present invention, examples of a solvent for preparing the resin solution are, for instance, those exemplified in the above-mentioned core portion 2 and clad portion 4.

Next, the material for a sealing member and the optical device comprising the cured article obtained by curing the material are explained below.

The above-mentioned optical material for optical devices can be used for the optical material for a sealing member, and basically the explanation relating to the curable fluorine-containing polymer (I) and the photo-curable fluorine-containing resin composition can be applied as it is to the optical material for a sealing member. Therefore mentioned below are mainly explanations with respect to the processes for preparation and fabrication of the material for a sealing member and applications thereof.

The material for a sealing member of the present invention can be prepared, for example, by mixing, kneading and pulverizing, through usual method, the curable fluorine-containing polymer (I) and as case demands, the photoacid generator (II) and further additives such as a curing accelerator, dye, modifier, deterioration-preventing agent and mold-releasing agent in combination of dry-blending method and further melt-blending method and then if necessary, formulating to tablets.

Sealing with the material for a sealing member can be carried out through usual method by filling the material in a portion to be sealed and molding by a known molding method such as a transfer molding method.

The optical devices sealed with the material of the present invention have very excellent reliability on moisture

prevention and resistance to moisture because of less shrinkage by curing due to a free volume derived from the molecular structure of the fluorine-containing polymer in addition to excellent moisture preventing property and excellent resistance to moisture of the sealing portion which are derived from the fluorine-containing polymer.

Also the material of the present invention is excellent in transparency within a wide range of from ultraviolet light to near infrared light and therefore is useful particularly for a sealing member in optical applications.

In the case of using the sealing member of the present invention for applications where transparency to ultraviolet light and near infrared light is not so required, it is preferable to blend a resinous substance (epoxy resin) having two or more oxirane groups in one molecule because necessary rigidity and flexibility can be imparted and further a viscosity and Tg can be controlled according to kind of the substance and an adding amount thereof.

To the composition of the present invention can be blended an epoxy resin for the purpose to freely control a refractive index of the cured article depending on applications (for example, a sealing member).

Examples of the epoxy resin are:

(i) glycidyl ether type,
(ii) glycidyl amine type,
(iii) glycidyl ester type, and
(iv) oxidated olefin (alicyclic) type.

The glycidyl type resins of (i) to (iii) are epoxy resins obtained from epichlorohydrin and active hydrogen compound, and resins generally called epoxy resins are usually those types. The glycidyl ether type epoxy resin of (i) shares not less than 90 % of commercially available epoxy resins.

Basic structures of the glycidyl ether type are shown below and are classified into the following three kinds of structures.

(A) bi-functional repeat structure type,
(B) multi-functional repeat structure type, and
(C) multi-functional monomer type.

(A) Bi-functional repeat structure type

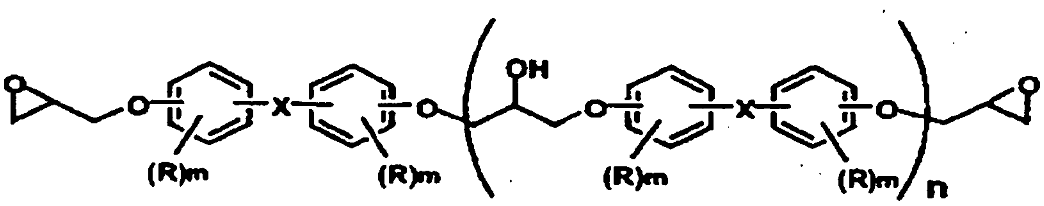

(B) Multi-functional repeat structure type (Oligomer)

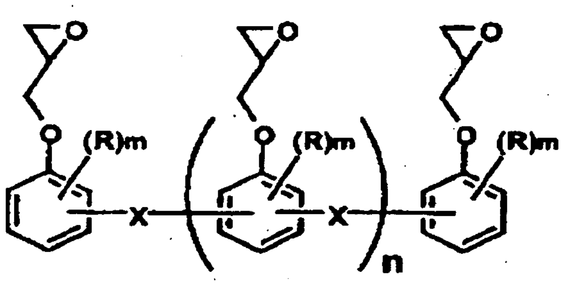

(C) Multi-functional monomer type (Monomer)

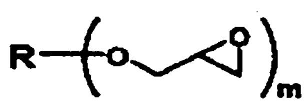

Bisphenol A type liquid epoxy resins which are the most general epoxy resins belong to (A), and cresol novolac type epoxy resins which are mainly used in sealing material applications for semiconductor belong to (B).

Examples of the application of the sealing member of the present invention are, for instance, packaging (sealing) and surface mount of optical functional devices such as light emitter and photodetector, i.e. light emitting diode (LED), electroluminescent device and non-linear optical device. Also there are applications for sealing materials (or filling materials) for optical members such as lens for deep ultraviolet microscope. Sealed optical devices are used for various applications. Nonlimiting examples thereof are light emitters of light source of high-mount-stop-lamp, meter panel, back light of mobile phone and remote control of various electric appliances; photodetectors for auto focus of camera and

optical pick-up of CD/DVD.

The present invention also relates to optical devices obtained by sealing optical functional devices with the sealing member of the present invention.

The third invention relates to the optical material for display devices.

The optical material for display devices are required to have transparency mainly in visible light and controllability of a refractive index. Particularly in an antireflection film application, a low refractive index is further preferred, and in addition, high hardness, abrasion resistance, scratch resistance and stain-proofing property are demanded. Further it is also demanded that resistance to water and moisture absorption and heat resistance are excellent and molding is easy.

Known as a display device are an antireflection film. Further the optical material of the present invention for display devices is suitable for use for various display devices when various functional compounds (fluorescence emitting functional pigment and liquid crystal component) are admixed thereto. In the third invention, those are collectively referred to as a display device.

The optical material for display devices of the present invention can be used as it is for the member for optical devices without curing the curable fluorine-containing polymer (I), but from the viewpoint of enhancing mechanical strength, solvent resistance and chemical resistance, it is preferable to use the optical material as the member for optical devices in the form of cured article by curing (crosslinking) the polymer.

When using the fluorine-containing polymer (I) alone, the polymer may be dissolved or dispersed in the above-mentioned solvent for forming into a solution or dispersion and then formed into a film by a spin coating method, roll coating method or gravure coating method and cured by irradiation of active energy ray or by heat treating.

The optical material for display devices in the form of the above-mentioned photo-curable fluorine-containing resin composition containing the photoacid generator (II) is excellent because a cured article can be produced at a high speed and mechanical strength of the cured article is enhanced.

In the optical material obtained using the fluorine-containing polymer (I) having the above-mentioned crosslinkable cyclic ether structure, a rate of curing reaction of the crosslinkable cyclic ether structure is in the same level as or higher than that of the curing (crosslinking) reaction of the fluorine-containing polymer having an ethylenic carbon-carbon double bond which is disclosed in International Publication No. WO02/18457 mentioned supra, and in addition, the optical material is superior because a reaction failure is difficult to occur even under atmosphere containing oxygen and further because of a little shrinkage due to the curing reaction and excellent dimensional stability.

Next, mentioned below is explanation in the case where the display device is an antireflection film.

The above-mentioned optical material for display devices can be employed as the optical material for an antireflection film. Basically the explanation made supra with respect to the curable fluorine-containing polymer (I) and the photo-curable fluorine-containing resin composition can be applied as it is to the optical material for an antireflection film. Therefore explained below are particulars to be noted for the antireflection film.

The material for an antireflection film of the present invention has been completed according to the discovery of the present inventors that when the fluorine-containing polymer (I) having a crosslinkable cyclic ether structure being curable (crosslinkable) and being low in a refractive index is coated on a transparent substrate in a specific thickness and then cured, there can be obtained an antireflection film exhibiting an antireflection effect and having high hardness, abrasion resistance and scratch resistance. When such a fluorine-containing polymer (I) is used, coatability (smoothness, uniform coating thickness) becomes good, a low molecular weight monomer component is difficult to remain in a cured coating film, the film surface is free from tackiness and excellent film characteristics are obtained.

When an antireflection film is provided on a transparent resin substrate, applying high temperature is not preferred because the substrate easily undergoes thermal deterioration and thermal deformation. Therefore photo-curing is preferred. The fluorine-containing polymer (I) used in the present invention has a crosslinkable cyclic ether structure being capable of photo-curing (for example, photo-polymerization) .

For obtaining an antireflection film by photo-curing the fluorine-containing polymer (I), there is adopted a method of firstly preparing a solution or dispersion of the fluorine-containing polymer (I) alone or a coating composition comprising the above-mentioned photo-curable fluorine-containing resin composition, coating on a substrate, drying to form a coating film (not cured) and then subjecting the film to irradiation of active energy rays such as ultraviolet light, electron beam or radiation to obtain a cured coating film. The irradiation of light may be carried out in the air or in a stream of inert gas such as nitrogen gas. Usually in many cases, the presence of oxygen obstructs curing reaction, and it is considered that irradiation of light in a stream of inert gas is preferred since curing reactivity is good. However in the fluorine-containing polymer (I) having a crosslinkable cyclic ether structure, such a curing reaction failure due to oxygen is difficult to occur, and even in the air, a high curing reaction rate can be attained.

The fluorine-containing polymer (I) used for the antireflection film of the present invention is selected from the above-mentioned examples. The curable fluorine-containing polymer to be selected is one having a high transparency, being non-crystalline and having a refractive index of not more than 1.42, preferably not more than 1.40, more preferably not more than 1.38 and not less than 1.25. Further it is preferable that the polymer is optionally selected depending on intended hardness, kind of a substrate, coating method and conditions, coating thickness, uniformity of a coating film

and adhesion to the substrate.

When the photo-curable fluorine-containing resin composition containing the photoacid generator (II) is used as the material for an antireflection film of the present invention, there can be used the same photoacid generator (initiator) (II) as exemplified supra in the explanation on the curable fluorine-containing resin composition. An amount and kind of the photoacid generator (II) can be selected optionally from the examples mentioned supra in consideration of kind (reactivity, content) of the crosslinkable cyclic ether structure in the fluorine-containing polymer (II), curing conditions, a pot life of a coating,

Solvents which can be used are the same as those exemplified supra in the photo-curable fluorine-containing resin composition, and an amount and kind thereof can be optionally selected from the examples mentioned supra depending on intended coatability, film forming property, uniformity of a coating thickness and productivity. Solvents which undergo melting and swelling of a transparent resin substrate are not preferred.

Particularly preferred are solvents selected from ketone solvents, acetic acid ester solvents, alcohol solvents and aromatic hydrocarbon solvents.

In the antireflection film of the present invention, it is a matter of course that the curable fluorine-containing polymer (I) may be used in combination with the crosslinking agent mentioned supra. By using the crosslinking agent together, hardness of a coating film can be increased more.

With respect to an amount and kind of the crosslinking agent, those mentioned in the photo-curable fluorine-containing resin composition can be preferably used similarly.

A cured article (coating film) obtained by applying the material for an antireflection film and curing the fluorine-containing polymer (I) has a refractive index of ideally from 1.22 to 1.30. When the refractive index is not more than 1.49, an antireflection effect can be obtained. The refractive index is preferably not more than 1.45, more preferably not more than 1.40, most preferably not more than 1.38. The lower the refractive index is, the more advantageous antireflection effect is obtained.

A preferred thickness of the antireflection film to be provided on various substrates varies depending on refractive indexes of the film and the substrate, and is not less than 0.03 μm, preferably not less than 0.07 μm, more preferably not less than 0.08 μm, and not more than 0.5 μm, preferably not more than 0.2 μm, more preferably not more than 0.12 μm. If the film is too thin, reduction of a reflectance due to interference of visible light tends to be insufficient, and if the film is too thick, since a reflectance depends on only reflection in an interface between air and film, reduction of a reflectance due to interference of visible light tends to be insufficient. It is preferable that a proper coating thickness is so set that a wavelength showing a minimum reflection of a product provided with the antireflection film is not less than 420 nm, preferably not less than 520 nm and not more than 720 nm, preferably not more than 620 nm.

Kind of the article, namely kind of the substrate which is provided with the antireflection film of the present invention are not limited particularly. There are, for example, inorganic materials such as glass, stone, concrete and tile; synthetic resins such as a vinyl chloride resin, polyethylene terephthalate, cellulose resin such as triacetyl cellulose, polycarbonate resin, polyolefin resin, acrylic resin, phenol resin, xylene resin, urea resin, melamine resin, diallyl phthalate resin, furan resin, amino resin, alkyd resin, urethane resin, vinyl ester resin and polyimide resin; metals such as iron, aluminum and copper; wood, paper, printed matter, printing paper and picture. When a certain portion of the article other than a specific portion thereof is provided with the antireflection film and the shape of the specific portion is lifted up by a reflecting light, a decorative effect of the article can be enhanced.

The antireflection film is preferably provided particularly on the transparent resin substrates such as an acrylic resin, polycarbonate, cellulose rein, polyethylene terephthalate and polyolefin resin, and a reflection reducing effect can be exhibited effectively.

The present invention is effectively applied on the following articles.

Optical parts such as prism, lens sheet, polarizing plate, optical filter, lenticular lens, Fresnel lens, screen of rear projection display, optical fiber and optical coupler;

Transparent protection plates represented by glass for show window, glass for show case, cover for advertisement and cover for photo-stand; Protection plates for CRT, liquid crystal display, plasma display and rear projection display;

Optical recording media represented by optical magnetic disk, optical disks such as CD·CD-R·CD-RW·LD·DVD and phase transition type optical disk such as PD;

Photolithography-related members for production of semiconductors such as photoresist, photomask, pellicle and reticule;

Protection covers for light emitters such as halogen lamp, fluorescent lamp and incandescent lamp; and

Sheet or film for adhering to the above-mentioned articles.

The antireflection film of the present invention may be formed into a cured coating film having a thickness of about 0.1 μm by applying the above-mentioned material for an antireflection film directly on a substrate and then irradiating the coating film with light, or the antireflection film may be formed, as a top coat, on one or plural undercoat layers formed on the substrate.

The effects of the undercoat are roughly classified into three, namely, an increase of scratch resistance of the

top coat, protection of the substrate and an increase of reflection reducing effect by providing the layers having a refractive index higher than that of the substrate. In order to increase scratch resistance of the top coat, a self-repairing undercoat mentioned in JP7-168005A may be used. Also for the protection of the substrate, a coating generally called a hard coat may be used. Examples of the hard coat are cured articles of curable acrylic resin and epoxy resin, cured articles of silicon alkoxide compounds and cured articles of metal alkoxide compounds. A heat curing method can be applied on all of them. For the acrylic resin and epoxy resin, a photo-curing method (ultraviolet light) is preferred from the viewpoint of productivity.

With respect to CRT and plasma display, static electricity easily deposits on the surface thereof due to characteristics of equipment. Therefore it is preferable to mix, to the undercoat layer and/or top coat layer mentioned above, an additive imparting electric conductivity. Examples of the additive are polymers having ionic group such as -COO-, $-NH_2$, $-NH_3^+$ or $-NR^{11}R^{12}R^{13}$, in which $R^{11}$, $R^{12}$ and $R^{13}$ are, for example, methyl, ethyl, n-propyl or n-butyl or $-SO_3^-$, silicone compounds and inorganic electrolytes (for example, NaF, $CaF_2$).

Also in order to prevent adhesion of dust, it is preferable to add an anti-static agent to the undercoat layer and/or the top coat layer for the antireflection film. Examples of the additive are the above-mentioned additives imparting electric conductivity and in addition, fine particles of metal oxides, fluoroalkoxysilane and surfactants (anionic, cationic, amphorytic and nonionic surfactants).

Examples of the preferred anti-static agent to be added to the undercoat layer are fine particles of metal oxides, concretely antimony-doped tin oxide (ATO) and indium-containing tin oxide (ITO) since the anti-static effect is high, is maintained for a long period of time and is hardly affected by humid and also since the reflection reducing effect can be enhanced because transparency and refractive index of the anti-static agent are so high as to enable the refractive index of the substrate to be adjusted. From the viewpoint of transparency, ATO is preferred, and from the viewpoint of anti-static effect or electric conductivity, ITO is preferred. Even in case where no anti-static effect is required, a reflection reducing effect can also be increased with those additives since the refractive index can be adjusted easily.

Also since ATO and ITO easily scatter and absorb light, in order not to obstruct transmission of light, the thickness of the undercoat layer is preferably sub-micron or so. In order to decrease dependency of the reflection reducing effect on a wavelength and to increase the reflection reducing effect throughout the whole wavelength, the thickness of the undercoat layer is preferably from 0.05 to 0.3 $\mu$m though it depends on the refractive index of the cured fluorine-containing polymer. An optimum refractive index of the undercoat layer is preferably from 1.55 to 1.95 though it also depends on the refractive index of the fluorine-containing polymer.

In order to impart anti-static property to the cured fluorine-containing polymer coating film, alkoxysilane anti-static agents are preferred from the point that the refractive index is hardly increased and those agents do not have an adverse effect on the reflection reducing effect. Fluoroalkoxysilane is further preferred since its action to increase the refractive index is further smaller and in addition, an effect of improving surface characteristics can be expected.

Also as a method being entirely different from the above-mentioned method of modifying a part of the film, there is a method of forming a surfactant layer in a thickness not having an adverse effect on the reflection reducing ability as mentioned in JP8-142280A. When this method is applied to the present invention, there is an effect of enhancing stain-proofing property such as prevention of adhesion of dust. There is the same effect also in the case of forming the hard coat layer.

The hard coat layer can be formed by the method of coating a solution of alkoxysilane or polysilazane and then heating and curing. Also a cured film obtained from an ultraviolet-curable acrylic coating or a cured film obtained by melamine-crosslinking can be used.

Further the antireflection film of the present invention may be provided on an undercoat layer formed by applying a coating agent containing fine particles as a flattening agent, namely on a substrate film (for example TAC film) subjected to anti-glaring (AG) treatment. Accordingly the antireflection film having a low gloss and a low reflection can be obtained. Such a film, when used for LCD is preferred since a further vivid image can be obtained.

The antireflection film of the present invention has a high fluorine content and a low surface contact angle and also possesses water repelling property, non-tackiness and stain-proofing property and therefore can be used as both of the antireflection layer and stain-proofing layer.

Further in order to impart stain-proofing property to the antireflection layer, a fluorine-containing polyether compound can be added. In that case, an adding amount of the compound need be decided in consideration of lowering of mechanical properties and white turbidity due to phase separation from the fluorine-containing polymer. Preferred is a linear perfluoro polyether compound. When carboxyl group, blocked carboxyl group, hydroxyl group, alkoxysilane group, oxirane group, oxetane group, (meth)acryloyl group, $\alpha$-fluoroacryloyl group or vinyl ether group is introduced to an end of the compound, the compound is easily fixed in the coating film. It is preferable that the number of repeat units of ether bond of the fluorine-containing polyether is not less than 7, more preferably not less than 10. Also the same effect can be obtained when the same polyether compound as above is coated on a surface of a previously formed antireflection film (a coating film before or after curing).

For forming a thin film of the curable fluorine-containing polymer, there are a method of coating a dispersion

of the curable fluorine-containing polymer, drying and then baking if necessary and a method of coating a solution (uniform solution) of the polymer and then drying. Preferred is the coating of the solution since a thin film is easily formed. In that case, as far as a coating thickness can be controlled sufficiently, known coating methods can be employed. For example, a roll coating method, micro gravure coating method, gravure coating method, flow coating method, bar coating method, spray coating method, die coating method, spin coating method and dip coating method can be employed. The optimum coating method is selected from them in consideration of a balance of productivity, controllability of a coating thickness, yield. The antireflection film formed into a film or sheet may be adhered to a substrate.

In the present invention, too, a silane compound may be added to enhance adhesion of the antireflection film to the substrate. An amount of the silane compound added to the coating film may be from 0.1 % by weight to 10 % by weight. Also treating of a substrate surface with a silane compound has an effect on improvement of adhesion. In the present invention, in any of the above cases, the silane compound hardly increases the refractive index of the cured film and therefore an influence thereof on the reflection reducing effect is very small.

The present invention is then explained by means of examples.

In the following Preparation Examples, Examples and Comparative Examples, equipment and measuring conditions used for evaluation of physical properties are as follows.

(1) NMR: available from BRUKER CO., LTD.
Measuring conditions of $^1$H-NMR: 300 MHz (tetramethylsilane = 0 ppm) Measuring conditions of $^{19}$F-NMR: 300 MHz (trichlorofluoromethane = 0 ppm)
(2) IR analysis: Measuring is carried out at room temperature with a Fourier-transform infrared spectrophotometer 1760X available from Perkin Elmer Co., Ltd.

PREPARATION EXAMPLE 1

(Synthesis of fluorine-containing allyl ether having glycidyl group)

Into a 500 ml four-necked glass flask equipped with a stirrer and thermometer were poured 200 g of perfluoro-(1,1,9,9-tetrahydro-2,5-bistrifluoromethyl-3,6-dioxanonenol), 2 ml of water and 114 g of epichlorohydrin, followed by heating to 60˚C. To this solution was added NaOH in ten lots with a pellet. Then the reaction solution was heated to 80˚C and reaction was carried out for six hours.

After completion of the reaction, hydrochloric acid was poured into the solution for neutralization and then the solution was poured into a separating funnel, followed by washing with water and saturated brine, drying with anhydrous magnesium sulfate and separating the solution by filtering. The solvent was distilled off from the filtrate by an evaporator. As a result of distillation of the reaction solution, 139 g of distillate was obtained. A boiling point thereof was 48˚ to 55˚C (0.04 mmHg).

According to $^1$H-NMR, $^{19}$F-NMR and IR analyses, the obtained product was found to be a fluorine-containing allyl ether (ml) of the following structure having glycidyl group.

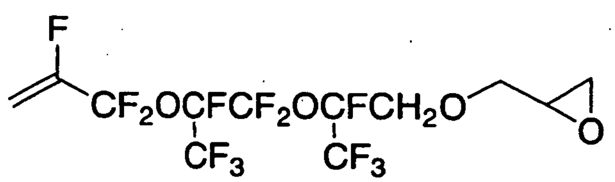

$^1$H-NMR analysis data (in δ(ppm) $CDCl_3$):

5.15 - 4.90 (2H, m), 4.05 - 3.85 (2H, m), 3.85 - 3.75 (1H, m), 3.38 - 3.25 (1H, m), 2.98 - 2.92 (1H, m), 2.68 - 2.57 (1H, m), 2.45 - 2.38 (1H, m)

$^{19}$F-NMR analysis data (in δ(ppm) $CDCl_3$, R-11 internal standard):

-72.6 - -73.0 (2F, m), -79.4 - -81.6 (8F, m), -124.0 - -124.4 (1F, m), -132.8 - -133.2 (1F, m), -145.1 - -145.6 (1F, m)

IR analysis data ($cm^{-1}$)

1695 (υC=C)

EXAMPLE 1

(Synthesis of fluorine-containing allyl ether having oxetanyl group)

Into a 500 ml four-necked glass flask equipped with a stirrer, thermometer and dropping funnel were poured 150 g of perfluoro-(1,1,9,9-tetrahydro-2,5-bistrifluoromethyl-3,6-dioxanonenol), 15 g of water, 2.9 g of tetrabutylammonium bromide (TBAB) and 72.8 g of 3-bromomethyl-3-methyloxetane (BrMMO), followed by heating to 75°C. To this solution was slowly added dropwise 36 g of 45 % by weight of NaOH solution through a dropping funnel. After completion of the addition, the reaction solution was heated to 90°C and reaction was carried out for five hours.

After completion of the reaction, the solution was neutralized with hydrochloric acid and then poured into a separating funnel, followed by washing with water and saturated brine, drying with anhydrous magnesium sulfate and separating the solution by filtering. The solvent was distilled off from the filtrate by an evaporator. As a result of distillation of the reaction solution, 133 g of distillate was obtained. A boiling point thereof was 62° to 64°C (0.2 mmHg).

According to $^1$H-NMR, $^{19}$F-NMR and IR analyses, the obtained product was found to be a fluorine-containing allyl ether (m2) of the following structure having oxetanyl group.

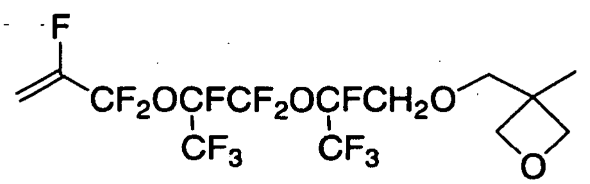

$^1$H-NMR analysis data (in δ(ppm) $CDCl_3$):

5.26 - 5.05 (2H, m), 4.38 (2H, d), 4.25 (2H, d), 4.08 - 3.96 (2H, m), 3.60-3.58 (2H, m), 1.23 (3H, s)

$^{19}$F-NMR analysis data (in δ(ppm) $CDCl_3$, R-11 internal standard):

\- 72.4 - -73.2 (2F, m), -79.8 - -81.3 (8F, m), -124.1 - -124.3 (1F, m), -132.3 - -133.4 (1F, m), -145.5 - -145.2 (1F, m)

IR analysis data (cm$^{-1}$)

1695 (υC=C)

PREPARATION EXAMPLE 2

(Synthesis of fluorine-containing allyl ether polymer having glycidyl group)

Into a 50 ml four-necked glass flask equipped with a stirrer and thermometer were poured a solution of 10.0 g of fluorine-containing allyl ether (m1) having glycidyl group synthesized in Preparation Example 1 and 8 g of HFC-365 ($CF_3CH_2CF_2CH_3$) and then 3.8 g of perfluorohexane solution of 8.0 % by weight of:

$$\left[ H\left(CF_2CF_2\right)_3COO \right]_2$$

and after sufficiently replacing the inside of the flask with nitrogen gas, stirring was continued at 20°C in a stream of nitrogen gas for nine hours and a solution having a high viscosity was obtained.

To the obtained solution was poured a sodium bicarbonate solution for neutralization, followed by dissolving in diethylether. The resultant solution was poured into a separating funnel, followed by washing with water and saturated brine. The organic layer was dried with anhydrous magnesium sulfate, and magnesium sulfate was separated by filtering. The solution was concentrated and poured into a hexane solution for re-precipitation, and the solution was separated to obtain a colorless transparent polymer. This polymer was again dissolved in diethylether to make 22.6 % by weight of solution (19.7 g)

According to $^1$H-NMR, $^{19}$F-NMR and IR analyses, the polymer was a fluorine-containing polymer which consisted of the structural unit of the above-mentioned fluorine-containing allyl ether (m1) having glycidyl group and had the glycidyl group at an end of its side chain. Also according to GPC analysis using tetrahydrofuran (THF) as a solvent, a number average molecular weight of the polymer was 13,000, and a weight average molecular weight thereof was 35,000.

EXAMPLE 2

(Synthesis of fluorine-containing allyl ether polymer having oxetanyl group)

Into a 50 ml four-necked glass flask equipped with a stirrer and thermometer were poured 5.0 g of fluorine-containing allyl ether (m2) having oxetanyl group synthesized in Example 1, 1.25 g of HCFC-141b ($CH_3CCl_2F$) and 1.92 g of perfluorohexane solution of 8.0 % by weight of:

$$\left[ H\left( CF_2CF_2 \right)_3 COO \right]_2$$

and after sufficiently replacing the inside of the flask with nitrogen gas, stirring was continued at 20°C in a stream of nitrogen gas for 21 hours and a solution having a high viscosity was obtained.

To the obtained solution was poured a sodium bicarbonate solution for neutralization, followed by dissolving in diethylether. The resultant solution was poured into a separating funnel, followed by washing with water and saturated brine. The organic layer was dried with anhydrous magnesium sulfate, and magnesium sulfate was separated by filtering. The solution was concentrated and poured into a hexane solution for re-precipitation, and the solution was separated to obtain a colorless transparent polymer. This polymer was again dissolved in diethylether to make 18.7 % by weight of solution (7.9 g).

According to $^1$H-NMR, $^{19}$F-NMR and IR analyses, the polymer was a fluorine-containing polymer which consisted of the structural unit of the above-mentioned fluorine-containing allyl ether (m2) having oxetanyl group and had the oxetanyl group at an end of its side chain. Also according to GPC analysis using tetrahydrofuran (THF) as a solvent, a number average molecular weight of the polymer was 3,800, and a weight average molecular weight thereof was 5,600.

PREPARATION EXAMPLE 3

(Synthesis of copolymer comprising fluorine-containing allyl ether having glycidyl group and tetrafluoroethylene)

A 100 ml stainless steel autoclave equipped with a valve, pressure gauge and thermometer was charged with 10.0 g of fluorine-containing allyl ether (m1) having glycidyl group synthesized in Preparation Example 1, 8.0 g of HCFC-141b and 0.10 g of 50 % by weight of methanol solution of dinormalpropyl peroxycarbonate (NPP), and the inside of a system was sufficiently replaced with nitrogen gas while cooling with dry ice/methanol solution. Then 2.9 g of tetrafluoroethylene (TFE) was introduced through the valve and polymerization was carried out while shaking at 40°C.

Eighteen hours after starting of the polymerization, the un-reacted monomer was released and the obtained polymer was taken out and neutralized in a sodium bicarbonate solution, followed by extracting with diethylether and washing with water and saturated brine. The organic layer was dried with anhydrous magnesium sulfate, and magnesium sulfate was separated by filtering. The resultant solution was concentrated and poured into a hexane solution for re-precipitation, and the solution was separated to obtain a colorless transparent polymer. This polymer was again dissolved in diethylether to make 44.7 % by weight of solution (17.1 g).

According to $^1$H-NMR and $^{19}$F-NMR analyses of the polymer (copolymer), the presence of epoxy group was recognized, and the polymer was one comprising TFE and fluorine-containing allyl ether (m1) having glycidyl group in a percent by mole ratio of 25/75. Also according to GPC analysis using THF as a solvent, a number average molecular weight of the polymer was 11,000, and a weight average molecular weight thereof was 18,000.

EXAMPLE 3

(Synthesis of copolymer comprising fluorine-containing allyl ether having oxetanyl group and TFE)

A 100 ml stainless steel autoclave equipped with a valve, pressure gauge and thermometer was charged with 10.0 g of fluorine-containing allyl ether (m2) having oxetanyl group synthesized in Preparation Example 2, 8.0 g of HCFC-141b and 0.10 g of 50 % by weight of methanol solution of dinormalpropyl peroxycarbonate (NPP), and the inside of a system was sufficiently replaced with nitrogen gas while cooling with dry ice/methanol solution. Then 3.0 g of tetrafluoroethylene (TFE) was introduced through the valve and polymerization was carried out while shaking at 40˚C.

Eighteen hours after starting of the polymerization, the un-reacted monomer was released and the obtained polymer was taken out and neutralized in a sodium bicarbonate solution, followed by extracting with diethylether and washing with water and saturated brine. The organic layer was dried with anhydrous magnesium sulfate, and magnesium sulfate was separated by filtering. The resultant solution was concentrated and poured into a hexane solution for re-precipitation, and the solution was separated to obtain a colorless transparent polymer. This polymer was again dissolved in diethylether to make 31.5 % by weight of solution (6.5 g).

According to $^{1}$H-NMR and $^{19}$F-NMR analyses of the polymer (copolymer), the presence of oxetane ring was recognized, and the polymer was one comprising TFE and fluorine-containing allyl ether (m2) having oxetanyl group in a percent by mole ratio of 11/89. Also according to GPC analysis using THF as a solvent, a number average molecular weight of the polymer was 4,000, and a weight average molecular weight thereof was 6,000.

EXAMPLE 4

(Antireflection film)

(1) Preparation of material for antireflection film

To a diethylether solution of fluorine-containing polymer having glycidyl group prepared in Preparation Example 2 was added methyl isobutyl ketone (MIBK) for diluting and adjusting the polymer concentration to 5.0 % by weight.

To 10 g of the obtained polymer solution was added 2.5 g of a solution obtained by dissolving, in MIBK, MPI-103 (trade name, 4-methoxyphenylphenyl iodonium hexafluoro antimonate available from Midori Kagaku Kabushiki Kaisha) as a photoacid generator (active energy curing initiator) at a concentration of 1 % by weight to prepare a material for an antireflection film in the form of uniform solution.

(2) Production of antireflection film

The material for an antireflection film obtained in (1) above was coated on an acryl panel having an un-treated surface at room temperature with a spin coater and then vacuum-dried at room temperature for five minutes. In that case, the number of revolutions of the spin coater was adjusted (1,000 to 2,000 revolutions) so that a thickness of dried coating film became 90 to 110 nm.

Also coatability in coating with a spin coater was evaluated by the following criteria. The results are shown in Table 1.

○: There is no unevenness of coating film.
Δ : There is partly recognized unevenness of coating film.
× : Coating cannot be carried out.

Then the dried coating film was irradiated with ultraviolet light at an intensity of 1,500 mJ/cm$^2$ at room temperature using a high pressure mercury lamp for photo-curing to produce a cured coating film (antireflection film).

(3) Measurement of refractive index of curable fluorine-containing polymer

The diethylether solution of the fluorine-containing polymer having glycidyl group prepared in Preparation Example 2 was coated on a slide glass with an applicator so that a coating thickness after the drying became about 50 μm. After vacuum drying at room temperature for 30 minutes, a refractive index (before curing) of the obtained film was measured using an Abbe's refractometer at 25˚C with light having a wavelength of 589 nm. The results are shown in Table 1.

(4) Measurement of refractive index of cured film

After a sample coating film was produced in the same manner as in (3) above, the film was subjected to irradiation of light in the same manner as in (2) above. A refractive index (after curing) of the obtained cured film was measured in the same manner as in (3) above. The results are shown in Table 1.

(5) Measurement of reflectance of one side of film

The acryl plate provided with the antireflection film which was obtained in (2) above was set on a visible ultraviolet light spectrophotometer equipped with a 5° regular reflection unit, and a reflectance was measured with light having a wavelength of 589 nm. The results are shown in Table 1.

(6) Evaluation of physical properties of antireflection film

The following physical properties of the antireflection film obtained in (2) above were evaluated. The results are shown in Table 1.

(i) Pencil hardness

Measured according to JIS K5400.

(ii) Solvent resistance

After the surface of the coating film is rubbed with a cotton cloth impregnated with ethyl acetate, condition (dissolved or peeled) of the coating film surface is evaluated with naked eyes.

The evaluation is made by:

○: There is no change.
Δ : There is partly dissolution or peeling.
× : There is dissolution or peeling.

(iii) Alkali resistance

The film is immersed in a 2N aqueous solution of KOH of 60°C for one minute and the condition of the film is observed with naked eyes and hardness is evaluated according to pencil hardness of (i) above.

The evaluation is made by:

○ : There is no change.
Δ : There are recognized deterioration of film and lowering of hardness.
× : There is peeling of film and the substrate is seen partly.

(iv) Shrinkage of volume

The material for antireflection film prepared in (1) above is poured into a shape of 50.0 mm × 10.0 mm and is dried in vacuo for 10 hours to produce a sample of 1.0 mm (thick) × 50 mm × 10 mm. The sample is subjected to irradiation of ultraviolet light under the same conditions as in (2) above for curing. After the curing, dimensions thereof are measured to calculate its volume and a shrinkage percentage of the volume is obtained.

$$\text{Shrinkage percentage of volume (\%)} = \frac{\text{Volume before curing} - \text{Volume after curing}}{\text{Volume before curing}} \times 100$$

(v) Transparency (in ultraviolet region)

An about 1 mm thick film of fluorine-containing polymer obtained in Preparation Example 2 is put between quartz glass plates, and light transmittance at a wavelength of 250 nm and 380 nm is measured using a self-recording spectrophotometer (trade name U-3310 available from Hitachi, Ltd.). The results are shown in Table 1.

EXAMPLE 5

(Antireflection film)

A material for an antireflection film was prepared in the same manner as in (1) of Example 1 except that the fluorine-containing polymer having oxetanyl group prepared in Example 2 was used as a fluorine-containing polymer. Then an antireflection film was produced in the same manner as in (2) of Example 4, and (3) Measurement of a refractive index before curing, (4) Measurement of a refractive index of cured film, (5) Measurement of reflectance on one side of film and (6) Evaluation of physical properties of the antireflection film were carried out. The results are shown in Table 1.

EXAMPLES 6 to 8

(Antireflection film)

To the material for an antireflection film obtained in (1) of Example 4 was added, as a crosslinking agent, a bi-functional epoxy compound (crosslinking agent 1) represented by the formula:

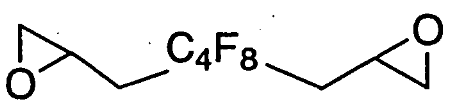

so that its amount became 0.3 equivalent (Example 6), 0.5 equivalent (Example 7) and 1.0 equivalent (Example 8) based on the polymer. Antireflection films were produced in the same manner as in (2) of Example 4 using the respective materials for an antireflection film, and (3) Measurement of refractive index before curing, (4) Measurement of refractive index of cured film, (5) Measurement of reflectance on one side of film and (6) Evaluation of physical properties of antireflection film were carried out. The results are shown in Table 1.

TABLE 1

| | Example | | | | |
|---|---|---|---|---|---|
| | 4 | 5 | 6 | 7 | 8 |
| Substrate | Acryl | Acryl | Acryl | Acryl | Acryl |
| Fluorine-containing polymer (I) | Prep. Ex. 2 | Ex. 2 | Prep. Ex. 2 | Prep. Ex. 2 | Prep. Ex. 2 |
| Kind of crosslinkable cyclic ether | Glycidyl | Oxetanyl | Glycidyl | Glycidyl | Glycidyl |
| Content of crosslinkable cyclic ether (% by mole) | 100 | 100 | 100 | 100 | 100 |
| Crosslinking agent | | | | | |
| Kind | - | - | Crosslinking agent 1 | Crosslinking agent 1 | Crosslinking agent 1 |
| Adding amount (equivalent to polymer) | - | - | 0.3 | 0.5 | 1.0 |
| Photoacid generator | | | | | |
| Kind | MPI-103 | MPI-103 | MPI-103 | MPI-103 | MPI-103 |

(continued)

| | Example | | | | |
|---|---|---|---|---|---|
| | 4 | 5 | 6 | 7 | 8 |
| Adding amount (% by weight based on polymer) | 5 | 5 | 5 | 5 | 5 |
| Amount of ultraviolet light ($mJ/cm^2$) | 1500 | 1500 | 1500 | 1500 | 1500 |
| Refractive index | | | | | |
| Before curing | 1.374 | 1.377 | 1.374 | 1.374 | 1.374 |
| After curing | 1.383 | 1.383 | 1.389 | 1.389 | 1.399 |
| Reflectance on one side of film (%) | 1.35 | 1.35 | 1.40 | 1.50 | 2.00 |
| Coatability | ○ | ○ | ○ | ○ | ○ |
| Pencil hardness | HB | HB | F | H | 3H |
| Solvent resistance | Δ | Δ | Δ | ○ | ○ |
| Alkali resistance | ○ | ○ | ○ | ○ | ○ |
| Shrinkage of volume | 2% | 2% | - | - | - |
| Transparency (250 nm) | 85% | 55% | - | - | - |
| Transparency (300 nm) | 90% | 87% | - | - | - |

EXAMPLE 9

(Synthesis of fluorine-containing crosslinking agent 2 having oxetanyl group)

Into a 100 ml four-necked glass flask equipped with a stirrer, thermometer and dropping funnel were poured 2.0 g of 2,2,3,3,4,4,5,5,6,6,7,7-dodecafluorooctane-1,8-diol, 0.06 g of tetrabutylammonium bromide (TBAB) and 2.0 g of 3-bromomethyl-3-methyloxetane (BrMMO), followed by heating to 75˚C. To the solution was slowly added dropwise 1.7 g of 40 % by weight of KOH solution through a dropping funnel. After completion of the addition, the reaction solution was heated to 90˚C and reaction was carried out for five hours.

After completion of the reaction, the solution was neutralized with hydrochloric acid and then poured into a separating funnel, followed by washing with water and saturated brine, drying with anhydrous magnesium sulfate and separating of the solution by filtering. The solvent was distilled off from the filtrate by an evaporator. As a result of distillation of the reaction solution, 2.2 g of colorless transparent liquid was obtained.

According to $^1$H-NMR, $^{19}$F-NMR and IR analyses, the obtained product was found to be a compound of the following structure. This compound is referred to as a crosslinking agent 2.

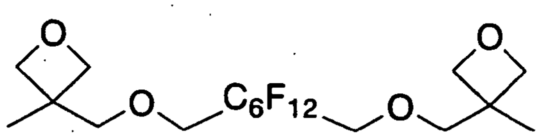

$^1$H-NMR analysis data (in δ(ppm) $CDCl_3$):

4.48 (4H, d), 4.36 (4H, d), 3.96 (4H, t), 3.66 (4H, s), 1.31 (6H, s)

$^{19}$F-NMR analysis data (in δ(ppm) $CDCl_3$, R-11 internal standard):

- 119.5 - -120.3 (4F, m), -122.3 - -123.3 (4F, m), -123.8 - -124.5 (4F, m)

EXAMPLES 10 to 12

(Antireflection film)

To the material for an antireflection film obtained in (1) of Example 4 was added, as a crosslinking agent, the bi-functional oxetane crosslinking agent 2 synthesized in Example 9 so that its amount became 0.3 equivalent (Example 10), 0.5 equivalent (Example 11) and 1.0 equivalent (Example 12) based on the polymer. Antireflection films were produced in the same manner as in (2) of Example 4 using the respective materials for an antireflection film, and (3) Measurement of refractive index before curing, (4) Measurement of refractive index of cured film, (5) Measurement of reflectance on one side of film and (6) Evaluation of physical properties of antireflection film were carried out. The results are shown in Table 2.

COMPARATIVE EXAMPLE 1

The glycidyl group of the fluorine-containing allyl ether polymer having glycidyl group synthesized in Preparation Example 2 was replaced with α-fluoroacryloyl group and a methyl ethyl ketone (MEK) solution of the polymer was prepared. To the solution was further added MEK to dilute the solution and adjust the polymer concentration to 5.0 % by weight.

To 2 g of the obtained polymer solution was added 0.1 g of a solution obtained by dissolving, in MEK, 2-hydroxy-2-methylpropiophenone (trade name DAROCUR 1174 which is a photoradical initiator available from Ciba Specialty Chemicals Co., Ltd.) as a photoacid generator (active energy curing initiator) at a concentration of 10 % by weight to make a uniform solution. By using this solution, the same evaluation as in Example 4 was carried out. The results are shown in Table 2.

COMPARATIVE EXAMPLE 2

MIBK was added for dilution to ADEKA OPTOMER KRM-2410 (trade name, available from ASAHI DENKA CO., LTD.) which is a cationically curable resin to adjust the polymer concentration to 10.0 % by weight.

To 2 g of the obtained polymer solution was added 0.1 g of a solution obtained by dissolving, in MIBK, MPI-103 used in Example 4 as a photoacid generator (active energy curing initiator) at a concentration of 10 % by weight to make a uniform solution. By using this solution, the same evaluation as in Example 4 was carried out. The results are shown in Table 2.

TABLE 2

| | Example | | | Comparative Example | |
|---|---|---|---|---|---|
| | 10 | 11 | 12 | 1 | 2 |
| Substrate | Acryl | Acryl | Acryl | Acryl | Acryl |
| Fluorine-containing polymer (I) | Prep. Ex. 2 | Prep. Ex. 2 | Prep. Ex. 2 | Com. Ex. 1 | Com. Ex. 2 |
| Kind of crosslinkable cyclic ether | Glycidyl | Glycidyl | Glycidyl | - | - |
| Content of crosslinkable cyclic ether (% by mole) | 100 | 100 | 100 | - | - |
| Crosslinking agent | | | | | |
| Kind | Crosslinking agent 2 | Crosslinking agent 2 | Crosslinking agent 2 | - | - |

(continued)

| | Example | | | Comparative Example | |
|---|---|---|---|---|---|
| | 10 | 11 | 12 | 1 | 2 |
| Adding amount (equivalent to polymer) | 0.3 | 0.5 | 1.0 | - | - |
| Photoacid generator | | | | | |
| Kind | MPI-103 | MPI-103 | MPI-103 | DAROCUR 1174 | MPI-103 |
| Adding amount (% by weight based on polymer) | 5 | 5 | 5 | 1 | 5 |
| Amount of ultraviolet light ($mJ/cm^2$) | 1500 | 1500 | 1500 | 1500 | 1500 |
| Refractive index | | | | | |
| Before curing | 1.374 | 1.374 | 1.374 | 1.376 | - |
| After curing | 1.385 | 1.389 | 1.392 | 1.381 | 1.521 |
| Reflectance on one side of film (%) | 1.4 | 1.7 | 1.8 | 1.3 | 4.3 |
| Coatability | ○ | ○ | ○ | ○ | × |
| Pencil hardness | F | H | 2H | 2B | 2H |
| Solvent resistance | Δ | ○ | ○ | Δ | ○ |
| Alkali resistance | ○ | ○ | ○ | × | ○ |
| Shrinkage of volume | - | - | - | 10% | 4% |
| Transparency (250 nm) | - | - | - | - | 0% |
| Transparency (300 nm) | - | - | - | - | 20% |

EXAMPLE 13

(Optical waveguide)

(1) Preparation of optical waveguide material

MIBK was added to a diethylether solution of the fluorine-containing polymer having glycidyl group prepared in Preparation Example 2 to dilute the solution and adjust the concentration of the polymer to 50 % by weight.

To 10 g of the obtained polymer solution was added 2.5 g of a solution prepared by dissolving, in MIBK, MPI-103 as a photoacid generator (active energy curing initiator) at a concentration of 1 % by weight. Thus a uniform solution of an optical waveguide material was produced.

(2) Production of film of optical waveguide material

The optical waveguide material (50 % ether solution of the fluorine-containing prepolymer) obtained in (1) above was coated on a polyester film with an applicator so that a coating thickness after the drying became a specific

thickness. After vacuum drying at 50°C for ten minutes, the obtained cast film was peeled from the polyester film and optical waveguide materials in the form of un-cured films having a thickness of about 1 mm and about 100 μm were produced.

(3) Production of cured film by irradiation of light

After drying of the film obtained in (2) above, ultraviolet light was irradiated on the film at an intensity of 1,500 $mJ/cm^2$ at room temperature using a high pressure mercury lamp for photo-curing to obtain a cured film.

(4) Measurement of physical properties of cured film

The following physical properties of the obtained cured film were evaluated.

(i) Measurement of absorption coefficient

A spectral transmittance curve of an about 1 mm thick sample (cured film) is obtained at a wavelength of from 300 to 1,700 nm using a self-recording spectrophotometer (U-3410 available from Hitachi, Ltd.). An absorption coefficient is calculated from the obtained spectrum by the following equation.

$$\text{Absorption coefficient} = \text{Absorbance}/\text{Thickness of sample (mm)}$$

The results are shown in Table 3.

(ii) Measurement of refractive index

A refractive index of an about 100 μm thick sample (a film before and after curing) is measured using an Abbe's refractometer at 25°C with light having a wavelength of 589 nm. The results are shown in Table 3.

(iii) Thermal characteristic (DSC)

Thermal characteristics are measured at a temperature elevating rate of 10°C/min using a differential calorimeter (DSC-50 available from Shimadzu Corporation). Any films were found to have no clear crystalline melting point peak and were non-crystalline.

(iv) Evaluation of solvent resistance

An about 1 mm thick cured film is immersed in acetone and allowed to stand at room temperature for 24 hours. After that, the condition thereof is observed with naked eyes and evaluated by the following criteria. The results are shown in Table 3.

○: There is no change in appearance.
× : Dissolved in acetone.

(v) Evaluation of heat resistance

An about 1 mm thick cured film is allowed to stand at 150°C for eight hours and a change in its form is observed with naked eyes and evaluated by the following criteria. The results are shown in Table 3.

○: There is no change in appearance.
× : The film cannot maintain its original form.

(vi) Moisture resistance

A percentage of moisture absorption after allowing to stand at 85 % × 85 % RH for 120 hours is obtained according to JIS K6911.

EXAMPLE 14

(Optical waveguide)

An optical waveguide material was produced in the same manner as in (1) of Example 13 except that the fluorine-containing polymer having oxetanyl group prepared in Example 2 was used as a fluorine-containing polymer. Then production of a film of the optical waveguide material, production of a cured film by irradiation of light and measurement of physical properties of the cured film were carried out in the same manner as in (2) to (4) of Example 13. The results are shown in Table 3.

COMPARATIVE EXAMPLE 3

MIBK was added for dilution to ADEKA OPTOMER KRM-2410 (trade name, available from ASAHI DENKA CO., LTD.) which is a cationically curable resin to adjust the polymer concentration to 10.0 % by weight.

To 2 g of the obtained polymer solution was added 0.1 g of a solution obtained by dissolving, in MIBK, MPI-103 used in Example 4 as a photoacid generator (active energy curing initiator) at a concentration of 10 % by weight to make a uniform solution. By using this solution, the same evaluation as in Example 13 was carried out. The results are shown in Table 3.

TABLE 3

| | Example | | Com. Ex. |
|---|---|---|---|
| | 13 | 14 | 3 |
| Substrate | Acryl | Acryl | Acryl |
| Fluorine-containing polymer (I) | Prep. Ex. 2 | Ex. 2 | Com. Ex. 2 |
| Kind of crosslinkable cyclic ether | Glycidyl | Oxetanyl | - |
| Content of crosslinkable cyclic ether (% by mole) | 100 | 100 | - |
| Photoacid generator | | | |
| Kind | MPI-103 | MPI-103 | MPI-103 |
| Adding amount (% by weight based on polymer) | 5 | 5 | 5 |
| Amount of ultraviolet light ($mJ/cm^2$) | 1500 | 1500 | 1500 |
| Refractive index | | | |
| Before curing | 1.374 | 1.377 | - |
| After curing | 1.383 | 1.383 | 1.521 |
| Absorption coefficient ($cm^{-1}$) | | | |
| 1,310 nm | 0.06 | 0.08 | - |
| 1,550 nm | 0.29 | 0.32 | - |
| Solvent resistance | ○ | ○ | ○ |
| Heat resistance | ○ | ○ | ○ |
| Moisture resistance | 0.5% | 0.3% | 2.5% |

The results of the above-mentioned examples indicate that the optical materials of the present invention are excellent in transparency, moisture resistance, heat resistance, mechanical strength and solvent resistance and have a small shrinkage percentage of volume. Therefore it is evident that the optical materials of the present invention are superior as an optical material for sealing members.

PREPARATION EXAMPLE 4

(Synthesis of low molecular weight fluorine-containing allyl ether polymer having glycidyl group)

Into a 30 ml four-necked glass flask equipped with a stirrer and thermometer were poured a solution of 5.0 g of fluorine-containing allyl ether having glycidyl group synthesized in Preparation Example 1 and 15 g of HFC-365 ($CF_3CH_2CF_2CH_3$), and then 3.8 g of perfluorohexane solution of 8.0 % by weight of:

$$[H(CF_2CF_2)_3COO]_2$$

and after sufficiently replacing the inside of the flask with nitrogen gas, stirring was continued at 20°C in a stream of nitrogen gas for 24 hours and a solution having a high viscosity was obtained.

To the obtained solution was poured a sodium bicarbonate solution for neutralization, followed by dissolving in diethylether. The resultant solution was poured into a separating funnel, followed by washing with water and saturated brine. The organic layer was dried with anhydrous magnesium sulfate, and magnesium sulfate was separated by filtering. The solution was concentrated and poured into a hexane solution for re-precipitation, and the solution was separated to obtain 3.6 g of colorless transparent polymer.

According to $^1$H-NMR, $^{19}$F-NMR and IR analyses, the polymer was a fluorine-containing polymer which consisted of the structural unit of the above-mentioned fluorine-containing allyl ether (m1) having glycidyl group and had the glycidyl group at an end of its side chain. Also according to GPC analysis using tetrahydrofuran (THF) as a solvent, a number average molecular weight of the polymer was 6,000, and a weight average molecular weight thereof was 10,000.

PREPARATION EXAMPLE 5

(Synthesis of fluorine-containing allyl ether having glycidyl group: short chain)

Into a 200 ml four-necked glass flask equipped with a stirrer and thermometer were poured 40 g of perfluoro-(1,1,6,6-tetrahydro-2-trifluoromethyl-3-oxahexanol), 0.4 ml of water and 38 g of epichlorohydrin, followed by heating to 60°C. To the solution was added 7.3 g of NaOH in five lots with a pellet and the reaction solution was heated to 70°C and reaction was carried out for four hours.

After completion of the reaction, hydrochloric acid was poured into the solution for neutralization and then the solution was poured into a separating funnel, followed by washing with water and saturated brine, drying with anhydrous magnesium sulfate and separating the solution by filtering. The solvent was distilled off from the filtrate by an evaporator. As a result of distillation of the reaction solution, 9.7 g of distillate was obtained. A boiling point thereof was 55° to 57°C (2.0 mmHg).

According to $^1$H-NMR, $^{19}$F-NMR and IR analyses, the obtained product was found to be a fluorine-containing allyl ether of the following structure having glycidyl group.

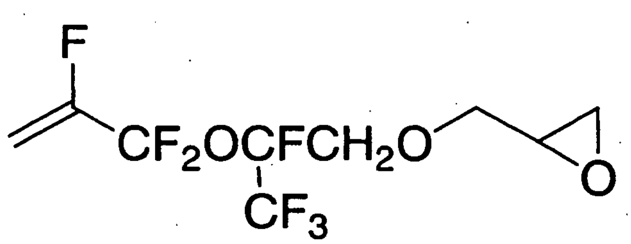

$^1$H-NMR analysis data (in δ(ppm) $CDCl_3$):

5.15 - 4.90 (2H, m), 4.05 - 3.82 (2H, m), 3.82 - 3.70 (1H, m), 3.38 - 3.25 (1H, m), 2.98 - 2.92 (1H, m), 2.68 - 2.57 (1H, m), 2.45 - 2.38 (1H, m)

$^{19}$F-NMR analysis data (in δ(ppm) $CDCl_3$, R-11 internal standard):

-75.4 - -72.8 (2F, m), -83.2 (3F, s), -123.3 - -122.8 (1F, m), -133.5 - -133.0 (1F, m)

IR analysis data ($cm^{-1}$)

1695 (νC=C)

PREPARATION EXAMPLE 6

(Synthesis of fluorine-containing allyl ether polymer having glycidyl group: short chain)

In a 10 ml four-necked glass flask equipped with a stirrer and thermometer, 4.7 g of perfluorohexane solution of 8.0 % by weight of:

$$\left[ H\left(CF_2CF_2\right)_3COO \right]_2$$

was poured into a solution of 4.0 g of fluorine-containing allyl ether having glycidyl group synthesized in Preparation Example 1 and 4 g of HFC-365 ($CF_3CH_2CF_2CH_3$), and after sufficiently replacing the inside of the flask with nitrogen gas, stirring was continued at 20°C in a stream of nitrogen gas for nine hours and a solution having a high viscosity was obtained.

To the obtained solution was poured a sodium bicarbonate solution for neutralization, followed by dissolving in diethylether. The resultant solution was poured into a separating funnel, followed by washing with water and saturated brine. The organic layer was dried with anhydrous magnesium sulfate, and magnesium sulfate was separated by filtering. The solution was concentrated and poured into a hexane solution for re-precipitation, and the solution was separated to obtain 1.2 g of colorless transparent polymer.

According to $^1$H-NMR, $^{19}$F-NMR and IR analyses, the polymer was a fluorine-containing polymer which consisted of the structural unit of the above-mentioned fluorine-containing allyl ether having glycidyl group and had the glycidyl group at an end of its side chain. Also according to GPC analysis using tetrahydrofuran (THF) as a solvent, a number average molecular weight of the polymer was 2,300, and a weight average molecular weight thereof was 3,000.

EXAMPLE 15

(Synthesis 1 of fluorine-containing allyl ether polymer having alicyclic epoxy (cyclohexyl) group)

In a 50 ml four-necked glass flask equipped with a stirrer and thermometer, 5 g of polymer obtained by polymerizing perfluoro-(1,1,9,9-tetrahydro-2,5-bistrifluoromethyl-3,6-dioxanonenol) was dissolved in 13 g of propyl acetate, followed by replacing the inside of the flask with nitrogen gas. To the obtained solution was added 1.2 ml of pyridine, followed by cooling of a reactor in ice bath. To the resultant solution was slowly added, through a dropping funnel, a mixture solution of 1.93 g of 3-cyclohexenic acid chloride and 3 g of propyl acetate. After completion of the addition, 6.5-hour reaction was carried out. After completion of the reaction, the reaction solution was poured into a saturated sodium bicarbonate solution, followed by washing with saturated sodium bicarbonate solution two times, with 1N hydrochloric acid two times and with saturated brine two times. The organic layer was dried with anhydrous magnesium sulfate, and magnesium sulfate was separated by filtering. As a result, 40.6 g of solution of 12.7 % by weight of polymer was obtained.

According to $^1$H-NMR and $^{19}$F-NMR analyses, the polymer was a fluorine-containing polymer which consisted of the structural unit of the fluorine-containing allyl ether and had the cyclohexenyl group at an end of its side chain in an amount of 70 %.

In a 50 ml four-necked glass flask equipped with a stirrer and thermometer was poured 11.7 g of propyl acetate solution of the obtained polymer (12.7 % by weight). To the obtained solution was slowly added 1.07 g of m-chloroperbenzoic acid (mCPBA), followed by reaction as it is at room temperature for 23 hours. After completion of the reaction, the reaction solution was poured into 1N aqueous solution of potassium hydroxide, followed by washing with 1N aqueous solution of potassium hydroxide two times and with saturated brine two times. The organic layer was dried with anhydrous magnesium sulfate, and magnesium sulfate was separated by filtering. As a result, 11.5 g of solution of 7.5 % by weight of polymer was obtained.

According to $^1$H-NMR and $^{19}$F-NMR analyses, the polymer was a fluorine-containing polymer which consisted of the structural unit of the fluorine-containing allyl ether and had functional group, in which 99.5 % of the cyclohexenyl group introduced to an end of its side chain in an amount of 70 % had been subjected to epoxidation.

EXAMPLE 16

(Synthesis of fluorine-containing allyl ether polymer having alicyclic epoxy (norbornene) group)

In a 50 ml four-necked glass flask equipped with a stirrer and thermometer, 5 g of polymer obtained by polymerizing perfluoro-(1,1,9,9-tetrahydro-2,5-bistrifluoromethyl-3,6-dioxanonenol) was dissolved in 15 g of propyl acetate, followed by replacing the inside of the flask with nitrogen gas. To the obtained solution was added 1.2 ml of pyridine, followed by cooling of a reactor in ice bath. To the resultant solution was slowly added, through a dropping funnel, a mixture solution of 5 g of propyl acetate and 2.1 g of 2-fluorobicyclo[2.2.1]hepta-5-en-2-carboxylic acid fluoride synthesized using dicyclopentadiene and α-fluoroacryloyl fluoride. After completion of the addition, 3-hour reaction was carried out. After completion of the reaction, the reaction solution was poured into a saturated sodium bicarbonate solution, followed by washing with saturated sodium bicarbonate solution two times, with 1N hydrochloric acid two times and with saturated brine two times. The organic layer was dried with anhydrous magnesium sulfate, and magnesium sulfate was separated by filtering. As a result, 32.6 g of solution of 16.7 % by weight of polymer was obtained.

According to $^{1}H$-NMR and $^{19}F$-NMR analyses, the polymer was a fluorine-containing polymer which consisted of the structural unit of the fluorine-containing allyl ether and had the cyclohexenyl group at an end of its side chain in an amount of 70 %.

Into a 50 ml four-necked glass flask equipped with a stirrer and thermometer was poured 9.0 g of propyl acetate solution of the obtained polymer (16.7 % by weight). To the obtained solution was slowly added mCPBA (1.35 g), followed by reaction as it was at room temperature for 23 hours. After completion of the reaction, the reaction solution was poured into a 1N aqueous solution of potassium hydroxide, followed by washing with 1N aqueous solution of potassium hydroxide two times and with saturated brine two times. The organic layer was dried with anhydrous magnesium sulfate, and magnesium sulfate was separated by filtering. As a result, 21.2 g of solution of 4.6 % by weight of polymer was obtained.

According to $^{1}H$-NMR and $^{19}F$-NMR analyses, the polymer was a fluorine-containing polymer which consisted of the structural unit of the fluorine-containing allyl ether and had functional group, in which 99 % of the 2-fluoro-bicyclo [2.2.1]hepta-5-en-carboxylic acid ester group introduced to an end of its side chain in an amount of 70 % had been subjected to epoxidation.

PREPARATION EXAMPLE 7

(Synthesis of fluorine-containing allyl ether monomer precursor having alicyclic epoxy (cyclohexyl) group)

The inside of a 500 ml four-necked glass flask equipped with a stirrer and thermometer was sufficiently replaced with nitrogen and in the flask, 7.6 g of NaH was suspended in 180 ml of THF. To the solution was added dropwise 71 g of perfluoro-(1,1,9,9-tetrahydro-2,5-bistrifluoromethyl-3,6-dioxanonenol) through a dropping funnel. After completion of the addition, 2-hour stirring was carried out at room temperature. Then to the resultant solution was added 33.4 g of 3-bromocyclohexene through the dropping funnel, followed by reaction for 24 hours.

After completion of the reaction, the solution was poured into water, followed by washing with water and saturated brine, drying with anhydrous magnesium sulfate and separating the solution by filtering. The solvent was distilled off from the filtrate by an evaporator. As a result of distilling of the reaction solution, 75 g of distillate was obtained. A boiling point thereof was 61° to 64°C (0.25 mmHg).

According to $^{1}H$-NMR, $^{19}F$-NMR and IR analyses, the obtained product was found to be a fluorine-containing allyl ether of the following structure having glycidyl group.

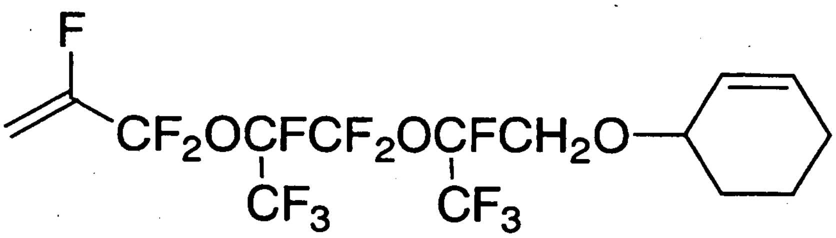

$^{1}H$-NMR analysis data (in δ(ppm) $CDCl_3$):

5.91 - 5.62 (2H, m), 5.12-5.03 (2H, m), 4.01-3.85 (3H, m), 2.10 - 1.41 (4H, m)

$^{19}F$-NMR analysis data (in δ(ppm) $CDCl_3$, R-11 internal standard):

-72.4 - -73.0 (2F, m), -79.4 - -81.7 (8F, m), -124.0 - -124.1 (1F, m), -133.4 - -133.9 (1F, m), -145.0 - -145.7 (1F, m)

IR analysis data ($cm^{-1}$)

1695 (υC=C)

EXAMPLE 17

In a 500 ml four-necked glass flask equipped with a stirrer and thermometer, 15.0 g of 30 % hydrogen peroxide solution was added to 1.1 g of sodium tungstate·dihydrate to make a yellow solution. To this solution was added 80 % phosphoric acid to adjust its pH value to about 2. Further to the obtained solution was added dropwise through a dropping funnel a solution obtained by diluting 32 g of monomer having cyclohexenyl group prepared in Preparation Example 7 and 1.1 g of trioctylmethylammonium chloride in 90 ml of toluene. After completion of the addition, 10-hour stirring was carried out at 50°C.

After completion of the reaction, the toluene layer of the solution was washed with sodium thiosulfate solution, saturated sodium bicarbonate solution and water, followed by drying with anhydrous magnesium sulfate and separation of the solution by filtering. The solvent was distilled off from the filtrate by an evaporator. As a result of distilling of the reaction solution, 30.4 g of distillate was obtained. A boiling point thereof was 79° to 83°C (0.25 mmHg).

According to $^{1}H$-NMR, $^{19}F$-NMR and IR analyses, the obtained product was found to be a fluorine-containing allyl ether of the following structure having alicyclic epoxy group.

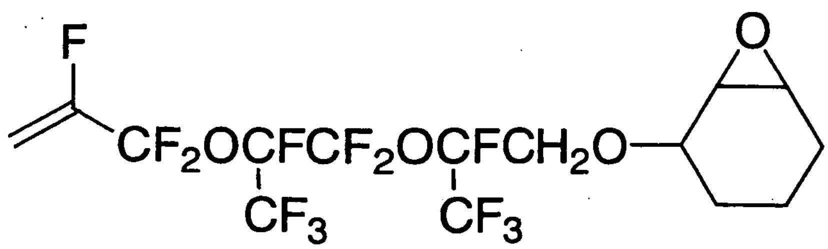

$^{1}H$-NMR analysis data (in δ(ppm) $CDCl_3$):

5.12 - 5.03 (2H, m), 4.10 - 3.95 (2H, m), 3.74 - 3.64 (1H, m), 3.19 - 3.13 (1H, m), 3.04 - 2.98 (1H, m), 2.00 - 1.05 (6H, m)

$^{19}F$-NMR analysis data (in δ(ppm) $CDCl_3$, R-11 internal standard):

-72.4 - -73.0 (2F, m), -79.4 - -81.7 (8F, m), -124.0 - -124.

IR analysis data ($cm^{-1}$)

1695 (υC=C)

EXAMPLE 18

(Synthesis of fluorine-containing allyl ether polymer having alicyclic epoxy (cyclohexyl) group)

In a 50 ml four-necked glass flask equipped with a stirrer and thermometer, 3.4 g of perfluorohexane solution of 8.0 % by weight of:

$$\left[ H \left( CF_2CF_2 \right)_3 COO \right]_2$$

was poured into a solution of 5.0 g of a fluorine-containing allyl ether having a 7-oxa-bicyclo[4.1.0]heptanyl group prepared in Example 17 and 5.0 g of HFC-365 ($CF_3CH_2CF_2CH_3$), and after sufficiently replacing the inside of the flask with nitrogen gas, stirring was continued at 20˚C for 10 hours in a stream of nitrogen gas and a solution having a high viscosity was obtained.

To the obtained solution was poured a sodium bicarbonate solution for neutralization, followed by dissolving in diethylether. The resultant solution was poured into a separating funnel, followed by washing with water and saturated brine. The organic layer was dried with anhydrous magnesium sulfate, and magnesium sulfate was separated by filtering. The resultant solution was concentrated and poured into a hexane solution for re-precipitation, and the solution was separated to obtain 2.9 g of colorless transparent polymer.

According to $^1$H-NMR and $^{19}$F-NMR analyses, the polymer was a fluorine-containing polymer which consisted of the structural unit of the fluorine-containing allyl ether and had 7-oxabicyclo[4.1.0]heptanyl group at an end of its side chain. Also according to GPC analysis using tetrahydrofuran (THF) as a solvent, a number average molecular weight of the polymer was 7,500, and a weight average molecular weight thereof was 24,000.

EXAMPLES 19 and 20

(Antireflection film)

(1) Preparation of materials for an antireflection film was carried out in the same manner as in Example 4 except that the fluorine-containing polymers having epoxy group prepared in Preparation Examples 4 and 6, respectively were used instead of the fluorine-containing polymer having glycidyl group prepared in Preparation Examples 2. By using the obtained materials, (2) Production of antireflection films, (3) Measurement of refractive index of curable fluorine-containing polymers, (4) Measurement of refractive index of cured films, (5) Measurement of reflectance on one side of films and (6) Evaluation of physical properties (excluding shrinkage of volume and transparency) of antireflection films were carried out. The results are shown in Table 4.

EXAMPLES 21 to 23

(Antireflection film)

(1) Preparation of materials for an antireflection film was carried out in the same manner as in Example 4 except that the fluorine-containing polymers having epoxy group prepared in Examples 15, 16 and 18, respectively were used instead of the fluorine-containing polymer having glycidyl group prepared in Preparation Example 2. By using the obtained materials, (2) Production of antireflection films, (3) Measurement of refractive index of curable fluorine-containing polymers, (4) Measurement of refractive index of cured films, (5) Measurement of reflectance on one side of films and (6) Evaluation of physical properties (excluding shrinkage of volume and transparency) of antireflection films were carried out. The results are shown in Table 4.

TABLE 4

| | Example | | | | |
|---|---|---|---|---|---|
| | 19 | 20 | 21 | 22 | 23 |
| Substrate | Acryl | Acryl | Acryl | Acryl | Acryl |
| Fluorine-containing crosslinkable polymer | Prep. Ex. 4 | Prep. Ex. 6 | Ex. 15 | Ex. 16 | Ex. 18 |
| Kind of crosslinkable cyclic ether | Glycidyl | Glycidyl | Cyclohexyl | Norbornene | Cyclohexyl |
| Content of crosslinkable cyclic ether (% by mole) | 100 | 100 | 70 | 70 | 100 |
| Photoacid generator | | | | | |
| Kind | MPI-103 | MPI-103 | MPI-103 | MPI-103 | MPI-103 |
| Adding amount (% by weight based on polymer) | 5 | 5 | 5 | 5 | 5 |

(continued)

| | Example | | | | |
|---|---|---|---|---|---|
| | 19 | 20 | 21 | 22 | 23 |
| Amount of ultraviolet light ($mJ/cm^2$) | 1500 | 1500 | 1500 | 1500 | 1500 |
| Refractive index | | | | | |
| Before curing | 1.373 | 1.3847 | 1.396 | 1.398 | 1.386 |
| After curing | 1.383 | 1.4016 | 1.407 | 1.408 | 1.398 |
| Reflectance on one side of film (%) | 1.35 | 1.67 | 1.80 | 1.80 | 1.65 |
| Coatability | ○ | ○ | ○ | ○ | ○ |
| Pencil hardness | HB | HB | HB | HB | F |
| Solvent resistance | Δ | Δ | Δ | Δ | Δ |
| Alkali resistance | ○ | ○ | Δ | Δ | ○ |

EXAMPLES 24 to 27

(Antireflection film)

To the materials for an antireflection film obtained in (1) of Examples 19 to 22 was added, as a crosslinking agent, a bi-functional epoxy compound (crosslinking agent 1) represented by the formula:

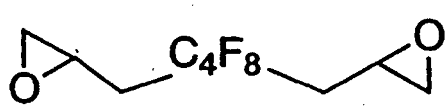

in an amount of 0.3 equivalent to the polymer. By using the respective materials for an antireflection film, antireflection films were produced in the same manner as in (2) of Example 15, and (3) Measurement of refractive index before curing, (4) Measurement of refractive index of cured films, (5) Measurement of reflectance on one side of films and (6) Evaluation of physical properties (excluding shrinkage of volume and transparency) of antireflection films were carried out. The results are shown in Table 5.

TABLE 5

| | Example | | | |
|---|---|---|---|---|
| | 24 | 25 | 26 | 27 |
| Substrate | Acryl | Acryl | Acryl | Acryl |
| Fluorine-containing crosslinkable polymer | Prep. Ex. 6 | Ex. 15 | Ex. 16 | Ex. 18 |
| Kind of crosslinkable cyclic ether | Glycidyl | Cyclohexyl | Norbornene | Cyclohexyl |
| Content of crosslinkable cyclic ether (% by mole) | 100 | 70 | 70 | 100 |
| Crosslinking agent | | | | |
| Kind | Crosslinking agent 1 | Crosslinking agent 1 | Crosslinking agent 1 | Crosslinking agent 1 |
| Adding amount (equivalent to polymer) | 0.3 | 0.3 | 0.3 | 0.3 |
| Photoacid generator | | | | |

(continued)

| | Example | | | |
|---|---|---|---|---|
| | 24 | 25 | 26 | 27 |
| Kind | MPI-103 | MPI-103 | MPI-103 | MPI-103 |
| Adding amount (% by weight based on polymer) | 5 | 5 | 5 | 5 |
| Amount of ultraviolet light ($mJ/cm^2$) | 1500 | 1500 | 1500 | 1500 |
| Refractive index (after curing) | 1.389 | 1.406 | 1.407 | 1.400 |
| Reflectance on one side of film (%) | 1.40 | 1.90 | 1.85 | 1.65 |
| Coatability | ○ | ○ | ○ | ○ |
| Pencil hardness | F | H | H | 2H |
| Solvent resistance | Δ | ○ | ○ | ○ |
| Alkali resistance | ○ | ○ | ○ | ○ |

EXAMPLES 28 to 31

(Antireflection film)

To the materials for an antireflection film obtained in (1) of Examples 20 to 23 was added, as a crosslinking agent, a bi-functional oxetane crosslinking agent 2 synthesized in Example 9 in an amount of 0.3 equivalent to the polymer. By using the respective materials for an antireflection film, antireflection films were produced in the same manner as in (2) of Example, and (3) Measurement of refractive index before curing, (4) Measurement of refractive index of cured films, (5) Measurement of reflectance on one side of films and (6) Evaluation of physical properties (excluding shrinkage of volume and transparency) of antireflection films were carried out. The results are shown in Table 6.

TABLE 6

| | Example | | | |
|---|---|---|---|---|
| | 28 | 29 | 30 | 31 |
| Substrate | Acryl | Acryl | Acryl | Acryl |
| Fluorine-containing crosslinkable polymer | Prep. Ex. 6 | Ex. 15 | Ex. 16 | Ex. 18 |
| Kind of crosslinkable cyclic ether | Glycidyl | Cyclohexyl | Norbornene | Cyclohexyl |
| Content of crosslinkable cyclic ether (% by mole) | 100 | 70 | 70 | 100 |
| Crosslinking agent | | | | |
| Kind | Crosslinking agent 2 | Crosslinking agent 2 | Crosslinking agent 2 | Crosslinking agent 2 |
| Adding amount (equivalent to polymer) | 0.3 | 0.3 | 0.3 | 0.3 |
| Photoacid generator | | | | |
| Kind | MPI-103 | MPI-103 | MPI-103 | MPI-103 |

(continued)

| | Example | | | |
|---|---|---|---|---|
| | 28 | 29 | 30 | 31 |
| Adding amount (% by weight based on polymer) | 5 | 5 | 5 | 5 |
| Amount of ultraviolet light (mJ/cm$^2$) | 1500 | 1500 | 1500 | 1500 |
| Refractive index (after curing) | 1.384 | 1.403 | 1.408 | 1.399 |
| Reflectance on one side of film (%) | 1.4 | 1.9 | 1.85 | 1.65 |
| Coatability | ○ | ○ | ○ | ○ |
| Pencil hardness | F | H | H | H |
| Solvent resistance | Δ | ○ | ○ | ○ |
| Alkali resistance | ○ | ○ | ○ | ○ |

EXAMPLE 32

(Production of optical waveguide device)

An optical waveguide was produced using the material for an optical waveguide produced in Example 14 as a material for core portion and the fluorine-containing polymer synthesized in Preparation Example 3 as a material for clad portion.

Those two kinds of materials were dissolved in methyl isobutyl ketone to make respective solutions. First, the material for clad portion was applied on a plastic substrate or a silicon substrate in a thickness of about 15 μm. After baking and drying treatment, the material for core portion was applied on the film of material for clad portion in a thickness of about 8 μm. Next, irradiation of light was carried out through a photo-mask to cure the film of a core portion. Then the un-cured portion of core film was washed out with a solvent, and the core portion was fabricated into a linear rectangular pattern of 50 mm long × 8 μm wide × 8 μm high. After the fabrication, the clad portion was applied on the core portion as explained according to Fig. 2 to obtain an optical waveguide.

Next, a transmission loss of the produced optical waveguide was measured by passing light having a wavelength of 1,300 nm through the core portion. As a result, the loss was 0.4 dB/cm.

Further the produced optical waveguide was allowed to stand at a temperature of 80°C and a humidity of 85 % RH, and the transmission loss was not decreased at all.

EXAMPLE 33

(Sealing member (filling material) for lens for deep ultraviolet)

The solvent was distilled off at 40°C under reduced pressure from the material for an antireflection film prepared in Example 4, and the resultant material was used as a sealing member. As shown in Fig. 3, a lens member $L_1$ of quartz glass and a lens member $L_2$ of quartz glass were used as lens members. The sealing member 8 was put between the lens member $L_1$ and the lens member $L_2$, followed by pressing while heating to 40°C so that a thickness of the sealing member became 1 μm. Then ultraviolet light was irradiated at room temperature vertically to the lens surface in the direction shown by an arrow at an irradiation intensity of 1,500 mJ/cm$^2$ using a high pressure mercury lamp, thus photo-curing the sealing member.

Next, transparency to deep ultraviolet light of the optical member, in which a connected portion between the lenses was sealed with the sealing member, was determined by passing light having a wavelength of 300 nm vertically to the lens surface and measuring transmittance with a self-recording spectrophotometer (U-3310 available from Hitachi, Ltd.). As a result, the transmittance was 92 %.

Further the produced optical member was subjected to 10 J ultraviolet irradiation at room temperature using a high pressure mercury lamp. As a result, transmittance of light of 300 nm was not decreased at all, and there was neither deformation nor cracking.

EXAMPLE 34

(Sealing material)

The solvent was distilled off at 40°C under reduced pressure from the material for an antireflection film prepared in Example 4, and the resultant material was used as a sealing member. As shown in Fig. 4, an organic electroluminescent device 10 was formed on a transparent glass substrate 9, and a light emitting surface thereof was faced to the glass substrate. A metallic can 11 for sealing was in the concave form and matching with the size of body of the organic electroluminescent device. In a globe box, in which nitrogen gas is circulated, the sealing member 12 of the present invention was put on an adhering portion between the glass substrate 9 having the organic electroluminescent device thereon and the metallic can 11, followed by pressing so that a thickness of the sealing member became 100 μm. Then the sealing member was cured under nitrogen gas atmosphere by irradiating UV at 2,000 mJ/cm$^2$ in the direction vertical to the surface of the transparent glass substrate.

The so-sealed organic electroluminescent device was subjected to acceleration test under the conditions of a temperature of 60°C and a humidity of 95 % RH. As a result of 500-hour test, a ratio of non-light-emitting area was not more than 10 %.

INDUSTRIAL APPLICABILITY

There can be provided various optical materials and cured members obtained therefrom which are excellent in transparency in a near infrared region, resistance to moisture, and heat resistance, by using the curable fluorine-containing polymer having a crosslinkable cyclic ether structure. Those materials and members are suitable as materials for optical devices such as an optical waveguide and a sealing member and as materials for display devices such as an antireflection film.

**Claims**

**1.** A photo-curable fluorine-containing resin composition comprising:

(a) a curable fluorine-containing polymer (I) having a number average molecular weight of from 500 to 1,000,000 and represented by the formula (1):

$$-(M)-(A)- \qquad (1)$$

wherein the structural unit M is a structural unit derived from a fluorine-containing ethylenic monomer and represented by the formula (M):

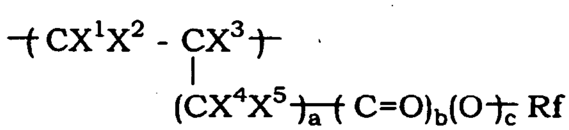

(M)

wherein $X^1$ and $X^2$ are the same or different and each is H or F; $X^3$ is H, F, $CH_3$ or $CF_3$; $X^4$ and $X^5$ are the same or different and each is H, F or $CF_3$; Rf is an organic group in which 1 to 3 $Y^1$ ($Y^1$ is a monovalent organic group which has 2 to 100 carbon atoms and 1 to 5 crosslinkable cyclic ether structures in which hydrogen atoms may be substituted with fluorine atoms) are bonded to a fluorine-containing alkyl group having 1 to 40 carbon atoms or a fluorine-containing alkyl group having 2 to 100 carbon atoms and ether bond; a is 0 or an integer of from 1 to 3; b and c are the same or different and each is 0 or 1,
the structural unit A is a structural unit derived from a monomer copolymerizable with the fluorine-containing ethylenic monomer for the structural unit represented by said formula (M),
said structural unit M and said structural unit A being contained in amounts of from 0.1 to 100 % by mole and from 0 to 99.9 % by mole, respectively, and
(b) a photoacid generator (II).

2. The composition of Claim 1, wherein the curable fluorine-containing polymer (I) is the fluorine-containing polymer of the formula (1), in which the structural unit M is a structural unit M 1 derived from a fluorine-containing ethylenic monomer and represented by the formula (M1):

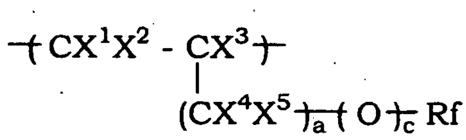

(M1)

wherein $X^1$ and $X^2$ are the same or different and each is H or F; $X^3$ is H, F, $CH_3$ or $CF_3$; $X^4$ and $X^5$ are the same or different and each is H, F or $CF_3$; Rf is an organic group in which 1 to 3 $Y^1$ ($Y^1$ is a monovalent organic group which has 2 to 100 carbon atoms and 1 to 5 crosslinkable cyclic ether structures in which hydrogen atoms may be substituted with fluorine atoms) are bonded to a fluorine-containing alkyl group having 1 to 40 carbon atoms or a fluorine-containing alkyl group having 2 to 100 carbon atoms and ether bond; a is 0 or an integer of from 1 to 3; c is 0 or 1.

3. The composition of Claim 1, wherein the fluorine-containing polymer (I) is the fluorine-containing polymer of the formula (1), in which the structural unit M is a structural unit M2 derived from a fluorine-containing ethylenic monomer and represented by the formula (M2):

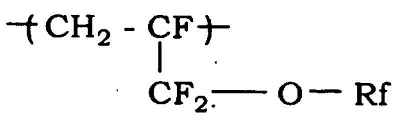

(M2)

wherein Rf is an organic group in which 1 to 3 $Y^1$ ($Y^1$ is a monovalent organic group which has 2 to 100 carbon atoms and 1 to 5 crosslinkable cyclic ether structures in which hydrogen atoms may be substituted with fluorine atoms) are bonded to a fluorine-containing alkyl group having 1 to 40 carbon atoms or a fluorine-containing alkyl group having 2 to 100 carbon atoms and ether bond.

4. The composition of Claim 1, wherein the fluorine-containing polymer (I) is the fluorine-containing polymer of the formula (1), in which the structural unit M is a structural unit M3 derived from a fluorine-containing ethylenic monomer and represented by the formula (M3):

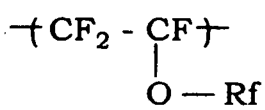

(M3)

wherein Rf is an organic group in which 1 to 3 $Y^1$ ($Y^1$ is a monovalent organic group which has 2 to 100 carbon atoms and 1 to 5 crosslinkable cyclic ether structures in which hydrogen atoms may be substituted with fluorine atoms) are bonded to a fluorine-containing alkyl group having 1 to 40 carbon atoms or a fluorine-containing alkyl group having 2 to 100 carbon atoms and ether bond.

5. The composition of any of Claims 1 to 4, wherein at least one of $Y^1$ in Rf in said formulae (M), (M1), (M2) and (M3) is bonded to an end of Rf.

6. The composition of any of Claims 1 to 4, wherein $Y^1$ in Rf in said formulae (M), (M1), (M2) and (M3) is a monovalent organic group which has 2 to 100 carbon atoms and 1 to 5 crosslinkable cyclic ether structures of 3- to 6-membered ring having at least one ether bond, in which hydrogen atom of the cyclic ether structure may be substituted with fluorine atom.

7. The composition of any of Claims 1 to 4, wherein $Y^1$ in Rf in said formulae (M), (M1), (M2) and (M3) is an organic

group having 2 to 100 carbon atoms and 1 to 5 oxirane structures which are crosslinkable cyclic ether structures of 3-membered ring and are represented by:

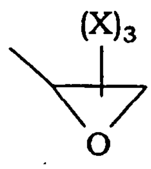 or 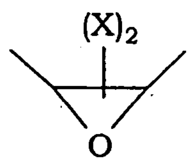

wherein X are the same or different and each is a hydrogen atom, a fluorine atom, an alkyl group having 1 to 6 carbon atoms or a fluorine-containing alkyl group having 1 to 6 carbon atoms, or
an organic group having 3 to 100 carbon atoms and 1 to 5 structures represented by:

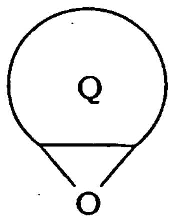

wherein Q is a monovalent or divalent organic group of monocyclic, polycyclic or heterocyclic structure having 3 to 100 carbon atoms, in which hydrogen atom of Q may be substituted with said X.

**8.** The composition of any of Claims 1 to 4, wherein $Y^1$ in Rf in said formulae (M), (M1), (M2) and (M3) is an organic group which has 6 to 100 carbon atoms and 1 to 5 structures represented by:

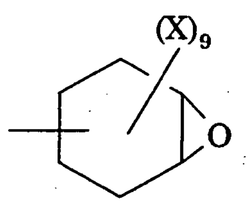

wherein X is as defined above, or
an organic group which has 7 to 100 carbon atoms and 1 to 5 structures represented by:

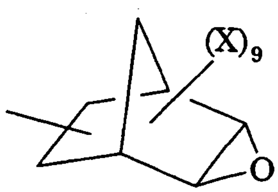

wherein X is as defined above.

**9.** The composition of any of Claims 1 to 4, wherein $Y^1$ in Rf in said formulae (M), (M1), (M2) and (M3) is an organic group which has 3 to 100 carbon atoms and 1 to 5 oxetane structures represented by:

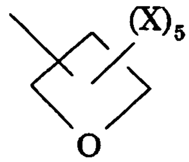

or

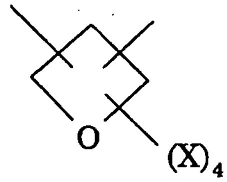

wherein X are the same or different and each is hydrogen atom, fluorine atom, an alkyl group having 1 to 6 carbon atoms or a fluorine-containing alkyl group having 1 to 6 carbon atoms.

**10.** The composition of any of Claims 1 to 9, wherein a fluorine content of the curable fluorine-containing polymer (I) is not less than 40 % by weight.

**11.** The composition of any of Claims 1 to 10, wherein the photoacid generator (II) is at least one aromatic compound selected from the group consisting of aromatic diazonium salts, aromatic sulfonium salts, aromatic iodonium salts and metallocene compounds.

**12.** The composition of any of Claims 1 to 11, wherein the photoacid generator (II) is at least one aromatic compound selected from the group consisting of aromatic diazonium salts, aromatic sulfonium salts, aromatic iodonium salts and metallocene compounds, in which 1 to 4 organic groups R are bonded to the aromatic ring, wherein R are the same or different and each is hydroxyl group, thioalkyl group, thiophenoxy group or an alkyl group having 1 to 10 carbon atoms which may have ether bond.

**13.** The composition of any of Claims 1 to 12, wherein the photoacid generator (II) is a compound having fluorine atom.

**14.** A cured article obtained by curing the composition of any of Claims 1 to 13.

**15.** A cured article obtained by photo-curing the composition of any of Claims 1 to 13.

**16.** An optical material for optical devices which comprises the curable fluorine-containing polymer (I) of any of Claims 1 to 10.

**17.** An optical material for optical devices which comprises the photo-curable fluorine-containing resin composition of any of Claims 1 to 13.

**18.** An optical member for optical devices which is obtained from a cured article made by curing the optical material for optical devices of Claim 16 or 17.

**19.** A material for optical waveguide which is obtained from the optical material for optical devices of Claim 16 or 17.

**20.** A member for optical waveguide which is obtained from a cured article made by curing the material for optical waveguide of Claim 19.

**21.** A material for a sealing member for optical devices which is obtained from the optical material for optical devices of Claim 16 or 17.

**22.** An optical device having a sealing member which is obtained from a cured article made by curing the material for a sealing member of Claim 21.

**23.** An optical material for display devices which comprises the curable fluorine-containing polymer (I) of any of Claims 1 to 10.

**24.** An optical material for display devices which comprises the photo-curable fluorine-containing resin composition of any of Claims 1 to 13.

**25.** An optical member for display devices which is obtained from a cured article made by curing the optical material

for display devices of Claim 23 or 24.

**26.** A material for an antireflection film which comprises the optical material for display devices of Claim 23 or 24.

**27.** An antireflection film obtained by curing the material for an antireflection film of Claim 26.

**28.** A fluorine-containing polymer having crosslinkable group which has a number average molecular weight of from 500 to 1,000,000 and is represented by the formula (2):

-(M4)-(B)- (2)

wherein the structural unit M4 is a structural unit derived from a fluorine-containing ethylenic monomer and represented by the formula (M4):

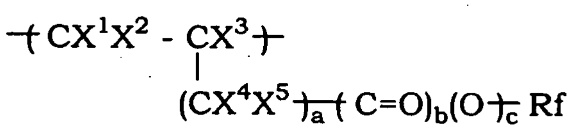

(M4)

wherein $X^1$ and $X^2$ are the same or different and each is H or F; $X^3$ is H, F, $CH_3$ or $CF_3$; $X^4$ and $X^5$ are the same or different and each is H, F or $CF_3$; Rf is an organic group in which 1 to 3 $Y^2$ ($Y^2$ is an organic group having 2 to 100 carbon atoms and 1 to 5 crosslinkable cyclic ether structures of:

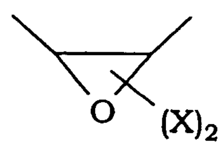

wherein X are the same or different and each is hydrogen atom, fluorine atom, an alkyl group having 1 to 6 carbon atoms or a fluorine-containing alkyl group having 1 to 6 carbon atoms, or
an organic group having 3 to 100 carbon atoms and 1 to 5 structures represented by the formula:

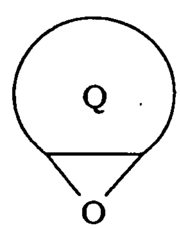

wherein Q is a monovalent or divalent organic group of monocyclic, polycyclic or heterocyclic structure having 3 to 100 carbon atoms in which hydrogen atom of Q may be substituted with said X) are bonded to a fluorine-containing alkyl group having 1 to 40 carbon atoms or a fluorine-containing alkyl group having 2 to 100 carbon atoms and ether bond; a is 0 or an integer of from 1 to 3; b and c are the same or different and each is 0 or 1,
the structural unit B is a structural unit derived from a monomer copolymerizable with the fluorine-containing ethylenic monomer for the structural unit of said formula (M4),
said structural unit M4 and said structural unit B being contained in amounts of from 0.1 to 100 % by mole and from 0 to 99.9 % by mole, respectively.

**29.** A fluorine-containing polymer having crosslinkable group which has a number average molecular weight of from 500 to 1,000,000 and is represented by the formula (2-1):

- (M4) - (B) - (2-1)

wherein the structural unit M4 is a structural unit derived from a fluorine-containing ethylenic monomer and represented by the formula (M4-1):

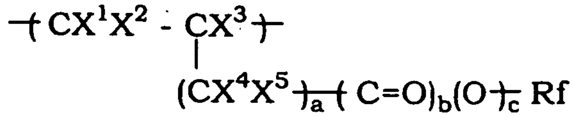

(M4-1)

wherein $X^1$ and $X^2$ are the same or different and each is H or F; $X^3$ is H, F, $CH_3$ or $CF_3$; $X^4$ and $X^5$ are the same or different and each is H, F or $CF_3$; Rf is an organic group in which 1 to 3 $Y^{2a}$ ($Y^{2a}$ is an organic group having 3 to 100 carbon atoms and 1 to 5 crosslinkable cyclic ether structures of:

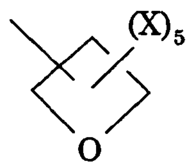

or

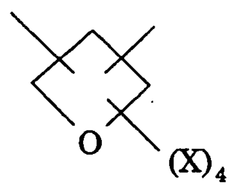

wherein X are the same or different and each is hydrogen atom, fluorine atom, an alkyl group having 1 to 6 carbon atoms or a fluorine-containing alkyl group having 1 to 6 carbon atoms) are bonded to a fluorine-containing alkyl group having 1 to 40 carbon atoms or a fluorine-containing alkyl group having 2 to 100 carbon atoms and ether bond; a is 0 or an integer of from 1 to 3; b and c are the same or different and each is 0 or 1,
the structural unit B is a structural unit derived from a monomer copolymerizable with the fluorine-containing ethylenic monomer for the structural unit of said formula (M4-1),
said structural unit M4 and said structural unit B being contained in amounts of from 0.1 to 100 % by mole and from 0 to 99.9 % by mole, respectively.

**30.** A fluorine-containing ethylenic monomer represented by the formula (3):

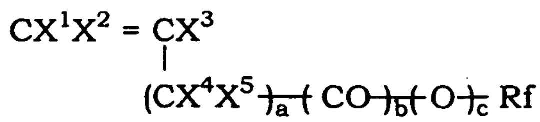

(3)

wherein $X^1$ and $X^2$ are the same or different and each is H or F; $X^3$ is H, F, $CH_3$ or $CF_3$; $X^4$ and $X^5$ are the same or different and each is H, F or $CF_3$; Rf is an organic group in which 1 to 3 $Y^2$ ($Y^2$ is an organic group having 2 to 100 carbon atoms and 1 to 5 crosslinkable cyclic ether structures of:

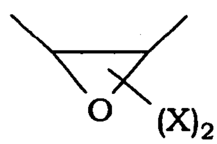

wherein X are the same or different and each is hydrogen atom, fluorine atom, an alkyl group having 1 to 6 carbon atoms or a fluorine-containing alkyl group having 1 to 6 carbon atoms, or
an organic group having 3 to 100 carbon atoms and 1 to 5 structures represented by the formula:

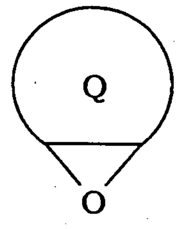

wherein Q is a monovalent or divalent organic group of monocyclic, polycyclic or heterocyclic structure having 3 to 100 carbon atoms in which hydrogen atom of Q may be substituted with said X) are bonded to a fluorine-containing alkyl group having 1 to 40 carbon atoms or a fluorine-containing alkyl group having 2 to 100 carbon atoms and ether bond; a is 0 or an integer of from 1 to 3; b and c are the same or different and each is 0 or 1

**31.** A fluorine-containing ethylenic monomer represented by the formula (3-1):

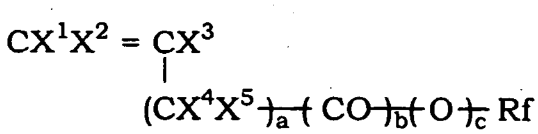

(3-1)

wherein $X^1$ and $X^2$ are the same or different and each is H or F; $X^3$ is H, F, $CH_3$ or $CF_3$; $X^4$ and $X^5$ are the same or different and each is H, F or $CF_3$; Rf is an organic group in which 1 to 3 $Y^{2a}$ ($Y^{2a}$ is an organic group having 2 to 100 carbon atoms and 1 to 5 crosslinkable cyclic ether structures of:

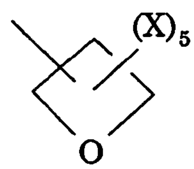

or

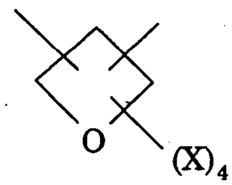

wherein X are the same or different and each is hydrogen atom, fluorine atom, an alkyl group having 1 to 6 carbon atoms or a fluorine-containing alkyl group having 1 to 6 carbon atoms) are bonded to a fluorine-containing alkyl group having 1 to 40 carbon atoms or a fluorine-containing alkyl group having 2 to 100 carbon atoms and ether bond; a is 0 or an integer of from 1 to 3; b and c are the same or different and each is 0 or 1.

**Patentansprüche**

**1.** Fotohärtbare, fluorhaltige Harzzusammensetzung, umfassend:

(a) ein härtbares, fluorhaltiges Polymer (I) mit einem mittleren Molekulargewicht von 500 bis 1.000.000, das durch die Formel (1) dargestellt wird:

$$-(M)-(A)- \qquad (1)$$

wobei die Struktureinheit M eine Struktureinheit darstellt, die von einem fluorhaltigen, ethylenischen Monomer abgeleitet ist und durch die Formel (M) dargestellt wird:

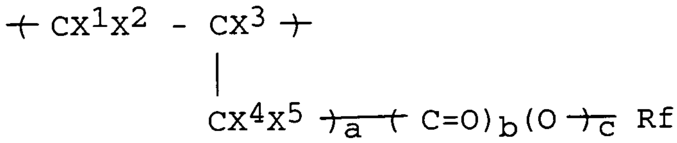

(M)

wobei $X^1$ und $X^2$ gleich oder verschieden sind und jedes H oder F sein kann; $X^3$ H, F, $CH_3$ oder $CF_3$ ist; $X^4$ und $X^5$ gleich oder verschieden sind und jedes H, F oder $CF_3$ sein kann; Rf eine organische Gruppe ist, in der 1 bis 3 $Y^1$ ($Y^1$ ist eine einwertige, organische Gruppe, die 2 bis 100 Kohlenstoffatome und 1 bis 5 vernetzbare, cyclische Etherstrukturen besitzt, in welchen Wasserstoffatome durch Fluoratome substituiert sein können) an eine fluorhaltige Alkylgruppe mit 1 bis 40 Kohlenstoffatomen oder eine fluorhaltige Alkylgruppe mit 2 bis 100 Kohlenstoffatomen sowie Etherbindung gebunden sind; a 0 oder eine ganze Zahl von 1 bis 3 ist; b und c gleich oder verschieden sind und jedes 0 oder 1 sein kann,

die Struktureinheit A eine Struktureinheit darstellt, die von einem Monomer abgeleitet ist, welches mit dem fluorhaltigen, ethylenischen Monomer zur Struktureinheit, die durch die Formel (M) dargestellt wird, copolymerisierbar ist,

die Struktureinheit M und die Struktureinheit A in Mengen von 0,1 bis 100 Mol% bzw. 0 bis 99,9 Mol% enthalten sind und

(b) ein Fotosäuregenerator (II).

**2.** Zusammensetzung gemäß Anspruch 1, worin das härtbare fluorhaltige Polymer (I) das fluorhaltige Polymer der Formel (1) ist, in der die Struktureinheit M die Struktureinheit M1 ist, die von einem fluorhaltigen, ethylenischen Monomer abgeleitet ist und durch die Formel (M1) dargestellt wird:

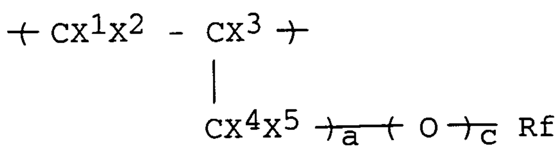

(M1)

wobei $X^1$ und $X^2$ gleich oder verschieden sind und jedes H oder F sein kann; $X^3$ H, F, $CH_3$ oder $CF_3$ ist; $X^4$ und $X^5$ gleich oder verschieden sind und jedes H, F oder $CF_3$ sein kann; Rf eine organische Gruppe ist, in der 1 bis 3 $Y^1$ ($Y^1$ ist eine einwertige organische Gruppe, die 2 bis 100 Kohlenstoffatome und 1 bis 5 vernetzbare, cyclische Etherstrukturen besitzt, in denen Wasserstoffatome durch Fluoratome substituiert sein können) an eine fluorhaltige Alkylgruppe mit 1 bis 40 Kohlenstoffatomen oder eine fluorhaltige Alkylgruppe mit 2 bis 100 Kohlenstoffatomen sowie Etherbindung gebunden sind; a 0 oder eine ganze Zahl von 1 bis 3 ist; c 0 oder 1 ist.

**3.** Zusammensetzung gemäß Anspruch 1, worin das fluorhaltige Polymer (I) das fluorhaltige Polymer der Formel (1) ist, in dem die Struktureinheit M eine Struktureinheit M2 ist, die von einem fluorhaltigen, ethylenischen Monomer abgeleitet ist und durch die Formel (M2) dargestellt wird:

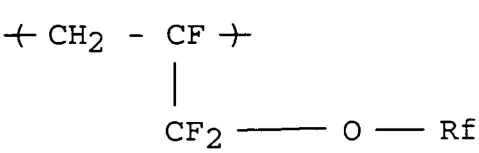

(M2)

worin Rf eine organische Gruppe ist, in der 1 bis 3 $Y^1$ ($Y^1$ ist eine einwertige, organische Gruppe, die 2 bis 100 Kohlenstoffatome und 1 bis 5 vernetzbare, cyclische Etherstrukturen besitzt, in denen Wasserstoffatome durch Fluoratome substituiert sein können) an eine fluorhaltige Alkylgruppe mit 1 bis 40 Kohlenstoffatomen oder eine fluorhaltige Alkylgruppe mit 2 bis 100 Kohlenstoffatomen sowie Etherbindung gebunden sind.

**4.** Zusammensetzung gemäß Anspruch 1, worin das fluorhaltige Polymer (I) das fluorhaltige Polymer der Formel (1) ist, in dem die Struktureinheit M eine Struktureinheit M3 ist, die von einem fluorhaltigen, ethylenischen Monomer

abgeleitet ist und durch die Formel (M3) dargestellt wird:

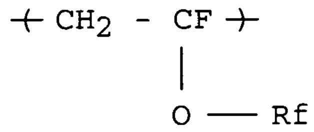 (M3)

wobei Rf eine organische Gruppe ist, in der 1 bis 3 $Y^1$ ($Y^1$ ist eine einwertige, organische Gruppe, die 2 bis 100 Kohlenstoffatome und 1 bis 5 vernetzbare, cyclische Etherstrukturen besitzt, in denen Wasserstoffatome durch Fluoratome substituiert sein können) an eine fluorhaltige Alkylgruppe mit 1 bis 40 Kohlenstoffatomen oder eine fluorhaltige Alkylgruppe mit 2 bis 100 Kohlenstoffatomen sowie Etherbindung gebunden sind.

**5.** Zusammensetzung gemäß einem der Ansprüche 1 bis 4, worin mindestens eines der $Y^1$ in Rf in den Formeln (M), (M1), (M2) und (M3) an ein Ende von Rf gebunden ist.

**6.** Zusammensetzung gemäß einem der Ansprüche 1 bis 4, worin $Y^1$ in Rf in den Formeln (M), (M1), (M2) und (M3) eine einwertige, organische Gruppe ist, die 2 bis 100 Kohlenstoffatome und 1 bis 5 vernetzbare Etherstrukturen eines 3- bis 6-gliedrigen Ringes mit mindestens einer Etherbindung besitzt, in denen Wasserstoffatome der cyclischen Etherstruktur durch Fluoratome substituiert sein können.

**7.** Zusammensetzung gemäß einem der Ansprüche 1 bis 4, worin $Y^1$ in Rf in den Formeln (M), (M1), (M2) und (M3) eine organische Gruppe mit 2 bis 100 Kohlenstoffatome und 1 bis 5 Oxiranstrukturen ist, die vernetzbare, cyclische Etherstrukturen eines 3-gliedrigen Ringes sind und dargestellt werden durch:

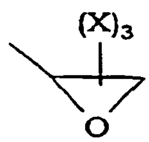 oder 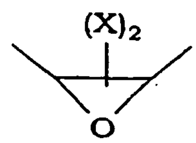

wobei X gleich oder verschieden sind und jedes ein Wasserstoffatom, ein Fluoratom, eine Alkylgruppe mit 1 bis 6 Kohlenstoffatomen oder eine fluorhaltige Alkylgruppe mit 1 bis 6 Kohlenstoffatomen oder
eine organische Gruppe mit 3 bis 100 Kohlenstoffatomen und 1 bis 5 Strukturen sein kann, die dargestellt werden durch:

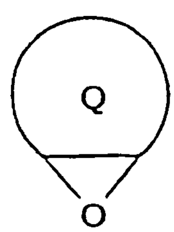

wobei Q eine einwertige oder zweiwertige, organische Gruppe einer monocyclischen, polycyclischen oder heterocyclischen Struktur mit 3 bis 100 Kohlenstoffatomen ist, in welcher Wasserstoffatom von Q mit X substituiert sein kann.

**8.** Zusammensetzung gemäß einem der Ansprüche 1 bis 4, worin $Y^1$ in Rf in den Formeln (M), (M1), (M2) und (M3) eine organische Gruppe ist, die 6 bis 100 Kohlenstoffatome und 1 bis 5 Strukturen besitzt, die dargestellt werden durch:

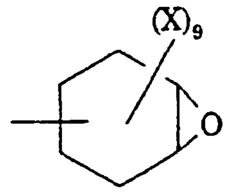

wobei X wie oben definiert oder
eine organische Gruppe ist, die 7 bis 100 Kohlenstoffatome und 1 bis 5 Strukturen besitzt, die dargestellt werden durch:

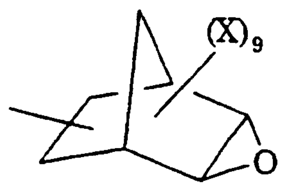

wobei X wie oben definiert ist.

9. Zusammensetzung gemäß einem der Ansprüche 1 bis 4, worin $Y^1$ in Rf in den Formeln (M), (M1), (M2) und (M3) eine organische Gruppe ist, die 3 bis 100 Kohlenstoffatome und 1 bis 5 Oxetanstrukturen besitzt, die dargestellt werden durch:

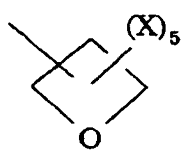

oder

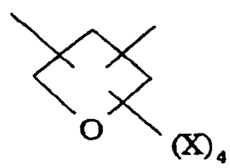

worin X gleich oder verschieden sind und jedes ein Wasserstoffatom, Fluoratom, eine Alkylgruppe mit 1 bis 6 Kohlenstoffatomen oder eine fluorhaltige Alkylgruppe mit 1 bis 6 Kohlenstoffatomen sein kann.

10. Zusammensetzung gemäß einem der Ansprüche 1 bis 9, wobei ein Fluorgehalt des härtbaren, fluorhaltigen Polymers (I) nicht weniger als 40 Gew.% ist.

11. Zusammensetzung gemäß einem der Ansprüche 1 bis 10, wobei der Fotosäuregenerator (II) mindestens eine aromatische Verbindung ausgewählt aus der Gruppe bestehend aus aromatischen Diazoniumsalzen, aromatischen Sulfoniumsalzen, aromatischen Jodoniumsalzen und Metallocenverbindungen ist.

12. Zusammensetzung gemäß einem der Ansprüche 1 bis 11, worin der Fotosäuregenerator (II) mindestens eine aromatische Verbindung ausgewählt aus der Gruppe bestehend aus aromatischen Diazoniumsalzen, aromatischen Sulfoniumsalzen, aromatischen Jodoniumsalzen und Metallocenverbindungen ist, in dem 1 bis 4 organische Gruppen R an den aromatischen Ring gebunden sind, wobei R gleich oder verschieden sind und jedes eine Hydroxygruppe, Thioalkylgruppe, Thiophenoxygruppe oder eine Alkylgruppe mit 1 bis 10 Kohlenstoffatomen, die eine Etherbindung besitzen kann, sein kann.

13. Zusammensetzung gemäß einem der Ansprüche 1 bis 12, wobei der Fotosäuregenerator (II) eine Verbindung mit Fluoratom ist.

14. Gehärteter Gegenstand, der durch Aushärten der Zusammensetzung gemäß einem der Ansprüche 1 bis 13 erhalten wird.

**15.** Gehärteter Gegenstand, der durch Aushärten bei Licht der Zusammensetzung gemäß einem der Ansprüche 1 bis 13 erhalten wird.

**16.** Optisches Material für optische Geräte, das das härtbare, fluorhaltige Polymer (I) gemäß einem der Ansprüche 1 bis 10 umfasst.

**17.** Optisches Material für optische Geräte, das die fotohärtbare, fluorhaltige Harzzusammensetzung gemäß einem der Ansprüche 1 bis 13 umfasst.

**18.** Optisches Element für optische Geräte, das aus einem gehärteten Gegenstand gewonnen wird, der durch Aushärten des optischen Materials für optische Geräte gemäß Anspruch 16 oder 17 hergestellt wird.

**19.** Material für Lichtwellenleiter, das aus dem optischen Material für optische Geräte gemäß Anspruch 16 oder 17 gewonnen wird.

**20.** Element für Lichtwellenleiter, das aus dem gehärteten Gegenstand gewonnen wird, der durch Aushärten des Materials für Lichtwellenleiter gemäß Anspruch 19 hergestellt wird.

**21.** Material für ein Dichtungselement für optische Geräte, das aus dem optischen Material für optische Geräte nach Anspruch 16 oder 17 gewonnen wird.

**22.** Optisches Gerät mit einem Dichtungselement, das aus dem gehärteten Gegenstand gewonnen wird, der durch Aushärten des Materials für ein Dichtungselement gemäß Anspruch 21 hergestellt wird.

**23.** Optisches Material für Anzeigegeräte, das das härtbare, fluorhaltige Polymer (I) gemäß einem der Ansprüche 1 bis 10 umfasst.

**24.** Optisches Material für Anzeigegeräte, das die fotohärtbare, fluorhaltige Harzzusammensetzung gemäß einem der Ansprüche 1 bis 13 umfasst.

**25.** Optisches Element für Anzeigegeräte, das aus dem gehärteten Gegenstand gewonnen wird, der durch Aushärten des optischen Materials für Anzeigegeräte gemäß Anspruch 23 oder 24 hergestellt wird.

**26.** Material für eine Antireflektionsschicht, die das optische Material für Anzeigegeräte gemäß Anspruch 23 oder 24 umfasst.

**27.** Antireflektionsschicht, die durch Aushärten des Materials für eine Antireflektionsschicht gemäß Anspruch 26 gewonnen wird.

**28.** Fluorhaltiges Polymer mit vernetzbarer Gruppe, die ein durchschnittliches Molekulargewicht von 500 bis 1.000.000 besitzt und durch die Formel (2) dargestellt wird:

- (M4) - (B) - (2)

wobei die Struktureinheit M4 eine Struktureinheit ist, die von einem fluorhaltigen, ethylenischen Monomer abgeleitet ist und durch die Formel (M4) dargestellt wird:

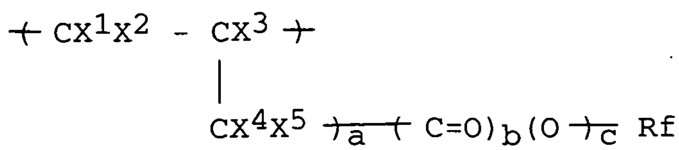

(M4)

wobei $X^1$ und $X^2$ gleich oder verschieden sind und jedes H oder F sein kann; $X^3$ H, F, $CH_3$ oder $CF_3$ ist; $X^4$ und $X^5$ gleich oder verschieden sind und jedes H, F oder $CF_3$ sein kann; Rf eine organische Gruppe ist, in der 1 bis 3 $Y^2$ ($Y^2$ ist eine organische Gruppe mit 2 bis 100 Kohlenstoffatome und 1 bis 5 vernetzbaren, cyclischen Etherstrukturen:

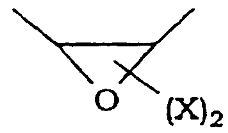

wobei X gleich oder verschieden sind und jedes Wasserstoffatom, Fluoratom, eine Alkylgruppe mit 1 bis 6 Kohlenstoffatomen oder eine fluorhaltige Alkylgruppe mit 1 bis 6 Kohlenstoffatomen oder
eine organische Gruppe mit 3 bis 100 Kohlenstoffatomen und 1 bis 5 Strukturen sein kann, die durch die Formel:

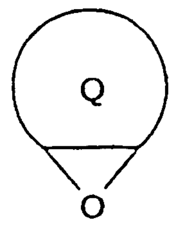

dargestellt werden, wobei Q eine einwertige oder zweiwertige, organische Gruppe einer monocyclischen, polycyclischen oder heterocyclischen Struktur mit 3 bis 100 Kohlenstoffatomen ist, in der Wasserstoffatom von Q mit X substituiert sein kann), gebunden an eine fluorhaltige Alkylgruppe mit 1 bis 40 Kohlenstoffatomen oder eine fluorhaltige Alkylgruppe mit 2 bis 100 Kohlenstoffatomen sowie Etherbindung; a 0 oder eine ganze Zahl von 1 bis 3 ist; b und c gleich oder verschieden sind und jedes 0 oder 1 sein kann,
die Struktureinheit B eine Struktureinheit ist, die von einem Monomer abgeleitet ist, welches mit dem fluorhaltigen, ethylenischen Monomer für die Struktureinheit der Formel (M4) copolymerisierbar ist,
wobei die Struktureinheit M4 und die Struktureinheit B in Mengen von 0,1 bis 100 Mol% bzw. 0 bis 99,9 Mol% enthalten sind.

**29.** Fluorhaltiges Polymer mit vernetzbarer Gruppe, das ein durchschnittliches Molekulargewicht von 500 bis 1.000.000 besitzt und durch die Formel (2-1) dargestellt wird:

- (M4) - (B) - (1-2)

wobei die Struktureinheit M4 eine Struktureinheit ist, die von einem fluorhaltigen, ethylenischen Monomer abgeleitet ist und durch die Formel (M4-1) dargestellt wird:

$$-(CX^1X^2-CX^3)-$$
$$\qquad\qquad | \qquad\qquad\qquad\qquad (M4\text{-}1)$$
$$\qquad CX^4X^5)_a-(C{=}O)_b(O-)_c\ Rf$$

wobei $X^1$ und $X^2$ gleich oder verschieden sind und jedes H oder F sein kann; $X^3$ H, F, $CH_3$ oder $CF_3$ ist; $X^4$ und $X^5$ gleich oder verschieden sind und jedes H, F oder $CF_3$ sein kann; Rf eine organische Gruppe ist, in der 1 bis 3 $Y^{2a}$ ($Y^{2a}$ ist eine einwertige, organische Gruppe mit 3 bis 100 Kohlenstoffatome und 1 bis 5 vernetzbaren, cyclischen Etherstrukturen:

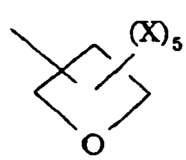 oder 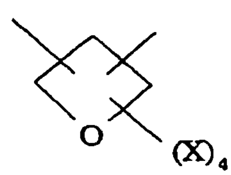

wobei X gleich oder verschieden sind und jedes Wasserstoffatom, Fluoratom, eine Alkylgruppe mit 1 bis 6 Kohlenstoffatomen oder eine fluorhaltige Alkylgruppe mit 1 bis 6 Kohlenstoffatomen sein kann) an eine fluorhaltige Alkylgruppe mit 1 bis 40 Kohlenstoffatomen oder eine fluorhaltige Alkylgruppe mit 2 bis 100 Kohlenstoffatomen sowie Etherbindung gebunden sind; a 0 oder eine ganze Zahl von 1 bis 3 ist; b und c gleich oder verschieden sind und jedes 0 oder 1 sein kann;
die Struktureinheit B eine Struktureinheit ist, die von einem Monomer abgeleitet ist, das mit dem fluorhaltigen, ethylenischen Monomer für die Struktureinheit der Formel (M4-1) copolymerisierbar ist,
wobei die Struktureinheit M4 und die Struktureinheit B in Mengen von 0,1 bis 100 Mol% bzw. 0 bis 99,9 Mol% enthalten sind.

**30.** Fluorhaltiges, ethylenisches Monomer, das durch die Formel (3) dargestellt wird:

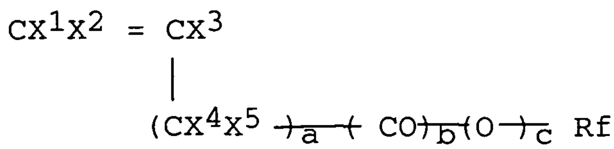

(3)

wobei $X^1$ und $X^2$ gleich oder verschieden sind und jedes H oder F sein kann; $X^3$ H, F, $CH_3$ oder $CF_3$ ist; $X^4$ und $X^5$ gleich oder verschieden sind und jedes H, F oder $CF_3$ sein kann; Rf eine organische Gruppe ist, in der 1 bis 3 $Y^2$ ($Y^2$ ist eine organische Gruppe mit 2 bis 100 Kohlenstoffatomen und 1 bis 5 vernetzbaren, cyclischen Etherstrukturen:

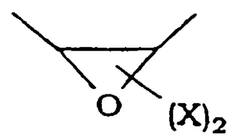

wobei X gleich oder verschieden sind und jedes Wasserstoffatom, Fluoratom, eine Alkylgruppe mit 1 bis 6 Kohlenstoffatomen oder eine fluorhaltige Alkylgruppe mit 1 bis 6 Kohlenstoffatomen oder
eine organische Gruppe mit 3 bis 100 Kohlenstoffatomen und 1 bis 5 Strukturen sein kann, die durch die Formel dargestellt werden:

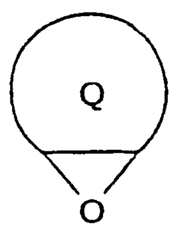

wobei Q eine einwertige oder zweiwertige, organische Gruppe einer monocyclischen, polycyclischen oder heterocyclischen Struktur mit 3 bis 100 Kohlenstoffatomen ist, in der Wasserstoffatom von Q mit X substituiert sein kann), an eine fluorhaltige Alkylgruppe mit 1 bis 40 Kohlenstoffatomen oder eine fluorhaltige Alkylgruppe mit 2 bis 100 Kohlenstoffatomen sowie Etherbindung gebunden sind; a 0 oder eine ganze Zahl von 1 bis 3 ist; b und c gleich oder verschieden sind und jedes 0 oder 1 sein kann.

**31.** Fluorhaltiges, ethylenisches Monomer, dargestellt durch die Formel (3-1):

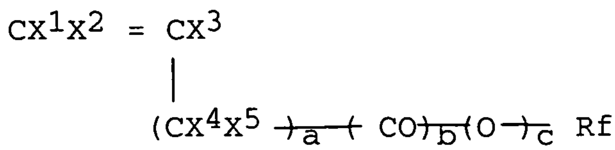

(3-1)

wobei $X^1$ und $X^2$ gleich oder verschieden sind und jedes H oder F sein kann; $X^3$ H, F, $CH_3$ oder $CF_3$ ist; $X^4$ und $X^5$ gleich oder verschieden sind und jedes H, F oder $CF_3$ sein kann; Rf eine organische Gruppe ist, in der 1 bis 3 $Y^{2a}$ ($Y^{2a}$ ist eine organische Gruppe mit 2 bis 100 Kohlenstoffatomen und 1 bis 5 vernetzbaren, cyclischen Etherstrukturen:

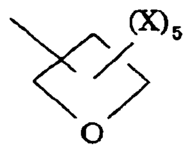

oder

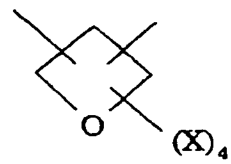

wobei X gleich oder verschieden sind und jedes Wasserstoffatom, Fluoratom, eine Alkylgruppe mit 1 bis 6 Kohlenstoffatomen oder eine fluorhaltige Alkylgruppe mit 1 bis 6 Kohlenstoffatomen sein kann) an eine fluorhaltige Alkylgruppe mit 1 bis 40 Kohlenstoffatomen oder eine fluorhaltige Alkylgruppe mit 2 bis 100 Kohlenstoffatomen sowie Etherbindung gebunden sind; a 0 oder eine ganze Zahl von 1 bis 3 ist; b und c gleich oder verschieden sind und jedes 0 oder 1 sein kann.

**Revendications**

**1.** Composition de résine photodurcissable contenant du fluor comprenant :

(a) un polymère durcissable contenant du fluor (I) ayant une masse moléculaire moyenne en nombre de 500 à 1 000 000 et représenté par la formule (1) :

$$-(M)-(A)- \qquad (1)$$

dans laquelle l'unité structurelle M est une unité structurelle dérivée d'un monomère éthylénique contenant du fluor et représenté par la formule (M) :

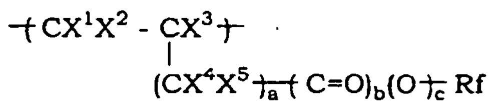

(M)

dans laquelle $X^1$ et $X^2$ sont les mêmes ou différents et chacun est H ou F ; $X^3$ est H, F, $CH_3$ ou $CF_3$ ; $X^4$ et $X^5$ sont les mêmes ou différents et chacun est H, F ou $CF_3$ ; Rf est un groupe organique dans lequel 1 à 3 $Y^1$ ($Y^1$ est un groupe organique monovalent qui a 2 à 100 atomes de carbone et 1 à 5 structures d'éther cycliques pouvant être réticulées dans lesquelles des atomes hydrogènes peuvent être substitués par des atomes de fluor) sont liés à un groupe alkyle contenant du fluor ayant 1 à 40 atomes de carbone ou un groupe alkyle contenant du fluor ayant 2 à 100 atomes de carbone et une liaison éther ; a est 0 ou un entier de 1 à 3 ; b et c sont les mêmes ou différents et chacun est 0 ou 1,
l'unité structurelle A est une unité structurelle dérivée d'un monomère copolymérisable avec le monomère éthylénique contenant du fluor pour l'unité structurelle représentée par ladite formule (M),
ladite unité structurelle M et ladite unité structurelle A étant respectivement contenues en quantités de 0,1 à 100 % en mole et de 0 à 99,9 % en mole, et
(b) un générateur photoacide (II).

**2.** Composition selon la revendication 1, dans laquelle le polymère durcissable contenant du fluor (I) est le polymère contenant du fluor de la formule (1), dans laquelle l'unité structurelle M est une unité structurelle M1 dérivée d'un monomère éthylénique contenant du fluor et représenté par la formule (M1) :

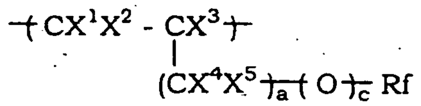

(M1)

dans laquelle $X^1$ et $X^2$ sont les mêmes ou différents et chacun est H ou F ; $X^3$ est H, F, $CH_3$ ou $CF_3$ ; $X^4$ et $X^5$ sont les mêmes ou différents et chacun est H, F ou $CF_3$ ; Rf est un groupe organique dans lequel 1 à 3 $Y^1$ ($Y^1$ est un groupe organique monovalent qui a 2 à 100 atomes de carbone et 1 à 5 structures d'éther cycliques réticulables dans lesquelles des atomes d'hydrogène peuvent être substitués par des atomes de fluor) sont liés à un groupe alkyle contenant du fluor ayant 1 à 40 atomes de carbone ou un groupe alkyle contenant du fluor ayant 2 à 100 atomes de carbone et une liaison éther ; a est 0 ou un entier de 1 à 3 ; c est 0 ou 1.

**3.** Composition selon la revendication 1, dans laquelle le polymère contenant du fluor (I) est le polymère contenant du fluor de la formule (1), dans laquelle l'unité structurelle M est une unité structurelle M2 dérivée d'un monomère éthylénique contenant du fluor et représenté par la formule (M2) :

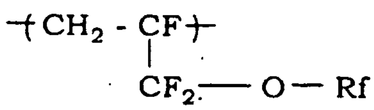

(M2)

dans laquelle Rf est un groupe organique dans lequel 1 à 3 $Y^1$ ($Y^1$ est un groupe organique monovalent qui a 2 à 100 atomes de carbone et 1 à 5 structures d'éther cycliques réticulables dans lesquelles des atomes d'hydrogène peuvent être substitués par des atomes de fluor) sont liés à un groupe alkyle contenant du fluor ayant 1 à 40 atomes de carbone ou un groupe alkyle contenant du fluor ayant 2 à 100 atomes de carbone et une liaison éther.

**4.** Composition selon la revendication 1, dans laquelle le polymère contenant du fluor (I) est le polymère contenant du fluor de la formule (1), dans laquelle l'unité structurelle M est une unité structurelle M3 dérivée d'un monomère éthylénique contenant du fluor et représenté par la formule (M3) :

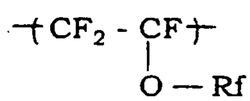

(M3)

dans laquelle Rf est un groupe organique dans lequel 1 à 3 $Y^1$ ($Y^1$ est un groupe organique monovalent qui a 2 à 100 atomes de carbone et 1 à 5 structures d'éther cycliques réticulables dans lesquelles des atomes d'hydrogène peuvent être substitués par des atomes de fluor) sont liés à un groupe alkyle contenant du fluor ayant 1 à 40 atomes de carbone ou un groupe alkyle contenant du fluor ayant 2 à 100 atomes de carbone et une liaison éther.

**5.** Composition selon l'une quelconque des revendications 1 à 4, dans laquelle au moins un de $Y^1$ dans Rf dans lesdites formules (M), (M1), (M2) et (M3) est lié à une extrémité de Rf.

**6.** Composition selon l'une quelconque des revendications 1 à 4, dans laquelle $Y^1$ dans Rf dans lesdites formules (M), (M1), (M2) et (M3) est un groupe organique monovalent qui a 2 à 100 atomes de carbone et 1 à 5 structures d'éther cycliques réticulables d'anneau à 3 à 6 éléments ayant au moins une liaison éther, dans laquelle un atome d'hydrogène de la structure d'éther cyclique peut être substitué par un atome de fluor.

**7.** Composition selon l'une quelconque des revendications 1 à 4, dans laquelle $Y^1$ dans Rf dans lesdites formules (M), (M1), (M2) et (M3) est un groupe organique ayant 2 à 100 atomes de carbone et 1 à 5 structures d'oxiranne qui sont des structures d'éther cycliques réticulables d'anneau à 3 éléments et sont représentées par :

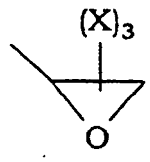

ou

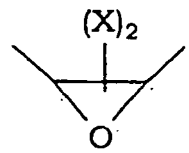

dans lesquelles X sont les mêmes ou différents et chacun est un atome d'hydrogène, un atome de fluor, un groupe alkyle ayant 1 à 6 atomes de carbone ou un groupe alkyle contenant du fluor ayant 1 à 6 atomes de carbone, ou un groupe organique ayant 3 à 100 atomes de carbone et 1 à 5 structures représentées par :

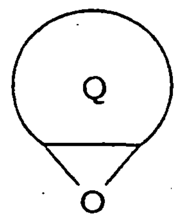

dans laquelle Q est un groupe organique monovalent ou divalent de structure monocyclique, polycyclique ou hétérocyclique ayant 3 à 100 atomes de carbone, dans laquelle l'atome d'hydrogène de Q peut être substitué par ledit X.

**8.** Composition selon l'une quelconque des revendications 1 à 4, dans laquelle $Y^1$ dans Rf dans lesdites formules (M), (M1), (M2) et (M3) est un groupe organique qui a 6 à 100 atomes de carbone et 1 à 5 structures représentées par :

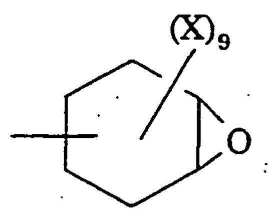

dans laquelle X est comme on l'a précédemment défini, ou
un groupe organique qui a 7 à 100 atomes de carbone et 1 à 5 structures représentées par :

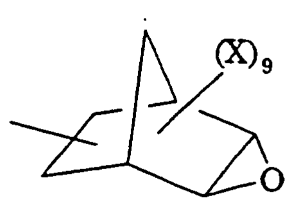

dans laquelle X est tel que défini ci-dessus.

**9.** Composition selon l'une quelconque des revendications 1 à 4, dans laquelle $Y^1$ dans Rf dans lesdites formules (M), (M1), (M2) et (M3) est un groupe organique qui a 3 à 100 atomes de carbone et 1 à 5 structures d'oxétane représentées par :

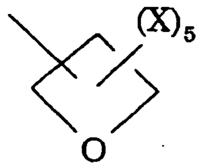

ou

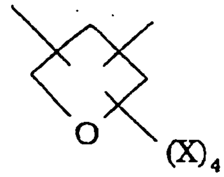

dans laquelle X sont les mêmes ou différents et chacun est un atome d'hydrogène, un atome de fluor, un groupe alkyle ayant 1 à 6 atomes de carbone ou un groupe alkyle contenant du fluor ayant 1 à 6 atomes de carbone.

**10.** Composition selon l'une quelconque des revendications 1 à 9, dans laquelle une teneur en fluor du polymère durcissable contenant du fluor (I) n'est pas inférieure à 40 % en poids.

**11.** Composition selon l'une quelconque des revendications 1 à 10, dans laquelle le générateur photoacide (II) est au moins un composé aromatique sélectionné à partir du groupe constitué par des sels aromatiques de diazonium, des sels aromatiques de sulfonium, des sels aromatiques d'iodonium et des composés de métallocène.

**12.** Composition selon l'une quelconque des revendications 1 à 11, dans laquelle le générateur photoacide (II) est au moins un composé aromatique sélectionné à partir du groupe constitué par des sels aromatiques de diazonium, des sels aromatiques de sulfonium, des sels aromatiques d'iodonium et des composés de métallocène, dans lesquels 1 à 4 groupes organiques R sont liés au noyau aromatique, dans lesquels R sont les mêmes ou différents et chacun est un groupe hydroxyle, un groupe thioalkyle, un groupe thiophénoxy ou un groupe alkyle ayant 1 à 10 atomes de carbone qui peuvent avoir une liaison éther.

**13.** Composition selon l'une quelconque des revendications 1 à 12, dans laquelle le générateur photoacide (II) est un composé ayant un atome de fluor.

**14.** Article durci obtenu en faisant durcir la composition selon l'une quelconque des revendications 1 à 13.

**15.** Article durci obtenu par photodurcissement de la composition selon l'une quelconque des revendications 1 à 13.

**16.** Matière optique pour des dispositifs optiques qui comprend le polymère durcissable contenant du fluor (I) selon l'une quelconque des revendications 1 à 10.

**17.** Matière optique pour des dispositifs optiques qui comprend la composition photodurcissable de résine contenant du fluor selon l'une quelconque des revendications 1 à 13.

**18.** Élément optique pour des dispositifs optiques qui est obtenu à partir d'un article durci fabriqué en faisant durcir la matière optique pour des dispositifs optiques selon la revendication 16 ou 17.

**19.** Matière pour guide d'ondes optique qui est obtenue à partir de la matière optique pour des dispositifs optiques selon la revendication 16 ou 17.

**20.** Élément pour guide d'ondes optique qui est obtenu à partir d'un article durci fabriqué en faisant durcir la matière pour guide d'ondes optique selon la revendication 19.

**21.** Matière pour un élément d'étanchéité pour des dispositifs optiques qui est obtenue à partir de la matière optique pour des dispositifs optiques selon la revendication 16 ou 17.

**22.** Dispositif optique ayant un élément d'étanchéité qui est obtenu d'un article durci fabriqué en faisant durcir la matière pour un élément d'étanchéité selon la revendication 21.

**23.** Matière optique pour des dispositifs d'affichage qui comprend le polymère durcissable contenant du fluor (I) selon l'une quelconque des revendications 1 à 10.

**24.** Matière optique pour des dispositifs d'affichage qui comprend la composition de résine photodurcissable contenant

du fluor selon l'une quelconque des revendications 1 à 13.

**25.** Élément optique pour des dispositifs d'affichage qui est obtenu à partir d'un article durci fabriqué en faisant durcir la matière optique pour des dispositifs d'affichage selon la revendication 23 ou 24.

**26.** Matière pour un film antiréfléchissant qui comprend la matière optique pour des dispositifs d'affichage selon la revendication 23 ou 24.

**27.** Film antiréfléchissant obtenu en faisant durcir la matière pour un film antiréfléchissant selon la revendication 26.

**28.** Polymère contenant du fluor ayant un groupe pouvant être réticulé qui a une masse moléculaire moyenne en nombre de 500 à 1 000 000 et est représenté par la formule (2) :

-(M4)-(B)- (2)

dans laquelle l'unité structurelle M4 est une unité structurelle obtenue à partir d'un monomère éthylénique contenant du fluor et représenté par la formule (M4) :

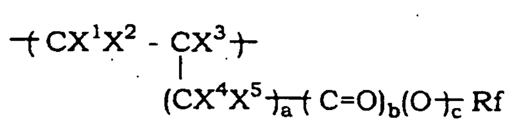
(M4)

dans laquelle $X^1$ et $X^2$ sont les mêmes ou différents et chacun est H ou F ; $X^3$ est H, F, $CH_3$ ou $CF_3$ ; $X^4$ et $X^5$ sont les mêmes ou différents et chacun est H, F ou $CF_3$ ; Rf est un groupe organique dans lequel 1 à 3 $Y^2$ ($Y^2$ est un groupe organique ayant 2 à 100 atomes de carbone et 1 à 5 structures d'éther cycliques réticulables de :

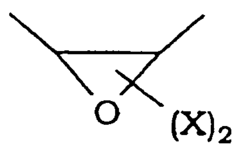

dans laquelle X sont les mêmes ou différents et chacun est un atome d'hydrogène, un atome de fluor, un groupe alkyle ayant 1 à 6 atomes de carbone ou un groupe alkyle contenant du fluor ayant 1 à 6 atomes de carbone, ou un groupe organique ayant 3 à 100 atomes de carbone et 1 à 5 structures représentées par la formule :

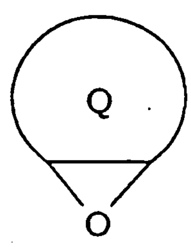

dans laquelle Q est un groupe organique monovalent ou divalent de structure monocyclique, polycyclique ou hétérocyclique ayant 3 à 100 atomes de carbone dans lesquels l'atome hydrogène de Q peut être substitué par ledit X) sont liés à un groupe alkyle contenant du fluor ayant 1 à 40 atomes de carbone ou un groupe alkyle contenant du fluor ayant 2 à 100 atomes de carbone et une liaison éther ; a est 0 ou un entier de 1 à 3 ; b et c sont les mêmes ou différents et chacun est 0 ou 1,
l'unité structurelle B est une unité structurelle obtenue à partir d'un monomère copolymérisable avec le monomère éthylénique contenant du fluor pour l'unité structurelle de ladite formule (M4),
ladite unité structurelle M4 et ladite unité structurelle B étant respectivement contenues en quantités de 0,1 à 100 % en mole et de 0 à 99,9 % en mole.

**29.** Polymère contenant du fluor ayant un groupe réticulable qui a une masse moléculaire moyenne en nombre de 500 à 1 000 000 et est représenté par la formule (2-1) :

- (M4) -(B) - (2-1)

dans laquelle l'unité structurelle M4 est une unité structurelle obtenue à partir d'un monomère éthylénique contenant du fluor et représenté par la formule (M4-1) :

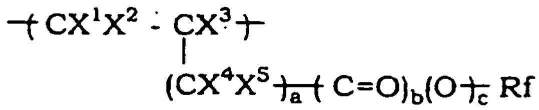

(M4-1)

dans laquelle $X^1$ et $X^2$ sont les mêmes ou différents et chacun est H ou F ; $X^3$ est H, F, $CH_3$ ou $CF_3$ ; $X^4$ et $X^5$ sont les mêmes ou différents et chacun est H, F ou $CF_3$ ; Rf est un groupe organique dans lequel 1 à 3 $Y^{2a}$ ($Y^{2a}$ est un groupe organique ayant 3 à 100 atomes de carbone et 1 à 5 structures d'éther cycliques réticulables de :

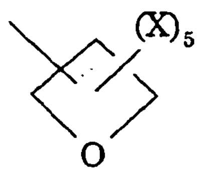

ou

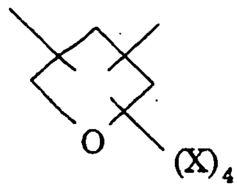

dans lesquelles X sont les mêmes ou différents et chacun est un atome d'hydrogène, un atome de fluor, un groupe alkyle ayant 1 à 6 atomes de carbone ou un groupe alkyle contenant du fluor ayant 1 à 6 atomes de carbone) sont liés à un groupe alkyle contenant du fluor ayant 1 à 40 atomes de carbone ou un groupe alkyle contenant du fluor ayant 2 à 100 atomes de carbone et une liaison éther ; a est 0 ou un entier de 1 à 3 ; b et c sont les mêmes ou différents et chacun est 0 ou 1,
l'unité structurelle B est une unité structurelle obtenue à partir d'un monomère copolymérisable avec le monomère éthylénique contenant du fluor pour l'unité structurelle de ladite formule (M4-1),
ladite unité structurelle M4 et ladite unité structurelle B étant respectivement contenues en quantités de 0,1 à 100 % en mole et de 0 à 99,9 % en mole.

**30.** Monomère éthylénique contenant du fluor représenté par la formule (3) :

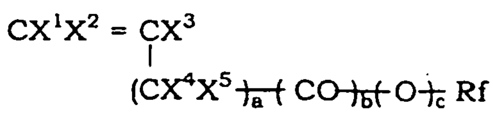

(3)

dans laquelle $X^1$ et $X^2$ sont les mêmes ou différents et chacun est H ou F ; $X^3$ est H, F, $CH_3$ ou $CF_3$ ; $X^4$ et $X^5$ sont les mêmes ou différents et chacun est H, F ou $CF_3$ ; Rf est un groupe organique dans lequel 1 à 3 $Y^2$ ($Y^2$ est un groupe organique ayant 2 à 100 atomes de carbone et 1 à 5 structures d'éther cycliques réticulables de :

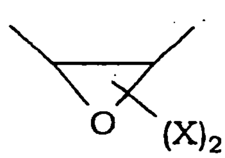

dans laquelle X sont les mêmes ou différents et chacun est un atome d'hydrogène, un atome de fluor, un groupe alkyle ayant 1 à 6 atomes de carbone ou un groupe alkyle contenant du fluor ayant 1 à 6 atomes de carbone, ou

un groupe organique ayant 3 à 100 atomes de carbone et 1 à 5 structures représentées par la formule :

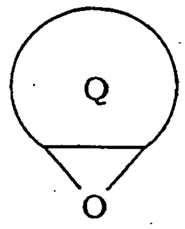

dans laquelle Q est un groupe organique monovalent ou divalent de structure monocyclique, polycyclique ou hétérocyclique ayant 3 à 100 atomes de carbone dans lequel l'atome d'hydrogène de Q peut être substitué par ledit X) sont liés à un groupe alkyle contenant du fluor ayant 1 à 40 atomes de carbone ou un groupe alkyle contenant du fluor ayant 2 à 100 atomes de carbone et une liaison éther ; a est 0 ou un entier de 1 à 3 ; b et c sont les mêmes ou différents et chacun est 0 ou 1.

**31.** Monomère éthylénique contenant du fluor représenté par la formule (3-1) :

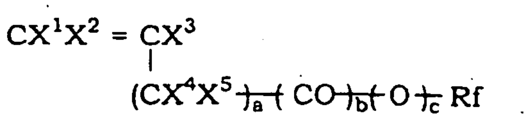

(3-1)

dans laquelle $X^1$ et $X^2$ sont les mêmes ou différents et chacun est H ou F ; $X^3$ est H, F, $CH_3$ ou $CF_3$ ; $X^4$ et $X^5$ sont les mêmes ou différents et chacun est H, F ou $CF_3$ ; Rf est un groupe organique dans lequel 1 à 3 $Y^{2a}$ ($Y^{2a}$ est un groupe organique ayant 2 à 100 atomes de carbone et 1 à 5 structures d'éther cycliques réticulables de :

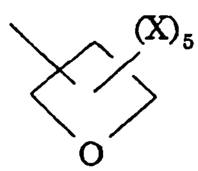

ou

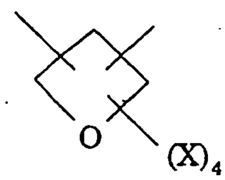

dans lesquelles X sont les mêmes ou différents et chacun est un atome d'hydrogène, un atome de fluor, un groupe alkyle ayant 1 à 6 atomes de carbone ou un groupe alkyle contenant du fluor ayant 1 à 6 atomes de carbone) sont liés à un groupe alkyle contenant du fluor ayant 1 à 40 atomes de carbone ou un groupe alkyle contenant du fluor ayant 2 à 100 atomes de carbone et une liaison éther ; a est 0 ou un entier de 1 à 3 ; b et c sont les mêmes ou différents et chacun est 0 ou 1.

FIG. 1

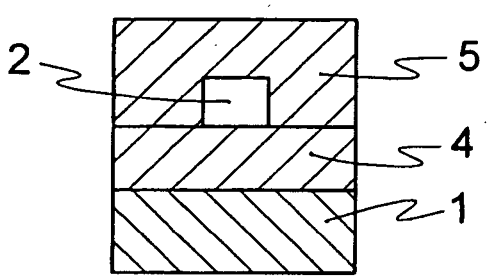

FIG. 2 (a)

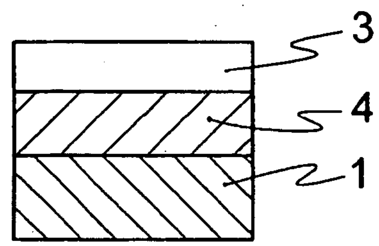


FIG. 2 (b)

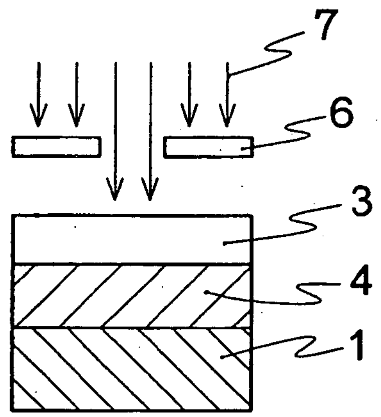


FIG. 2 (c)

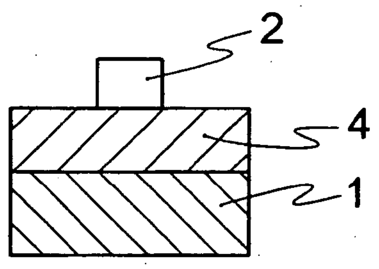


FIG. 2 (d)

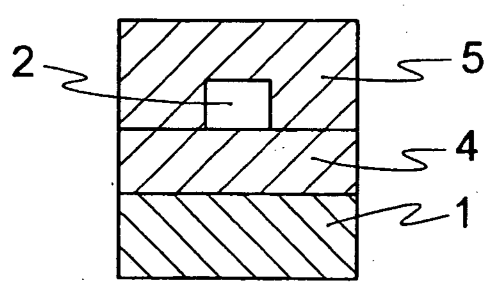

FIG. 3

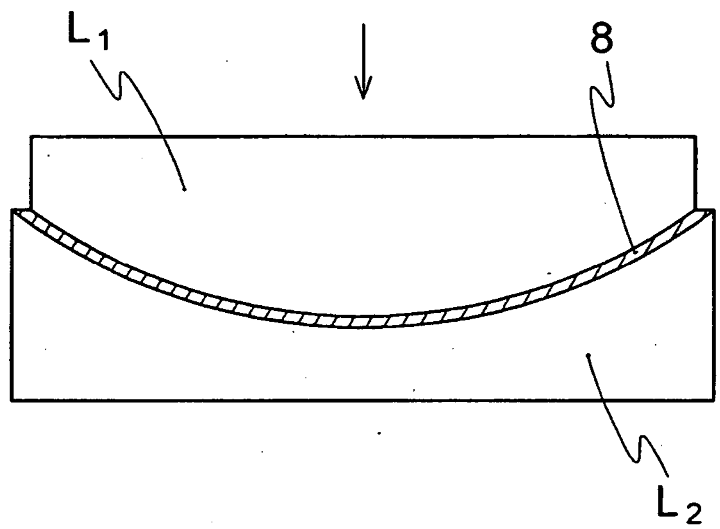


FIG. 4

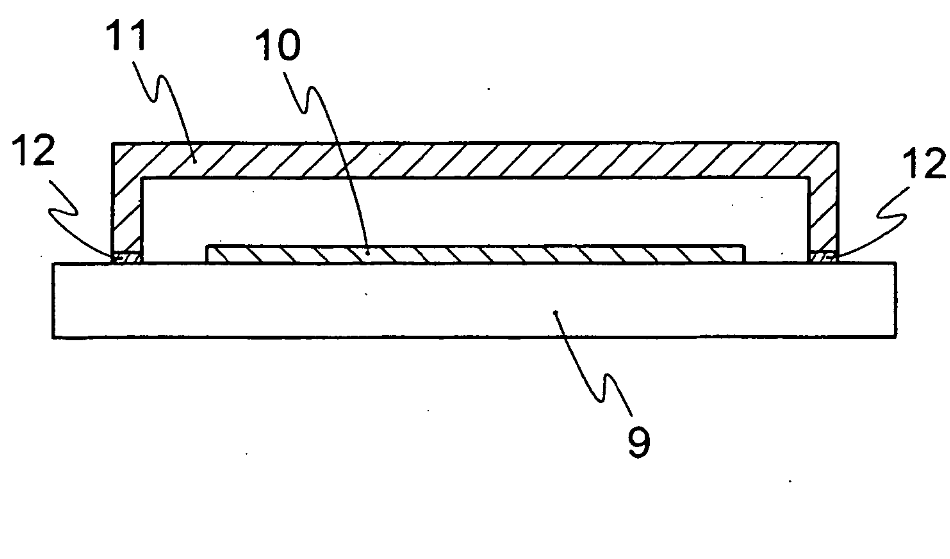

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 6016720 A
- JP 4019020 A
- JP 2000081519 A
- JP 7126552 A
- JP 7188582 A
- JP 8048935 A
- WO 0218457 A
- JP 8027233 A
- JP 7021987 A
- JP 7168005 A
- JP 8142280 A

### Non-patent literature cited in the description

- **Kurokawa et al.** *Applied Optics,* 1980, 3124
- **Kurokawa et al.** *Applied Optics,* 1977, 1033